# EUROPEAN PATENT APPLICATION

(11) **EP 4 517 179 A1**
(43) Date of publication of application: **05.03.2025**
(21) Application number: 24196462.6
(22) Date of filing: 26.08.2024
(51) Int. Cl.: F24C 7/08, A47L 15/42, E05D 11/00, F24C 15/02, F25D 23/02, H02G 11/00, H05B 6/64

(54) **DOOR FOR HOME APPLIANCE**

(30) Priority: 29.08.2023 KR 20230113785
(71) Applicant: LG Electronics Inc., Yeongdeungpo-gu Seoul 07336 (KR)
(72) Inventor: KIM, DongWoo, 08592 Seoul (KR); CHOI, Jinseok, 08592 Seoul (KR)
(74) Representative: Vossius & Partner Patentanwälte Rechtsanwälte mbB

(57) **Abstract**

Door for a home appliance and a home appliance including the same are disposed. The door includes a door body disposed in front of a storage space of a home appliance, and accommodating an electronic compartment. A connector module is disposed in the door body. The connector module includes a door connector elastically connected to the electronic compartment through a wire. A connector storage part is provided in the door body. The connector storage part includes a connector inlet open outward of the door body. Herein, the door connector is moved between a storage position disposed in the connector storage part and an operation position disposed at the connector inlet.

## Description

The present application claims priority to Korean Patent Application No. 10-2023-0113785, filed August 29, 2023.

The present disclosure relates to doors for a home appliance.

Home appliances storing target objects therein and including doors, such as a cooking appliance, a refrigerator, a clothing treating apparatus, etc., may be widely used. The home appliances may include storage spaces to store target objects in cabinets creating the external appearance thereof, and doors to open and close the storage spaces.

Recently, various electronic compartments may be installed in the door of the home appliance. For example, a touch sensor device, a display device, etc. may be installed in the door. The electronic compartments may be electrically connected to the main controller provided in the main body with wire.

To facilitate the connection of the wire, the wire may be connected with a connector. For example, a door connector protruding from the door and a main body connector protruding from the main body of the home appliance may be assembled with each other. As described above, the door connector and the main body connector (hereinbelow, which will be referred to as "connector assembly") which are assembled to each other are disposed not to be exposed outward. For example, the connector assembly is stored in a frame of the main body close to the door, and then a storage entrance may be covered with a separate cover.

Herein, assembling of the connector assembly may be performed after the door is assembled to the main body. After the door is assembled to the main body, the door connector is assembled to the main body connector. However, a gap between the door and the main body is narrow, so there is difficulty in the assembly operation of the connectors.

Furthermore, to reduce exposure of the wire and the connector assembly, the connector assembly and the wire may be disposed at a lower portion of the main body. In this case, the assembly operation of the connector assembly is performed at lower portions of the main body and the door. Accordingly, a fabricator must assemble the connector assembly without accurately checking the connector assembly with the naked eye, which requires skill in the assembly operation of the connector assembly and reduces the workability thereof, which are problems.

Specifically, a connector has directionality, and the fabricator must perform the assembly operation in the narrow space between the main body and the door while checking a direction of the connector assembly, which further reduces workability.

Meanwhile, in the home appliance, products such as the cooking appliance making a storage space into high temperature environment have a high temperature of main bodies thereof. As described above, the high temperature of the main body influences the connector assembly to reduce durability of the connector assembly, resulting damage to the connector assembly.

In addition, due to the narrow inner space of the frame of the main body adjacent to the door, maintenance of the connector assembly is difficult, which is a problem. Specifically, to insert the connector assembly into the frame, or remove the connector assembly inside the frame outward, the fabricator must access the connector assembly through the narrow inner space of the frame, which reduces workability. Furthermore, when the fabricator inserts the connector assembly to the depths inside the frame, it may be difficult to remove the connector assembly.

Meanwhile, the conventional connector assembly is not moved along a specific path and is installed to be freely moved by being pulled by the connected wire. Accordingly, the fabricator must precisely grip and fix the two connectors with two hands, and then assemble the connectors. However, as described above, since the two connectors are assembled in a narrow space, it is difficult to grip and assemble the connectors, which is a disadvantage.

In addition, a wire installed in the main body of the home appliance and a wire installed in the door may be fixed by separate fasteners at constant intervals for assembly stability. As described above, the connectors provided at terminal ends of the wires fixed by the fasteners are limited in movable distances and directions. Herein, when the lengths of the wires are sufficiently long, an operation distance in which the two connectors may be coupled becomes long, which improves workability. However, sections, where the wires are exposed outward, extend, which deteriorates the aesthetic feeling and the durability such that a sheath is damaged due to friction with the outside part. On the other hand, when the wires are shortened, the sections, where the wires are exposed outward, are shortened, which improves the aesthetic feeling and reduces friction with the outside part. However, there is a problem in that the workability of assembling the two connectors is deteriorated.

Accordingly, the present disclosure has been made keeping in mind the above problems occurring in the related art, and the present disclosure is intended to assemble a wire and a connector connected to an electronic compartment disposed in a door with a relative connector (main body connector) and then store the assembly in the door. Another objective of the present disclosure is to move a connector stored in a door between a storage position and an operation position along a constant path. Yet another objective of the present disclosure is to expose a connector moved to an operation position outward. Still another objective of the present disclosure is to align a connector in a constant direction when the connector is moved to an operation position. Still another objective of the present disclosure is to adjust the storage depth of a connector in a door to respond to a variety of extra lengths of a wire.

The invention is specified by the independent claim. Preferred embodiments are defined in the dependent claims. According to the features of the present disclosure to achieve the above-described objectives, each of doors for a home appliance of the present disclosure may include a door body disposed in front of a storage space of the home appliance and accommodating an electronic compartment. A connector module may be disposed in the door body. The connector module may include a door connector electrically connected to the electronic compartment through a door wire. The door body may include a connector storage part therein. The connector storage part may include a connector inlet open outward of the door body. The door connector may be moved between a storage position disposed in the connector storage part and an operation position disposed at the connector inlet. As described above, since the connectors are disposed in the door, the connects do not need to be stored in a frame of a main body of the home appliance or in a narrow space provided in a lower portion of the main body, and storage performance of the connectors may be improved.

The door connector may be linearly moved along the connector storage part between the storage position and the operation position. As described above, when the door connector is moved, the storage position of the door connector may change.

In addition, when the door connector is moved between the storage position and the operation position, a relative distance of the door connector may change to the electronic compartment. Therefore, compared to when the door connector is securely installed at a specific position, a space in the door may be freely used.

Furthermore, the connector inlet may be disposed at a lower portion of the door. Therefore, the connector accessibility of the fabricator can be improved.

Then, the connector inlet may be formed at an air inlet into which air is introduced into the door. Accordingly, without redesigning of the existing door body or with minimum design change, the connector storage part may be provided.

Furthermore, the connector storage part may extend in the height direction of the door body, and the storage position may be provided in an upper portion of the connector storage part. Accordingly, the door connector may be stored in the deepest position in the door.

In addition, the width of the connector inlet is wider than the thickness of the door connector, so an operation space, i.e., an empty space, may be formed between an edge of the connector inlet and a surface of the door connector. The fabricator may put a finger into the operation space to operator a door connector.

Furthermore, the door connector may include an assembly surface assembled to a relative connector disposed in a main body of the home appliance or a connection connector outside the home appliance, and when the door connector is moved to the operation position, the assembly surface of the door connector may be exposed outside of the connector inlet. Accordingly, an assembled portion of the door connector is exposed outward, and the connector accessibility may be improved.

Furthermore, the door connector may be moved between the storage position and the operation position with the assembly surface facing the connector inlet. Therefore, the fabricator does not need to re-align the direction of the door connector for assembly/separation of the connector.

Furthermore, the door wire connected to the door connector and a main wire connected to the relative connector may extend in different directions from the connector module. Therefore, the two wires may be pulled or released with the door connector.

In addition, the door connector may be fixed to the connector storage part at the storage position and the operation position. Then, the door connector may be stably fixed at the two positions.

Furthermore, a movement range of the door connector may be equal to or longer than the sum of a protruding length from the door connector disposed at the operation position outward of the connector inlet and a length of the relative connector. Accordingly, when the door connector is moved, the two connectors may not be exposed outward.

In addition, the connector storage part may include a storage fixation part, the storage fixation part interfering with the door connector and fixing the door connector to the storage position. The door connector may remain fixed to the storage position by the storage fixation part.

Furthermore, the storage fixation part may be continuously or discontinuously disposed in a movement direction of the door connector, and the storage fixation part fixes the door connector at a plurality of positions in the connector storage part. Accordingly, the storage fixation part may provide a free stop function.

In addition, the storage fixation part may include a first position fixation part provided at a mounting base of the connector module, and a second position fixation part provided at the door connector and engaged with the first position fixation part.

Furthermore, the first position fixation part may be an uneven structure continuously disposed in the movement direction of the door connector, and the second position fixation part may be a tension fixation arm fixed by being caught by the first position fixation part. Therefore, the door connector may be fixed to a plurality of positions by using an elastic force.

Furthermore, the connector module may include a mounting base fixed to the connector storage part, a movement supporter moved along the mounting base, and the door connector disposed at the movement supporter and moved with the movement supporter along the mounting base.

Furthermore, the mounting base may include a mounting station in a movement direction of the movement supporter, and the movement supporter may be moved along the mounting station. The mounting station may guide a linear movement of the movement supporter.

In addition, a plurality of surfaces of the movement supporter may be brought into close contact with a plurality of different surfaces of the mounting base respectively. Accordingly, the movement supporter may be stably moved without a spacing.

Furthermore, the mounting base may include a mounting station in which the movement supporter is moved, and a guide fence disposed at either side of the mounting station. The guide fence may surround the movement supporter to prevent transverse movement.

Furthermore, one surface of the movement supporter may be seated on the mounting station, and the guide fence may cover one of both surfaces of the movement supporter.

Furthermore, the mounting station may include a mounting stopper fixing the movement supporter and the door connector to the storage position, and the movement supporter may include a stopping holder fixed by being caught by the mounting stopper. The mounting stopper may limit the movement distance of the door connector.

In addition, the mounting base may include a restraint maintaining part catching and fixing the movement supporter disposed at the operation position. The restraint maintaining part may maintain the movement supporter fixed at the operation position.

Furthermore, the movement supporter may include a connector holder covering the door connector, and the connector holder may align the door connector so that the door connector may be directed in a specific direction. The connector holder may enable the movement supporter to transfer the door connector.

In addition, the mounting base and the movement supporter may include a supporter guide groove and a guide block corresponding to each other, and while the guide block is inserted into the supporter guide groove, the movement supporter may be moved along the mounting base.

Furthermore, either surface of the mounting base may include a first position fixation part at a position facing either surface of the movement supporter, the movement supporter may include a second position fixation part interfering with the first position fixation part, and the first position fixation part or the second position fixation part may be caught by the second position fixation part or the first position fixation part by elastic deformation.

In addition, the connector module may include an elastic member connecting the mounting base and the movement supporter to each other, and the elastic member may supply an elastic force to the movement supporter in a direction toward the storage position.

Furthermore, the mounting base may be disposed at a lower portion of the door frame.

Furthermore, a central portion of the door body may include a door panel disposed therein, and the door panel may include a window through which the storage space is visible, an indoor space defined by the door body and the door panel has an installation region around an outer portion of the window, and the connector storage part is disposed in the installation region. Accordingly, exposure of the connector assembly stored in the connector storage part may be reduced.

Furthermore, the door panel may include a plurality of panels, and the connector module may be disposed on a surface of one of the plurality of panels.

In addition, the connector module may be spaced apart from one of a plurality of panels, and an operation space may be provided between the connector module and the panel. The operation space may provide a path through which the fabricator accesses the door connector.

Furthermore, a mounting cover may be assembled to the connector inlet to block the connector inlet.

Furthermore, the mounting cover may include a cover body blocking the connector inlet and having a cover tension part open on a central portion thereof and a cover gripping part protruding from an edge of the cover tension part. Herein, a cover fixation finger may protrude on the cover body and be caught by an edge of the connector inlet.

As described above, the doors of a home appliance and the home appliance including the same according to the present disclosure have the following effects.

In the present disclosure, the door connector connected to the electronic compartment in the door, and the relative connector (main body connector or external connector) assembled with the door connector may be stored in the door. Accordingly, since the connectors do not need to be stored in a narrow space provided at a side surface or a lower portion of the main body of the home appliance, the storage performance of the connectors can be improved.

In the present disclosure, the connectors are stored in the door, not the main body of the home appliance. Accordingly, the connectors can be less affected by harsh environments of the main body in which the temperature and the humidity are excessively high or low. Accordingly, the durability of the connectors can be improved, and the operation reliability of the connectors can be improved.

Furthermore, since the connectors can be assembled with or separated from each other at a lower portion of the door disposed at the part of the home appliance, the accessibility to the connectors can be improved. Accordingly, the assembly/separation workability of the connector can be improved.

In addition, in the present disclosure, the door connector may be moved in a constant path along the connector storage part disposed in the door. The door connector and the relative connector assembled to each other are disposed on a preset regular path, so the fabricator can easily predict the storage position of the connectors. Accordingly, the maintainability of the connectors can also be improved.

Furthermore, since the door connector and the relative connector assembled to each other are stored/discharged along the constant regular path, it is possible to prevent the connectors from deviating from the preset movement path and covering the window disposed at the central portion of the door. Accordingly, the aesthetic feeling of the door and the home appliance can also be improved.

Specifically, in the present disclosure, the door connector and the relative connector may be disposed in the edge portion (installation region) provided around the window of the door. Therefore, the door connector and the relative connector can be covered by the edge portion when being located in the storage position, so it is possible to prevent outward exposure of the door connector and the relative.

In addition, when the door connector is moved along the connector storage part to the operation position, the door connector may be exposed outside the door. The fabricator can assemble or separate the outward exposed door connector to/from the relative connector, so assembly/separation of the connectors can be easily performed.

Specifically, in the present disclosure, since the assembly surface is moved toward the connector inlet of the connector storage part, the door connector is exposed outside the assembly surface when being moved to the operation position. Therefore, the fabricator does not need to check the directionality of the door connector, so high skill in the assembly operation of the connectors is not required and the workability can be improved.

In addition, in the present disclosure, the door connector and the relative connector coupled thereto may be fixed to various positions by the storage fixation part provided along the connector storage part. Accordingly, the mounting depth of the door connector and the relative connector can be varied, and a variety of extra lengths of the wires connected to the connectors can be accommodated. Therefore, the assembly compatibility of the connectors can be improved.

Furthermore, since the mounting depth of the door connector and the relative connector can be varied, the outward protruding length of the wires can be minimized by adjusting the mounting depth. Therefore, the aesthetic feeling of the home appliance can also be improved.

In addition, in the present disclosure, the connector storage part may be disposed around the inlet provided at the lower portion of the door. The inlet is provided in the existing door, so the existing door can be applied without design change. Therefore, according to the present disclosure, the door compatibility is high and manufacturing costs can be reduced.

Furthermore, in the present disclosure, the door connector is mounted to the movement supporter first and then is moved with the movement supporter along the mounting base. The structure to move the door connector should be provided in the movement supporter and the mounting base, so the existing door connector can be used. Therefore, the present disclosure has the effect of high compatibility of the connector

In addition, in the present disclosure, the connector module including the door connector, the movement supporter, and the mounting base may be disposed between the plurality of panels constituting the door. Herein, the connector module is fixed to one of the plurality of panels, and the connector module is separated from the other panel to have the operation space therebetween. The operation space is a clearance through which the fabricator can access the connectors, so the assembly/separation workability of the connector can be improved.

Furthermore, in the present disclosure, the mounting base includes the mounting stopper, so the mounting stopper may limit the storage depth of the door connector. Accordingly, it is possible to prevent the door connector and the relative connector from being stored while being moved to a position too deep in the door.

### BRIEF DESCRIPTION OF THE DRAWINGS

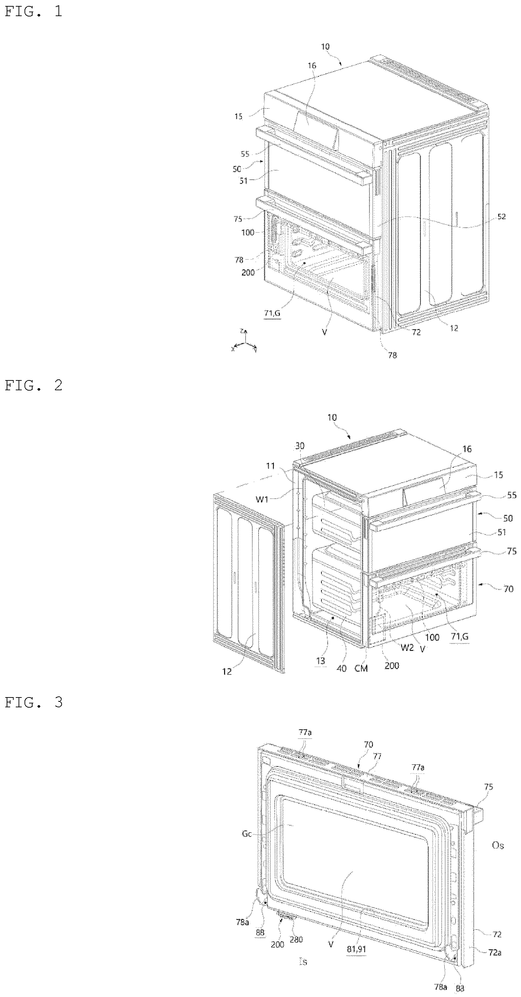

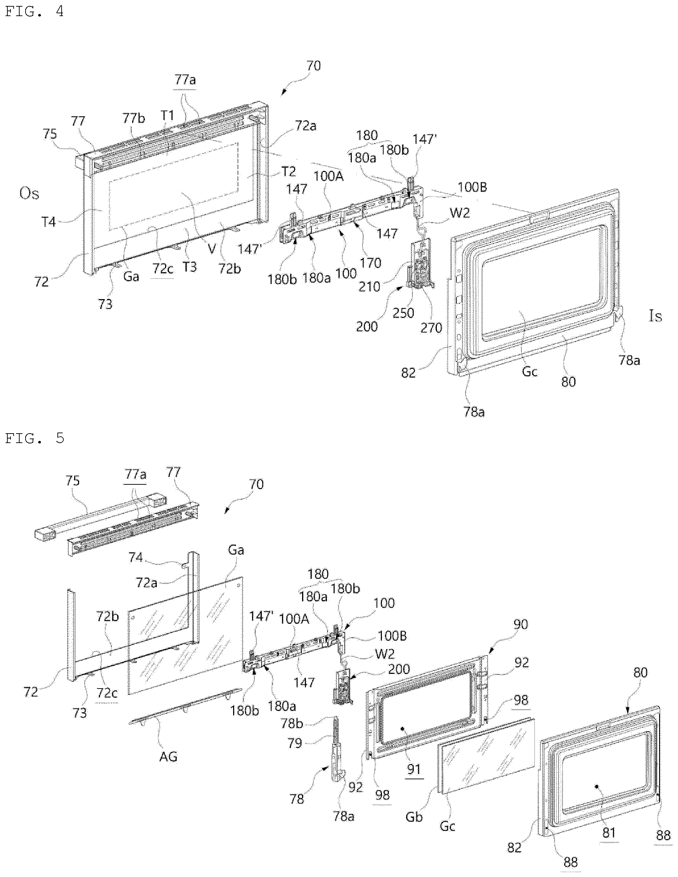

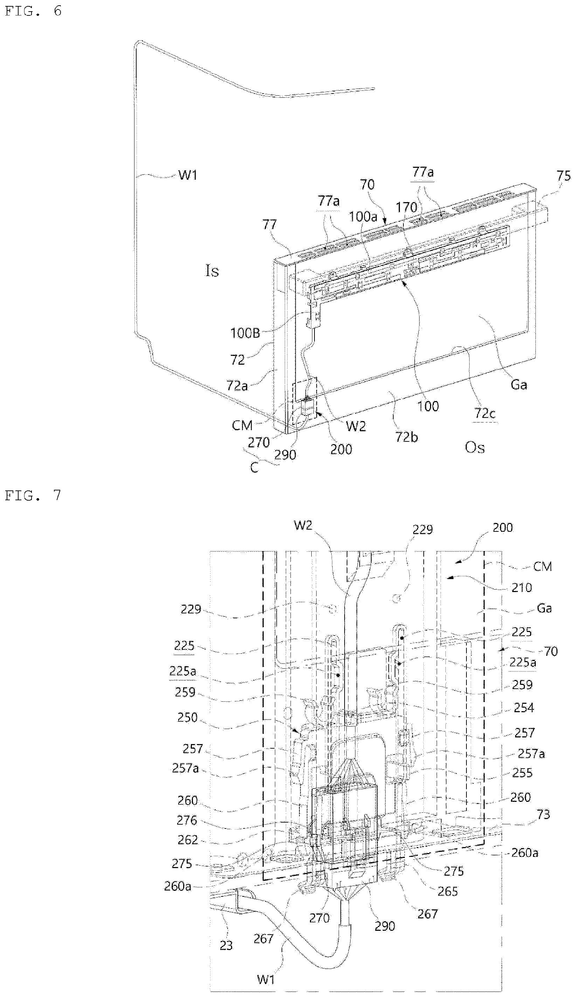

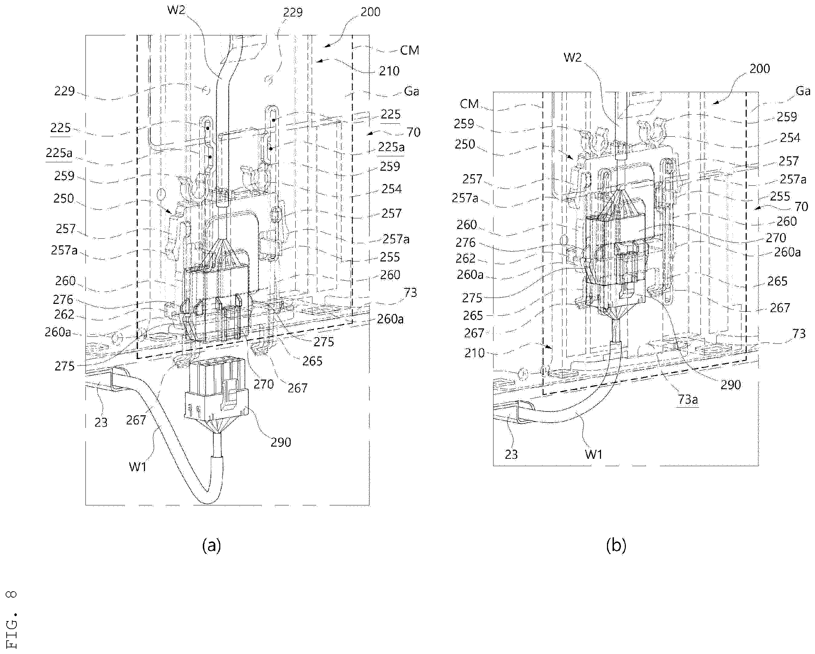

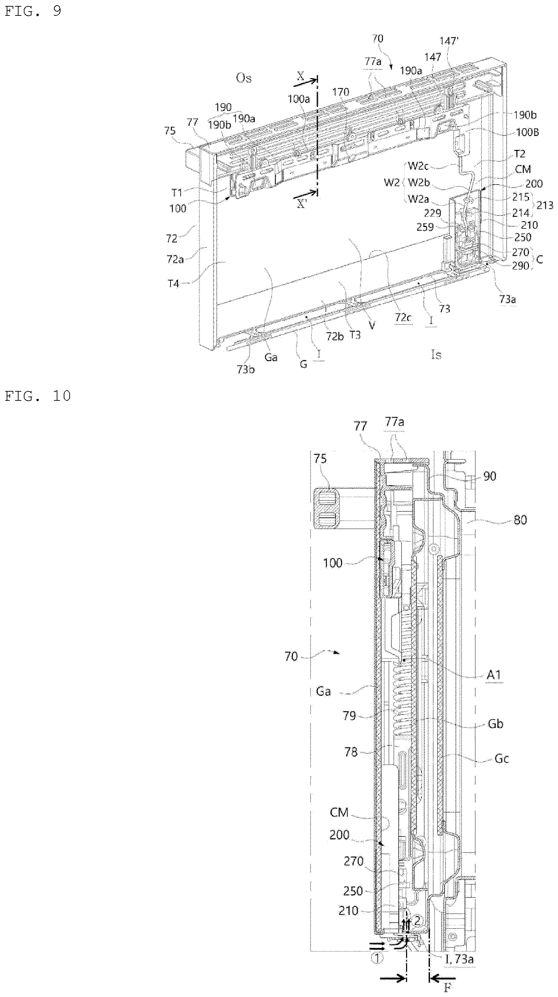

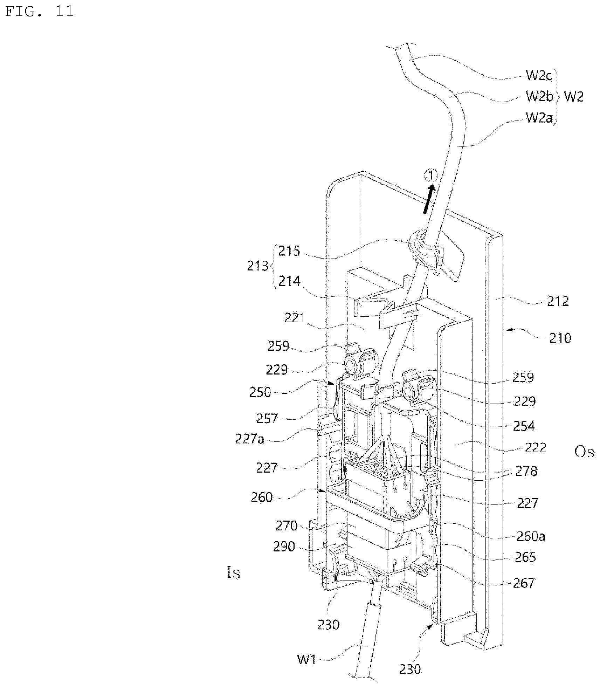

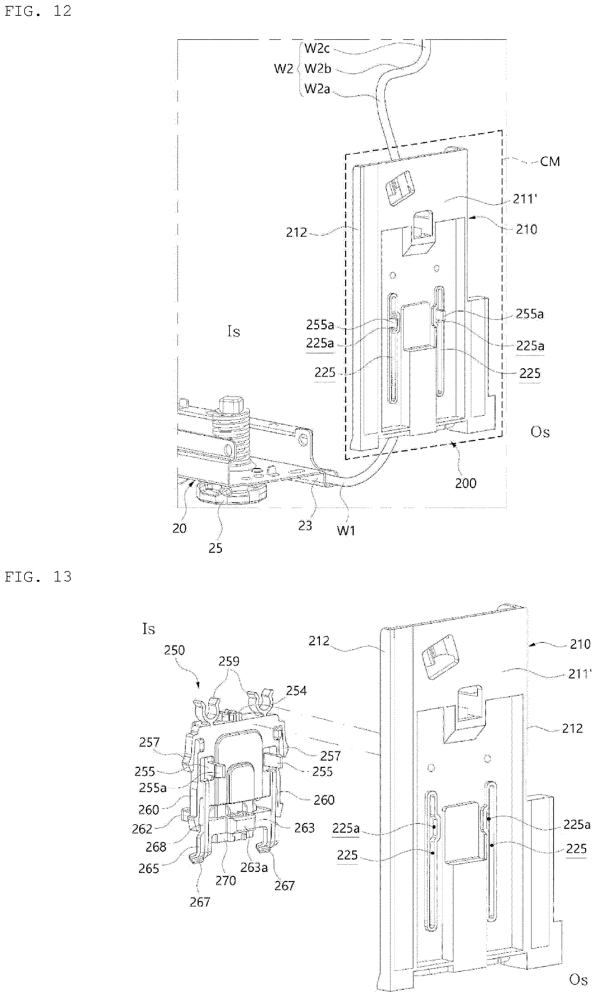

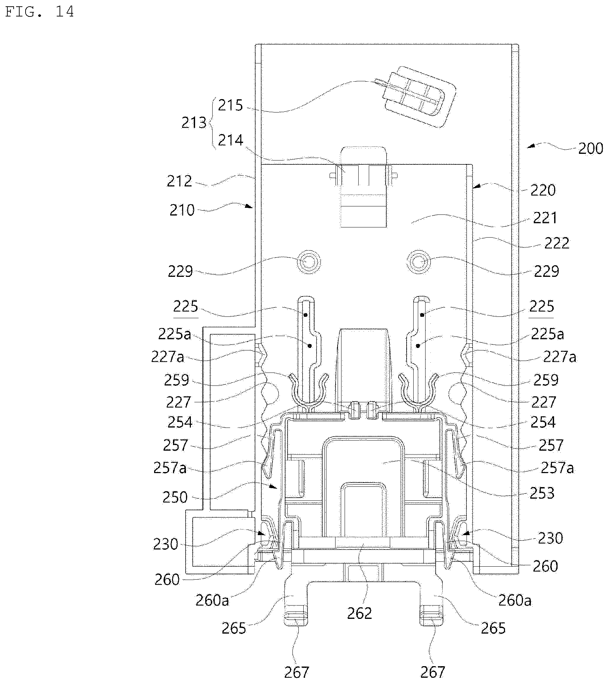

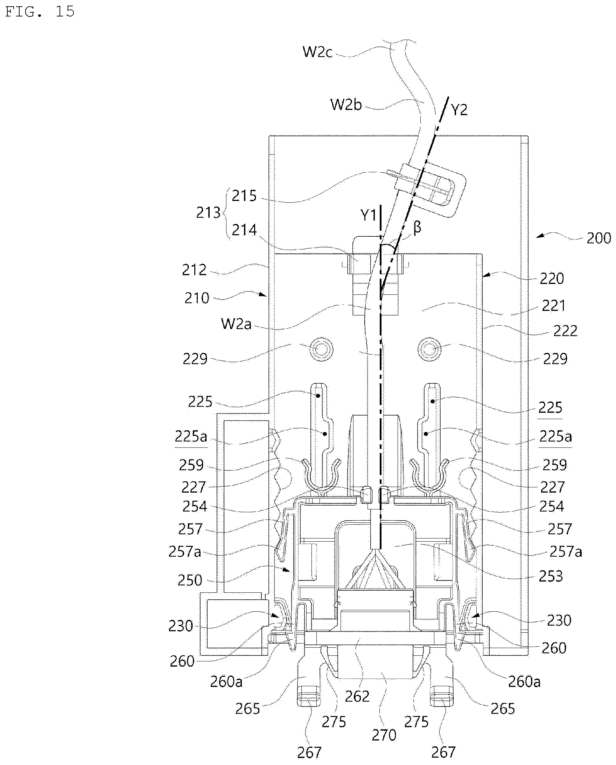

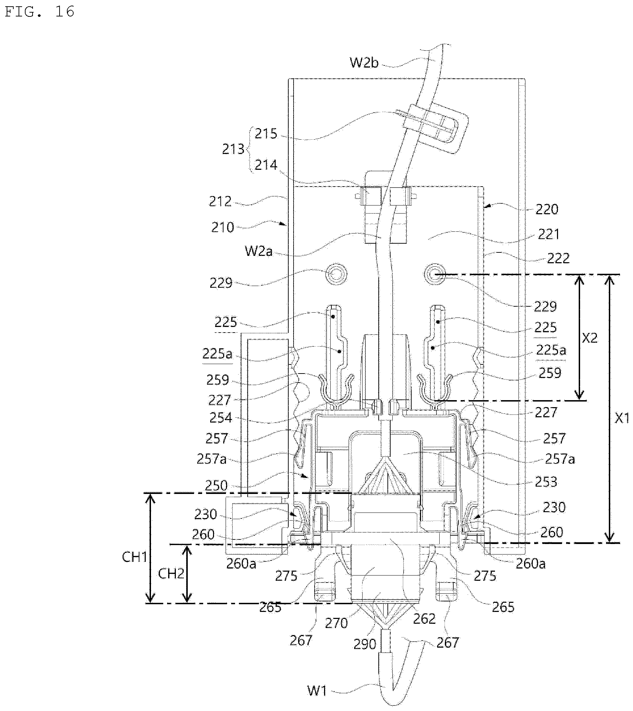

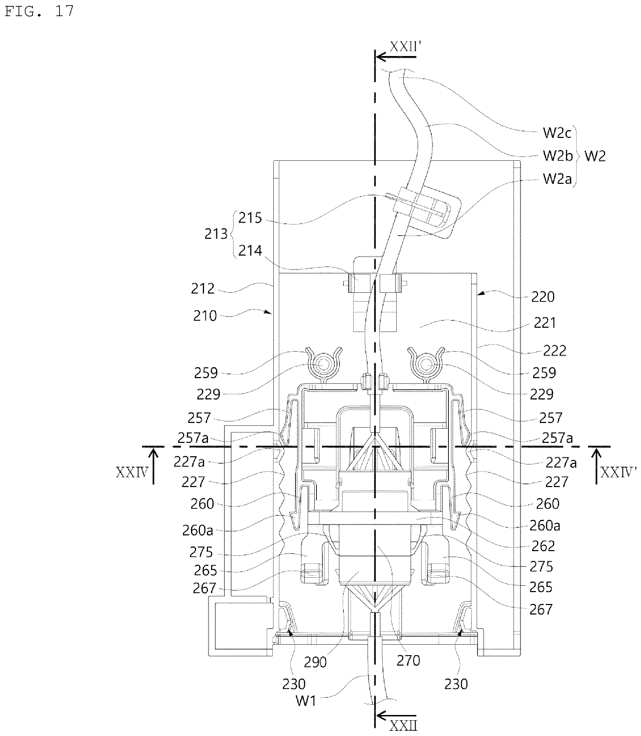

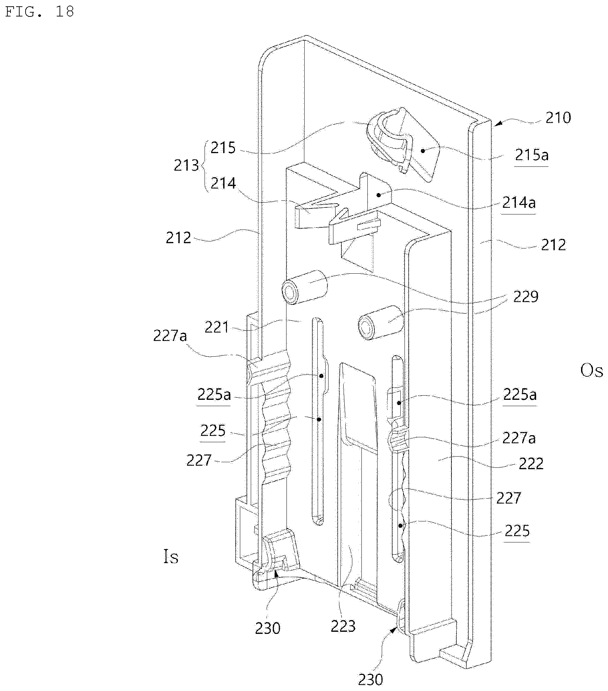

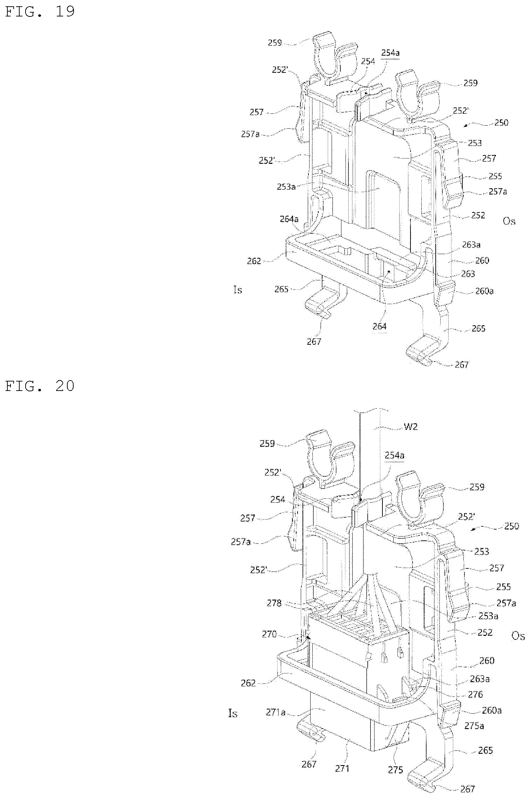

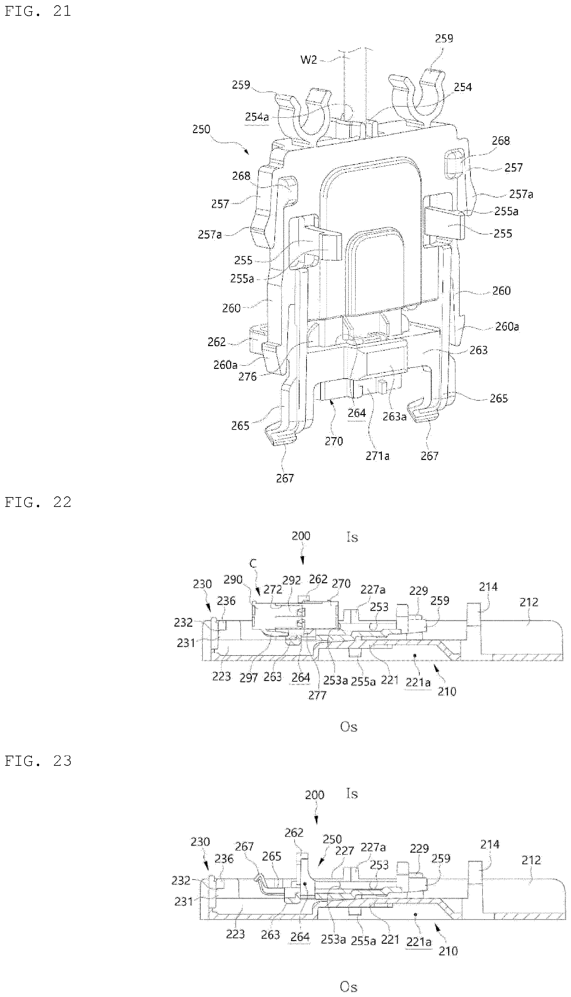

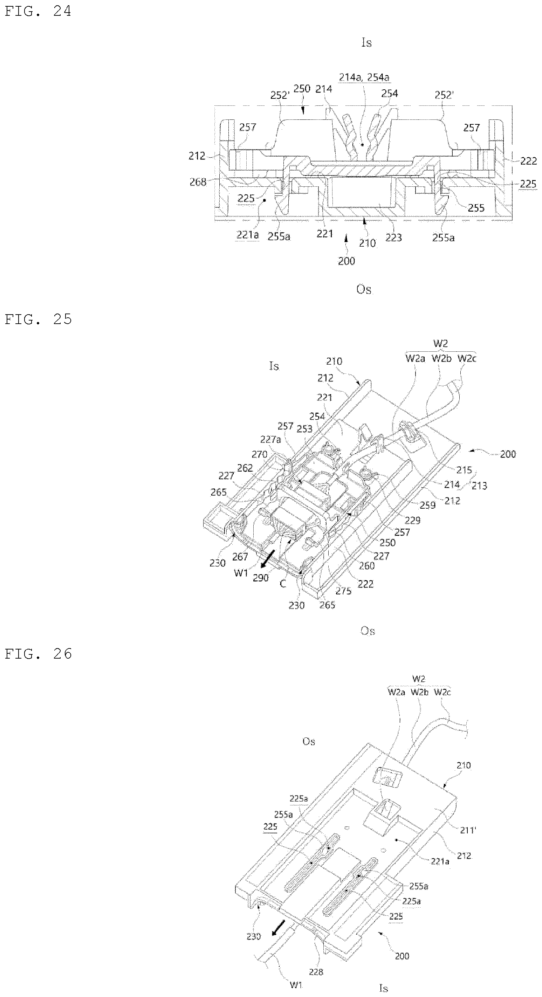

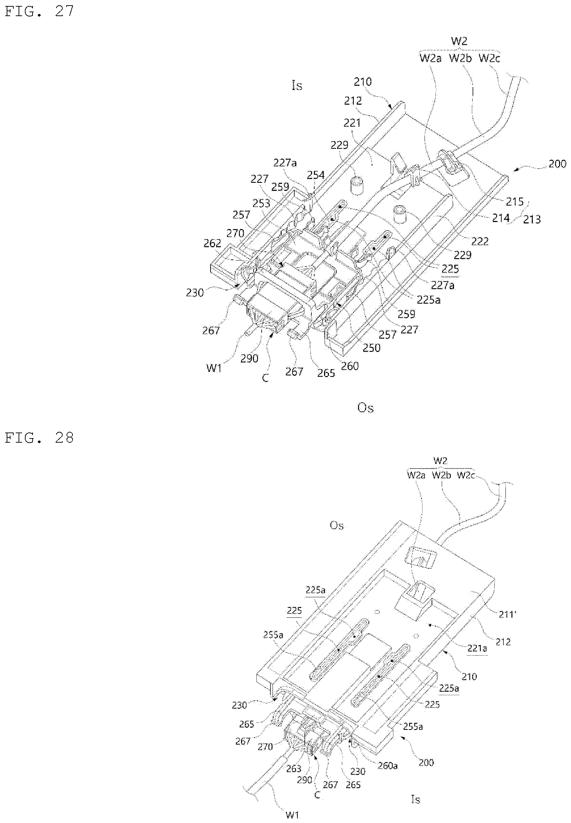

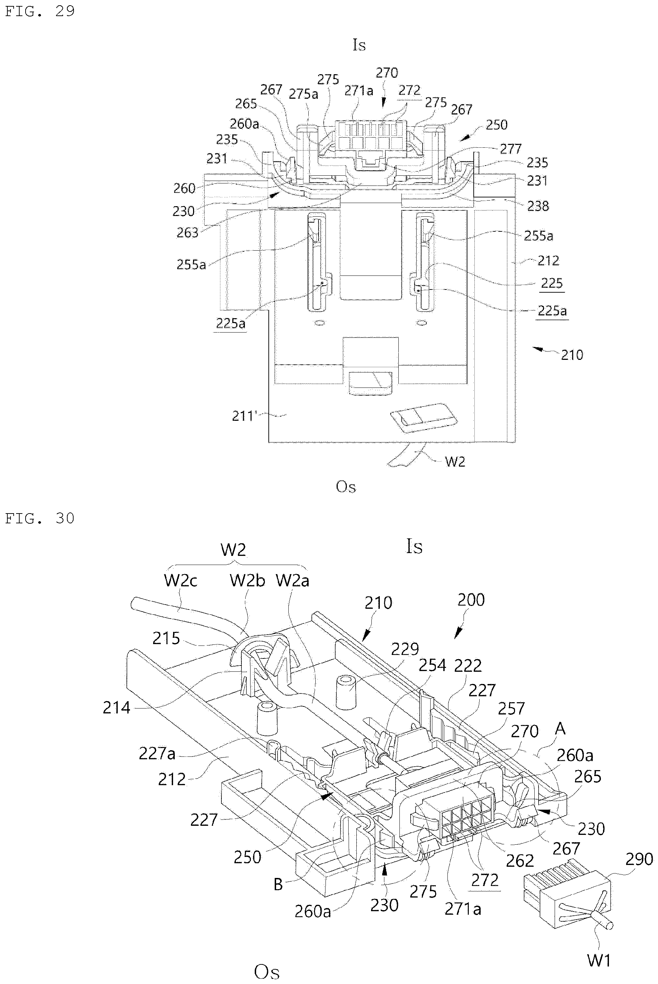

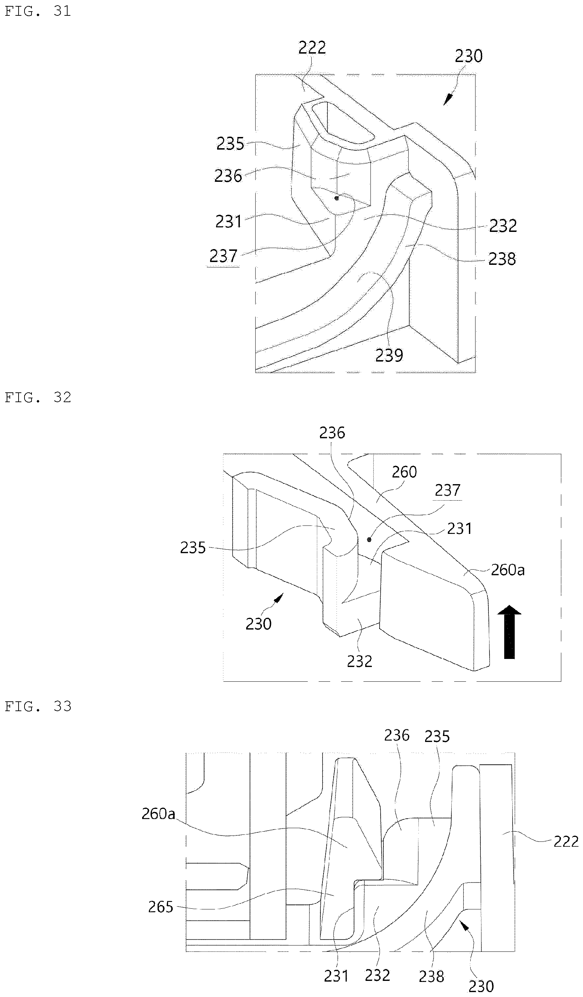

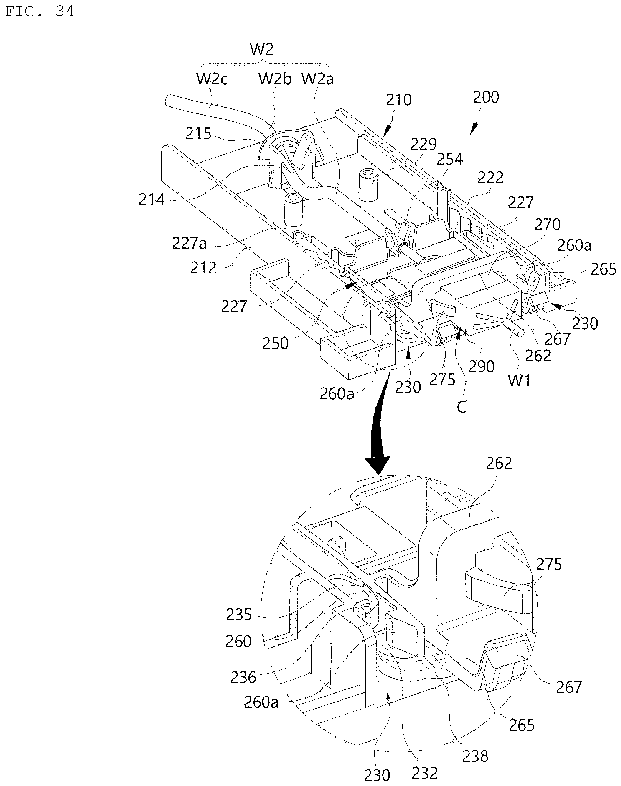

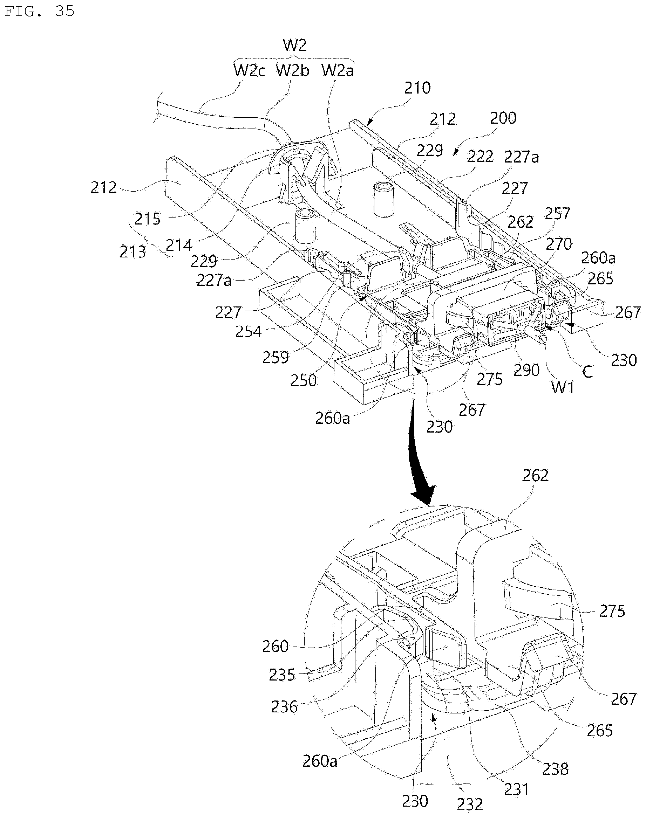

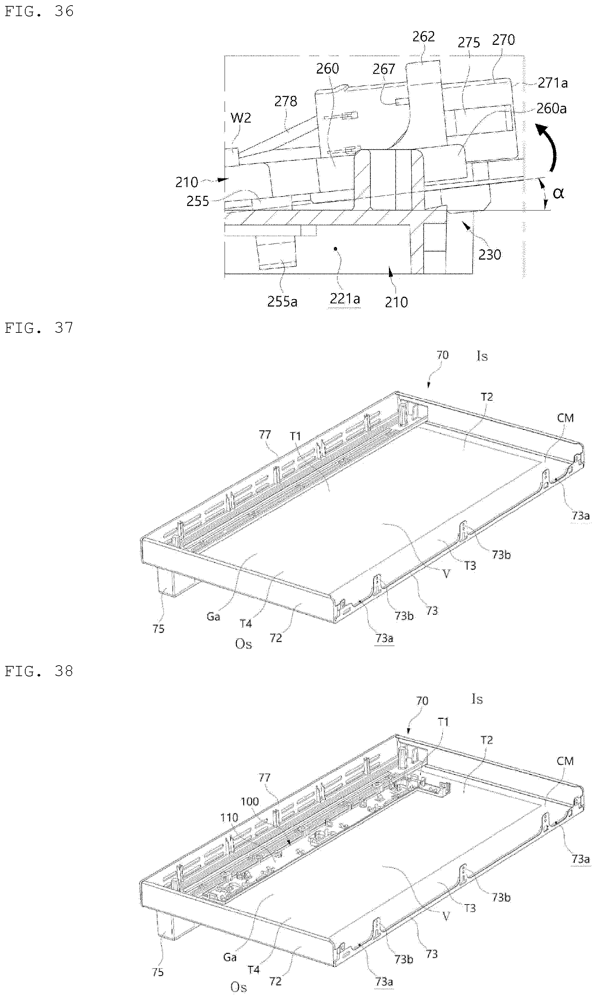

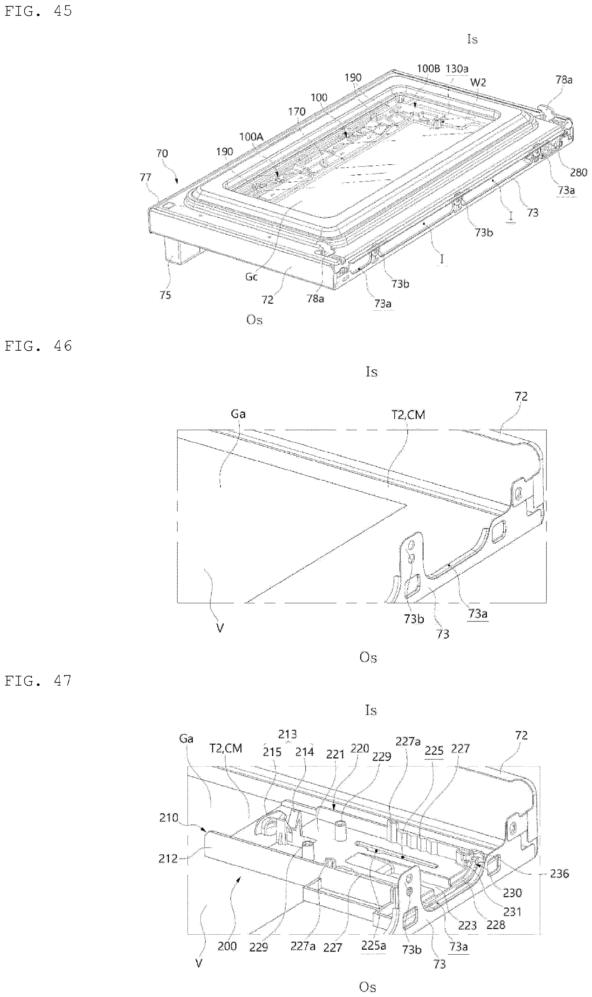

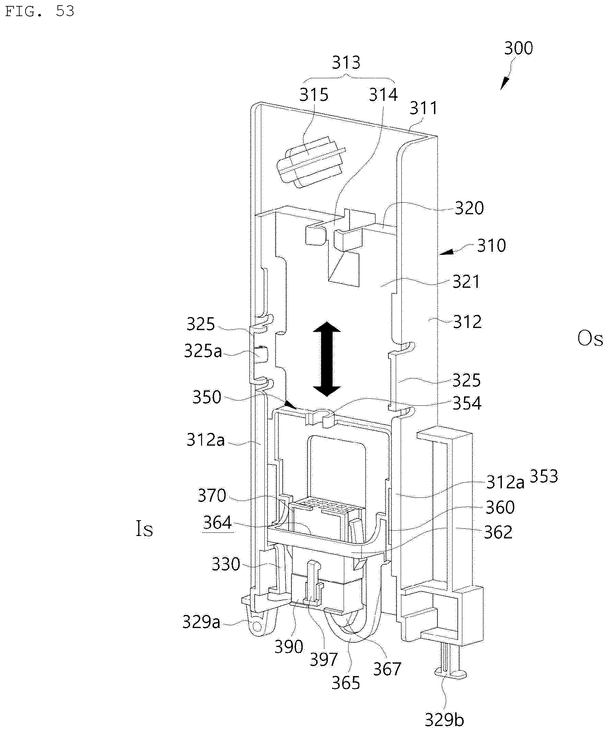

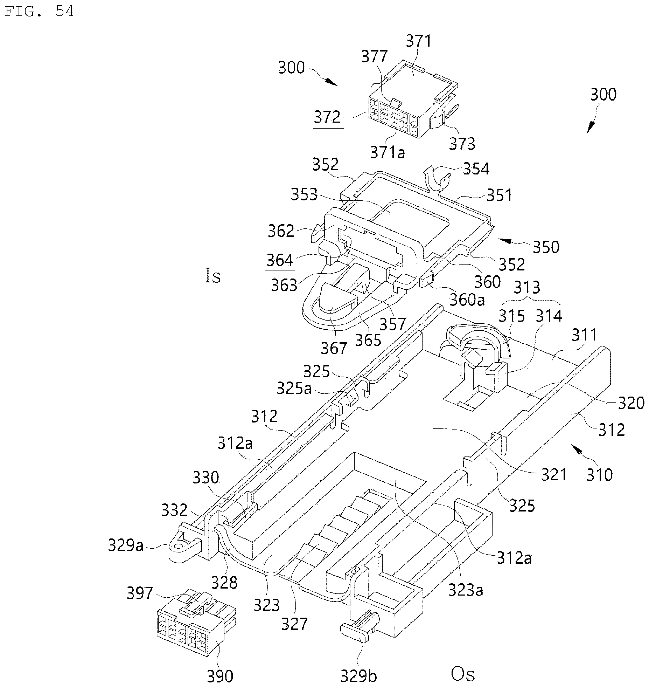

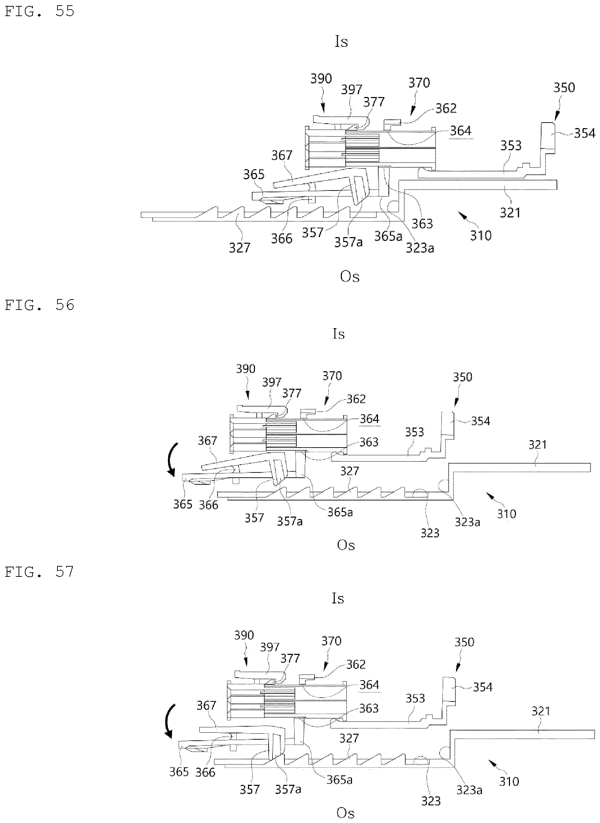

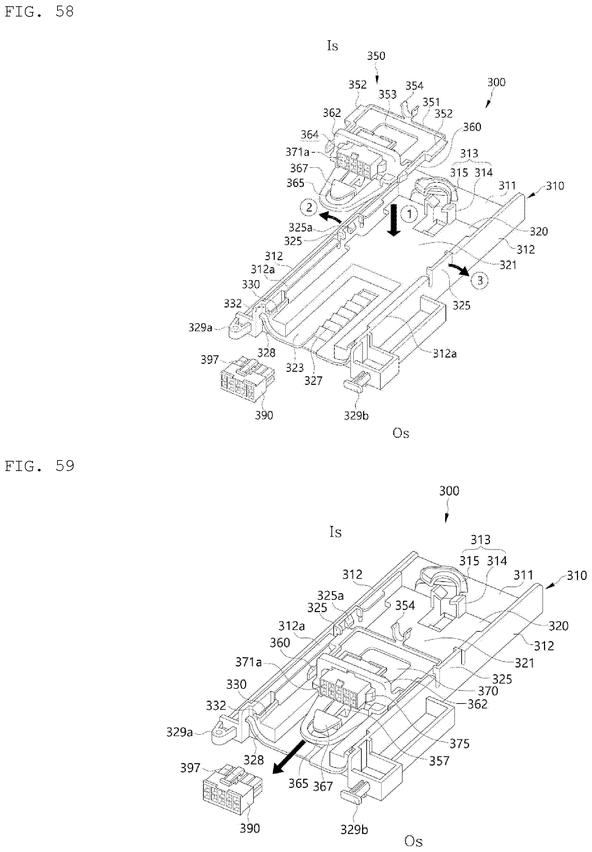

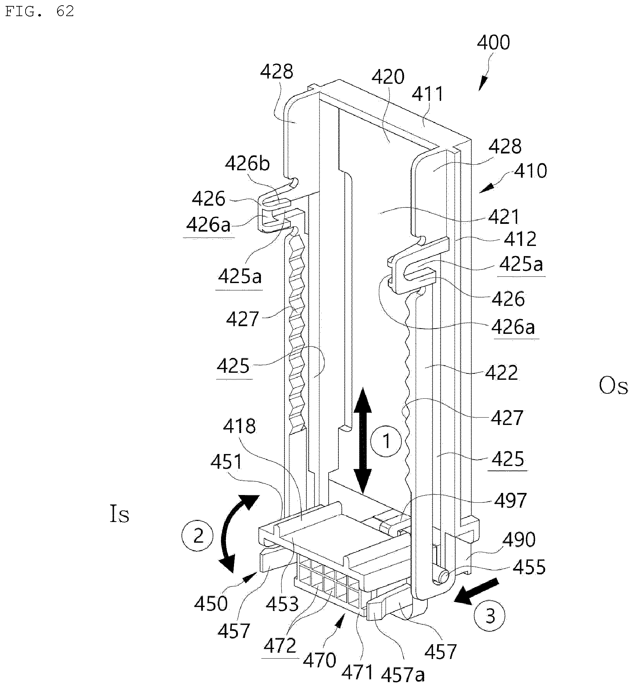

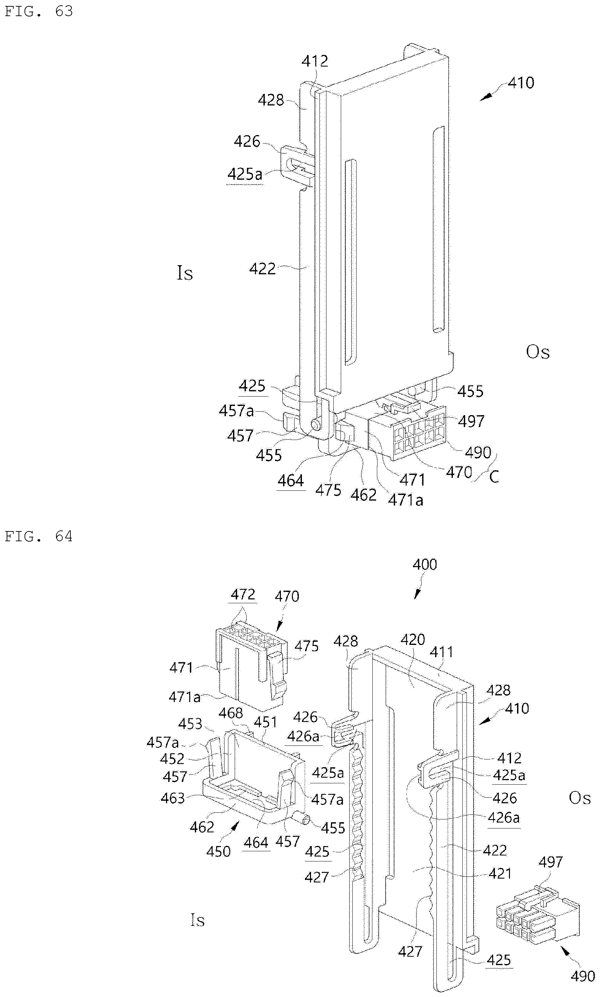

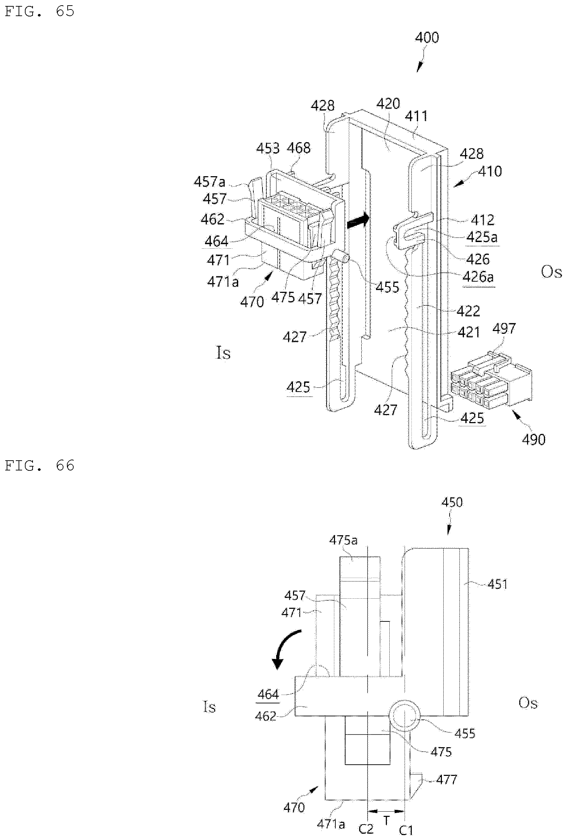

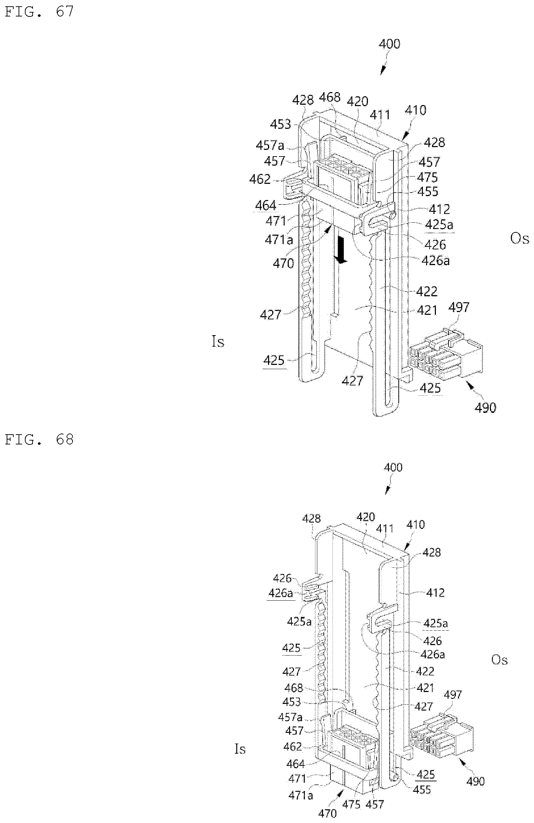

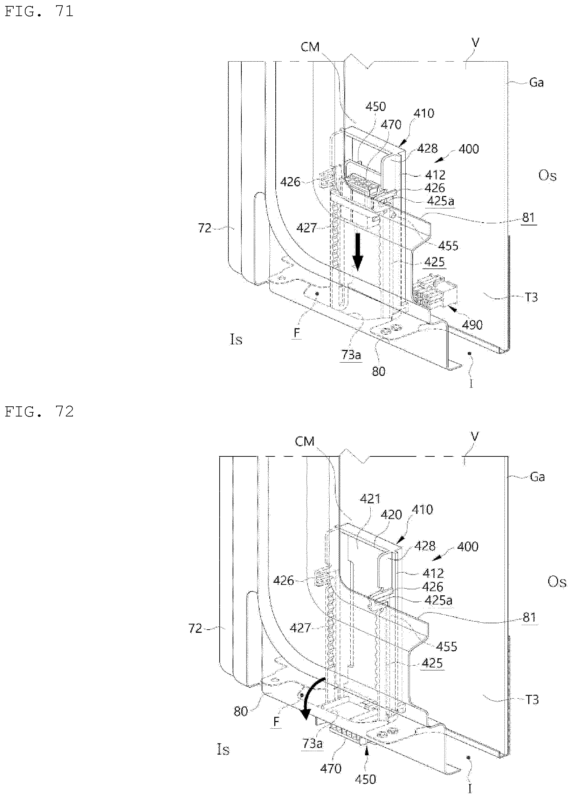

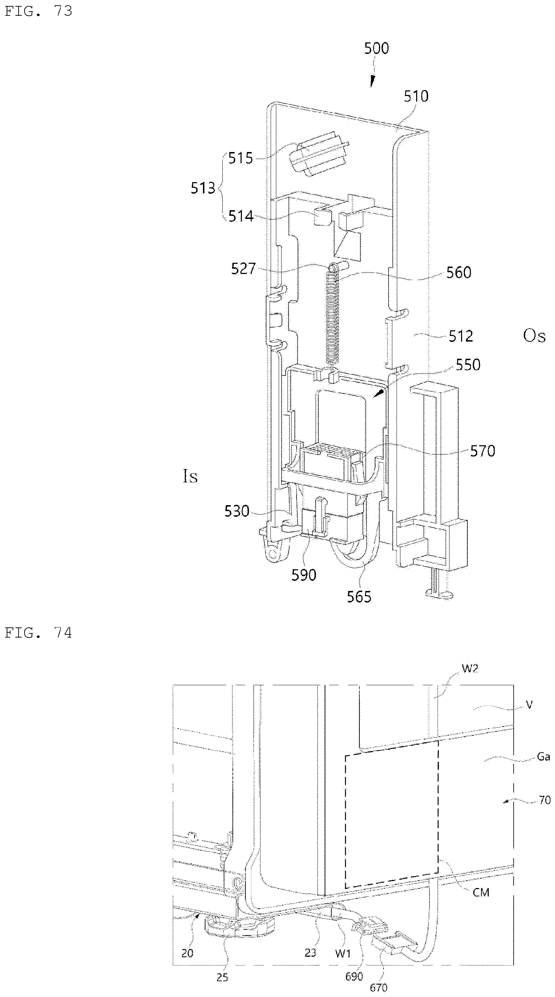

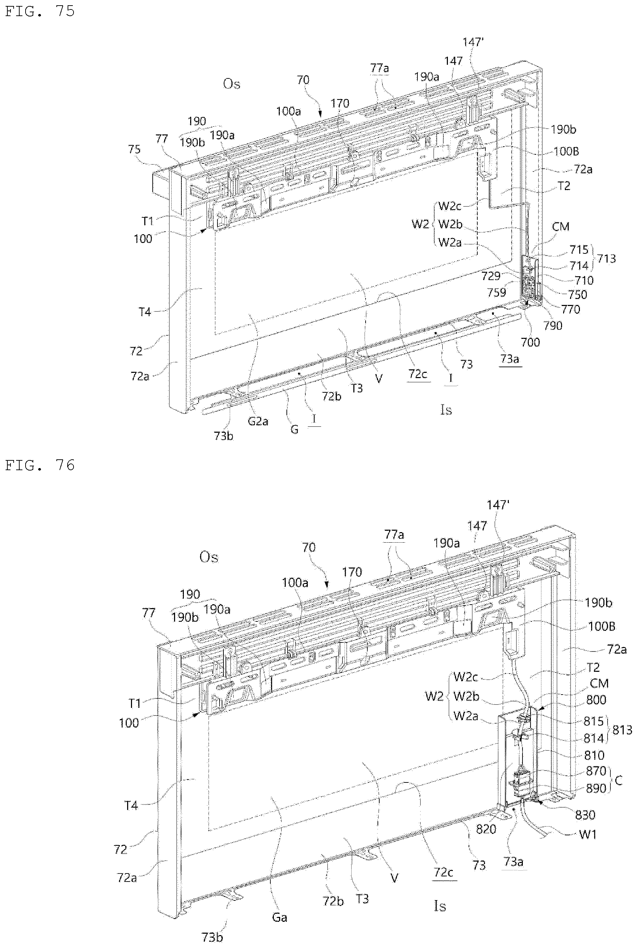

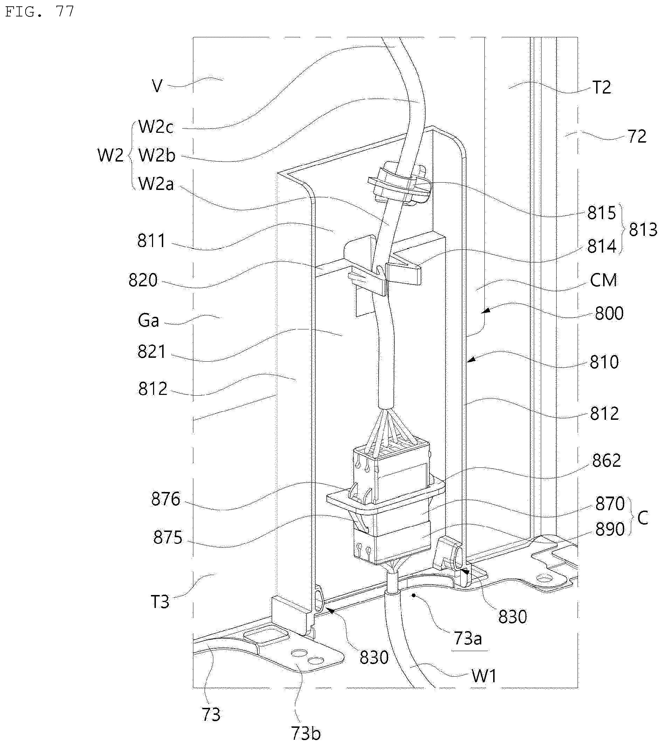

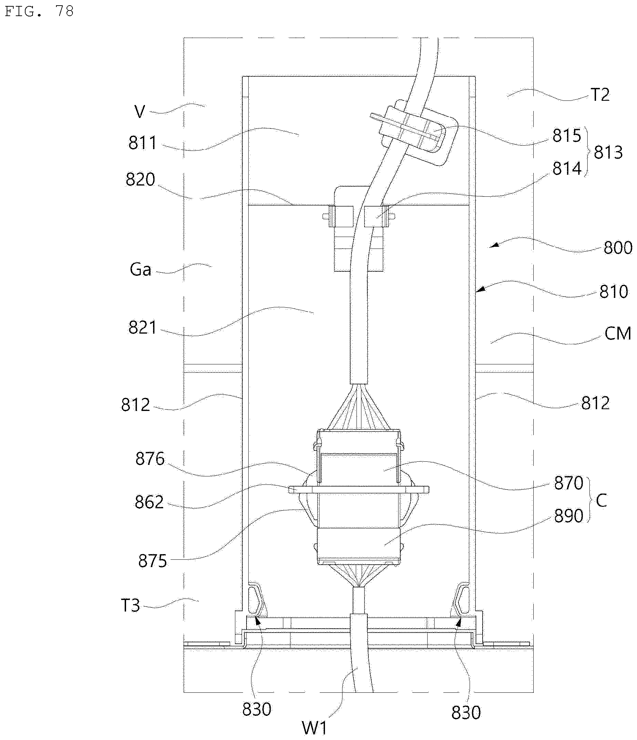

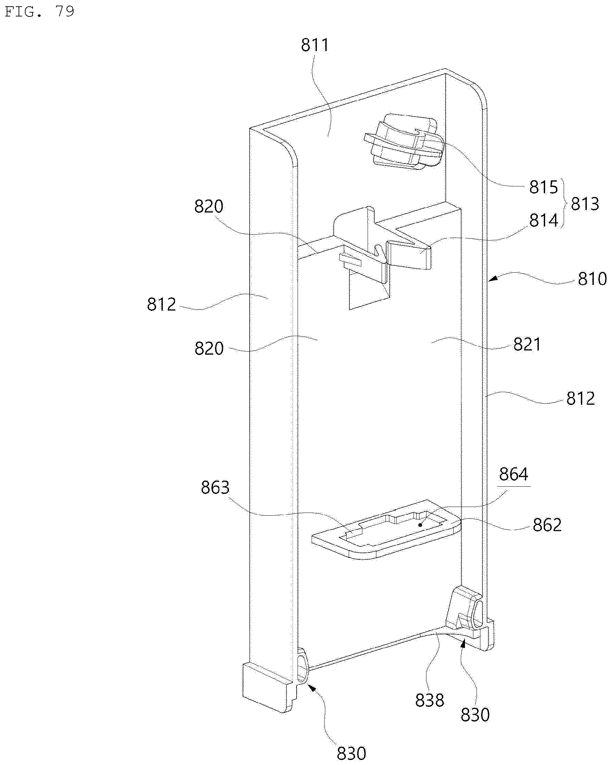

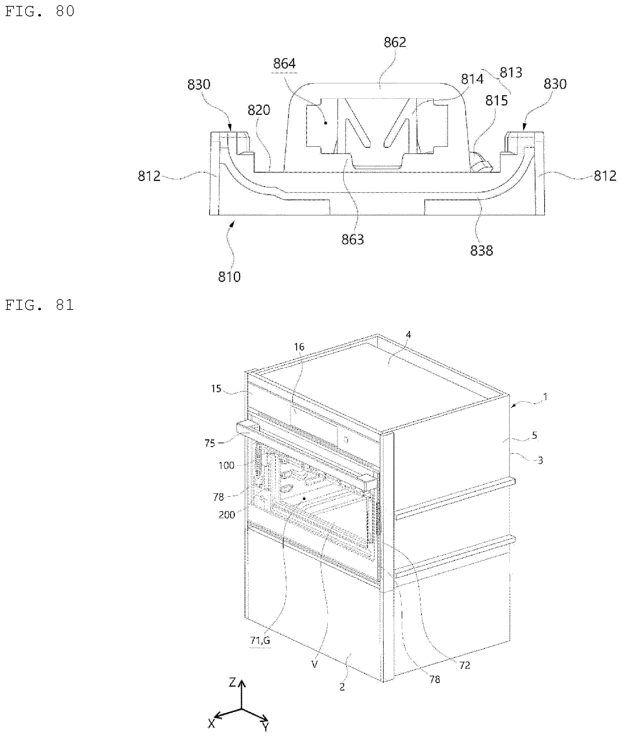

FIG. 1 is a perspective view illustrating an embodiment of a home appliance according to the present disclosure. FIG. 2 is a perspective view illustrating the embodiment of the present disclosure with a separated side cover constituting the embodiment. FIG. 3 is a perspective view illustrating a lower door constituting the embodiment of the present disclosure. FIG. 4 is an exploded perspective view illustrating main components of the lower door constituting the embodiment of the present disclosure. FIG. 5 is a perspective view, in greater detail than FIG. 4, illustrating the main components of the lower door constituting the embodiment of the present disclosure. FIG. 6 is a perspective view illustrating a structure of the lower door, an image acquisition module, a connector module, a main wire, and a connector wire constituting the embodiment of the present disclosure. FIG. 7 is a perspective view illustrating the connector module constituting the embodiment of the present disclosure assembled at a lower portion of the lower door. FIGS. 8A and 8B are perspective views illustrating the connector module constituting the embodiment of the present disclosure before and after being stored into the lower door. FIG. 9 is a perspective view illustrating the internal part of the lower door without a rear frame and an inner frame of the lower door constituting the embodiment of the present disclosure. FIG. 10 is a sectional view taken along line X-X' of FIG. 9. FIG. 11 is a perspective view illustrating an embodiment of the connector module constituting the door for a home appliance according to the present disclosure. FIG. 12 is a perspective view illustrating the embodiment of the connector module according to the present disclosure in a mounted state to the lower door, without the lower door. FIG. 13 is a perspective view illustrating a movement supporter and a door connector separated from each other in a mounting base constituting the embodiment of the connector module according to the present disclosure. FIG. 14 is a plan view illustrating the movement supporter coupled to the mounting base constituting the embodiment of the connector module according to the present disclosure. FIG. 15 is a plan view illustrating the movement supporter and the door connector coupled to the mounting base constituting the embodiment of the connector module according to the present disclosure. FIG. 16 is a plan view illustrating the movement supporter, the door connector, and a main connector connected to the mounting base constituting the embodiment of the connector module according to the present disclosure. FIG. 17 is a plan view illustrating the movement supporter, the door connector, and the main connector moved upward from FIG. 3. FIG. 18 is a perspective view illustrating a structure of the mounting base constituting the embodiment of the connector module according to the present disclosure. FIG. 19 is a perspective view illustrating a structure of the movement supporter constituting the embodiment of the connector module according to the present disclosure. FIG. 20 is a perspective view illustrating the door connector mounted to the movement supporter constituting the embodiment of the connector module according to the present disclosure. FIG. 21 is a perspective view illustrating the structure of FIG. 20 at a different angle from FIG. 20. FIG. 22 is a sectional view taken along line XXII-XXII' of FIG. 17. FIG. 23 is a sectional view illustrating the state of FIG. 22 without the door connector and the main connector. FIG. 24 is a sectional view taken along line XXIV-XXIV' of FIG. 17. FIG. 25 is a perspective view illustrating the movement supporter and a connector assembly constituting the embodiment of the connector module according to the present disclosure, the movement supporter and the connector assembly being disposed at a storage position. FIG. 26 is a perspective view illustrating the state of FIG. 25 at a different angle from FIG. 25. FIG. 27 is a perspective view illustrating the movement supporter and the connector assembly constituting the embodiment of the connector module according to the present disclosure, the movement supporter and the connector assembly being disposed at an operation position. FIG. 28 is a perspective view illustrating the state of FIG. 27 at a different angle from FIG. 27. FIG. 29 is a perspective view illustrating the state of FIG. 27 at a different angle from FIGS. 27 and 28. FIG. 30 is a perspective view illustrating the main connector separated from the embodiment of the connector module according to the present disclosure. FIG. 31 is an enlarged view illustrating part A of FIG. 30. FIG. 32 is an enlarged view illustrating part B of FIG. 30. FIG. 33 is an enlarged view illustrating the movement supporter in a released state from the embodiment of the connector module according to the present disclosure. FIG. 34 is a perspective view illustrating the embodiment of the connector module according to the present disclosure located at the operation position. FIG. 35 is a perspective view illustrating the movement supporter of FIG. 34 turned from the mounting base into a released state. FIG. 36 is an enlarged view illustrating the state of FIG. 35 when viewed from the side space. FIGS. 37 to 45 are sequence views sequentially illustrating a process of forming a door for a home appliance according to the present disclosure. FIGS. 46 to 52 are sequence views sequentially illustrating a process of mounting the connector module constituting the door for a home appliance according to the present disclosure to the door. FIG. 53 is a perspective view illustrating a second embodiment of the connector module constituting the door for a home appliance according to the present disclosure. FIG. 54 is an exploded perspective view illustrating parts of the second embodiment of the connector module constituting the present disclosure. FIGS. 55 to 57 are operational state views sequentially illustrating a process in which the movement supporter of the second embodiment of the connector module constituting the present disclosure is moved from the storage position to the operation position. FIGS. 58 to 61 are operational state views sequentially illustrating a process in which the connector module of the second embodiment constituting the present disclosure is moved from the storage position to the operation position and then coupled to the main connector. FIG. 62 is a perspective view illustrating a third embodiment of the connector module constituting the door for a home appliance according to the present disclosure. FIG. 63 is a perspective view illustrating the third embodiment of the connector module in FIG. 62 at a different angle from FIG. 62. FIG. 64 is an exploded perspective view illustrating parts of the third embodiment of the connector module constituting the present disclosure. FIG. 65 is a perspective view illustrating the door connector is assembled to the movement supporter in the third embodiment of the connector module constituting the present disclosure. FIG. 66 is a side view illustrating the door connector assembled to the movement supporter constituting the third embodiment of the connector module according to the present disclosure. FIGS. 67 to 70 are operational state views sequentially illustrating a process in which the connector module of the third embodiment constituting the present disclosure is moved from the storage position to the operation position and then coupled to the main connector. FIG. 71 is a perspective view illustrating the third embodiment of the connector module constituting the present disclosure disposed at the storage position with the lower door. FIG. 72 is a perspective view illustrating the third embodiment of the connector module constituting the present disclosure disposed at the operation position with the lower door. FIG. 73 is a perspective view illustrating a fourth embodiment of the connector module constituting the door for a home appliance according to the present disclosure. FIG. 74 is a perspective view illustrating a fifth embodiment of the connector module constituting the door for a home appliance according to the present disclosure. FIG. 75 is a perspective view illustrating a sixth embodiment of the connector module constituting the door for a home appliance according to the present disclosure. FIG. 76 is a perspective view illustrating a seventh embodiment of the connector module constituting the present disclosure, the view illustrating the connector module mounted to the door. FIG. 77 is a perspective view illustrating the seventh embodiment of the connector module constituting the present disclosure. FIG. 78 is a plan view illustrating a structure of the seventh embodiment of the connector module constituting the present disclosure. FIG. 79 is a perspective view illustrating a structure of the mounting base of the seventh embodiment of the connector module constituting the present disclosure. FIG. 80 is a front view illustrating the structure of the mounting base of the seventh embodiment of the connector module constituting the present disclosure. FIG. 81 is a perspective view illustrating another embodiment of the home appliance according to the present disclosure.

### DETAILED DESCRIPTION

Hereinafter, exemplary embodiments of the present disclosure will be described in detail with reference to the illustrative drawings. Wherever possible, the same reference numerals will be used throughout the drawings and the description to refer to the same or like elements or parts.

The present disclosure relates to doors for a home appliance (hereinafter, which will be referred to as "door"). Herein, the home appliance may include a storage space 31, 41 therein. The door may open and close the storage space 31, 41. The door may be applied to various home appliances such as a cooking appliance, a refrigerator, a freezer, a kimchi refrigerator, a plant cultivating apparatus, Styler^{®}, a washing machine, etc. Otherwise, the door may be applied to a door of furniture or an entrance door. Furthermore, in the embodiment, the door includes two doors 50 and 70, but the door of the present disclosure may also be applied to a home appliance equipped with a single lower door 70. Hereinafter, the present disclosure will describe an example in which two doors 50 and 70 are applied to a cooking appliance. Furthermore, a door at a relatively upper side of the two doors 50 and 70 may be called an upper door 50, and a door at a lower side may be called a lower door 70.

In the embodiment, an electronic compartment may be disposed in the lower door 70 of the doors 50, 70. The electronic compartment may provide various functions to the lower door 70. For example, when the electronic compartment is an image acquisition module 100, the image acquisition module 100 may be used to obtain an inside image through a storage space 41. The lower door 70 may include the inner illuminance of the storage space 41. To this end, the image acquisition module 100 may include an image sensing device 170 and a lighting device 180.

As another example, a display device (not illustrated) may be disposed at the lower door 70 as an electronic compartment. The display device may provide the information of the home appliance to a user. The user can input an operational command through the display device.

The image acquisition module 100 or a part of the display device may be provided in the lower door 70. At this point, the electronic compartment such as the image acquisition module 100, the display device, or the like may receive and transmit an electric signal with a main controller provided in a main body of the home appliance, or may be connected to the main body with a wire to supply power.

At this point, a connector 270, 290 may be connected to the wire. The connector 270, 290 may include a door connector 270 disposed in the lower door 70 and a main connector disposed in the main body. The door connector 270 may be assembled with the main connector to be electrically connected thereto. On the other hand, the door connector 270 may not be assembled with the main connector, but an external connection connector. Herein, both the main connector and the connection connector will be called a relative connector 290.

Hereinbelow, it will be described that the electronic compartment disposed in the lower door 70 is the image acquisition module 100 as an example.

Referring to FIG. 1, the view illustrates a cooking appliance equipped with the doors 50 and 70. A main body 10 of the cooking appliance may be roughly shaped into a hexahedral form. In the embodiment, the main body 10 of the cooking appliance may include two doors 50 and 70. The two doors 50 and 70 may be disposed at different heights. The two doors 50 and 70 may serve to respectively shield different storage spaces 31 and 41.

FIG. 2 illustrates a separated state of a side cover 12 constituting the main body 10 of the cooking appliance. When the side cover 12 is separated, an internal space 13 of the main body 10 of the cooking appliance may be exposed. Two cabinets 30 and 40 may be disposed inside the inside space 13 at different heights. The two cabinets 30 and 40 may include the storage spaces 31 and 41 separated from each other. As another example, the inside space 13 may include one cabinet or three or more cabinets 30 and 40. As another example, the two cabinets 30 and 40 may be disposed transversely. Reference numeral 11 indicates a rear cover constituting the main body 10 of the cooking appliance.

An upper panel 15 may be provided at an upper portion of the cooking appliance. The upper panel 15 may be disposed on an upper end portion of a front surface of the cooking appliance. The upper panel 15 may include an operating part 16. The operating part 16 may be used to operate functions of the cooking appliance and display a state of the cooking appliance. The operating part 16 may be composed of a display capable of being operated in a touch manner. As another example, the operating part 16 may include a knob rotatably moved. As another example, the operating part 16 may be omitted, and the display device may be disposed at the lower door 70.

The upper panel 15 may be connected to a main wire W1. The main wire W1 may connect the operating part 16 and a main controller (not illustrated) to each other. Otherwise, the main wire W1 may connect the operating part 16 to the electronic compartment of the lower door 70, such as the image acquisition module 100. The main wire W1 may be connected to a connection wire W2 described below, through a door wire W2.

The two cabinets 30 and 40 may be classified into a first cabinet 30 and a second cabinet 40. The first cabinet 30 and the second cabinet 40 may be disposed in the inside space 13 at different heights. An upper storage space 31 may be provided in a first cabinet 30. A lower storage space 41 may be provided in the second cabinet 40. Herein, the upper storage space 31 and the lower storage space 41 are separated from each other, and may be open only at the front portions.

The upper door 50 may be disposed in front of the first cabinet 30. The lower door 70 may be disposed in front of the second cabinet 40. In the embodiment, the upper door 50 and the lower door 70 may be operated in a kind of pull-down method in which each upper end is vertically swung on a lower end thereof. As another example, the upper door 50 and the lower door 70 may be operated in a side swing method in which each door is opened sideways.

In the upper door 50, a front surface 51 of the upper door 50 may have a structure allowing the upper storage space 31 to be visible. For example, the front surface 51 of the upper door 50 has a glass panel structure, and a user can observe the inside part of the upper storage space 31 through the upper door 50. As another example, the front surface 51 of the upper door 50 may be made of dark materials or be coated with a separate film, thereby preventing the upper storage space 31 from being visible from the outside. Reference numeral 55 indicates a first handle to open and close the upper door 50.

The lower door 70 may be disposed below the upper door 50. The lower door 70 may be disposed in front of the second cabinet 40. The lower storage space 41 may be visible through a front surface of the lower door 70. The user can observe the inside of the lower storage space 41 through the front surface of the lower door 70.

In the embodiment, the lower door 70 may include a window V The window V allows the lower storage space 41 to be visible from the outside space and may be made of a transparent material. The window V may be understood as a part of a front panel Ga constituting the front surface of the lower door 70. The window V may be provided in a central portion of the front panel Ga. For example, an edge portion of the front panel Ga may have a material with higher surface roughness unlike the window V Otherwise, a separate opaque film may be applied to the edge portion of the front panel Ga. Then, excluding the window V, the edge portion of the front panel Ga prevents the lower storage space 41 form being visible.

As another example, the edge of the front panel Ga corresponding to the outside part of the window V may be covered by a door frame 72, 77, 80, 90. Herein, the outside part of the window V may be the edge portion of the front panel Ga that surrounds the edges of the window V with the window V as the center.

As another example, the lower door 70 may be made of dark materials or coated with a separate film, thereby preventing the lower storage space 41 from being visible from the outside space. As another example, in the lower door 70, the door panel G which will be described below may be omitted, and an opaque metallic or nonmetallic plate may constitute the front surface thereof. Also, in this case, the lower storage space 41 may not be visible from the outside space.

FIG. 2 illustrates the image acquisition module 100 and the connector module 200 which are mounted inside the lower door 70. Although FIG. 2 illustrates the image acquisition module 100 and the connector module 200 indicating positions where the image acquisition module 100 and the connector module 200 are mounted inside the lower door 70, the image acquisition module 100 and the connector module 200 may not be visible from the front space of the cooking appliance. This is because, as described above, the edge portion of the front panel Ga excluding the window V is opaque. Reference numeral 75 indicates a second handle to open and close the lower door 70.

As another example, the image acquisition module 100 may be disposed in the upper door 50. As another example, two image acquisition modules 100 may be disposed in the upper door 50 and the lower door 70 respectively. As another example, the image acquisition module 100 and the connector module 200 may be separately disposed in the upper door 50 and the lower door 70.

FIG. 3 illustrates the lower door 70 when viewed from the rear side. The front surface of the lower door 70 may have a flat surface structure. In the embodiment, the surface of the front panel Ga may constitute the front surface of the lower door 70.

The window V may be provided in the central portion of the front surface of the lower door 70. The window V may be a portion made of a transparent or translucent material so that the lower storage space 41 may be visible from the outside space. The window V may be located through a central portion of a plurality of panels constituting the door panel G. FIG. 3 illustrates the window V provided in a central portion of a second rear panel Gc constituting the door panel G.

A frame of the lower door 70 may be formed from the door body. The door body may include the door frame 72, 77, 80, 90 and the door panel G. The door body may have roughly a hexahedral structure when the door frame 72, 77, 80, 90 and the door panel G are assembled.

Referring to FIGS. 4 and 5, the door frame 72, 77, 80, 90 may include multiple frame parts. In the embodiment, the door frame 72, 77, 80, 90 may include a front frame part 72, a rear frame part 80, an inner frame part 90, and the upper frame part 77. The frame parts may be coupled to each other to provide one door frame 72, 77, 80, 90.

Herein, "front" is based on the front side of the lower door 70. For reference, in the entire drawings including FIG. 4, "Is" indicates the inside area of the lower door 70 facing the storage space 41, and "Os" indicates the outside area of the home appliance, i.e., the outside space of the lower door 70.

The front frame part 72 may be disposed at the front part of the door frame 72, 77, 80, 90. More specifically, the front frame part 72 may form a front frame of the door frame 72, 77, 80, 90. The front frame part 72 may be formed roughly in a rectangular frame shape. The front frame part 72 may be formed in a rectangular frame shape with an upper portion and a lower portion open upward and downward, respectively. A pair of front side plates 72a may be provided at both sides of the front frame part 72. The pair of front side plates 72a may stand vertically. A front lower plate 72b may connect the pair of front side plates 72a to each other while being located therebetween. The front side plates 72a and the front lower plate 72b are connected to each other to form roughly a "U" shape.

A front opening 72c may be provided between the front side plates 72a and the front lower plate 72b. The front opening 72c may be an empty space open in a longitudinal direction. The front panel Ga constituting the door panel G (referring to FIG. 1) may be disposed in the front opening 72c. It may be understood that an open portion of the front opening 72c is filled with the front panel Ga.

More specifically, the region of the door panel G is wider than the region of the front opening 72c, so a part of the front side plates 72a and a part of the front lower plate 72b may be stacked with the door panel G respectively. The front side plates 72a, the front lower plate 72b, and the front panel Ga may be coupled to each other by an adhesive or an adhesive tape. FIG. 4 illustrates the front panel Ga and the front frame part 72 stacked to each other. FIG. 4 illustrates the front panel Ga with a lower portion covering most of a rear surface of the front lower plate 72b.

With the second front side plates 72a of the front frame part 72 located in the center, the front panel Ga may be disposed at one side. The second handle 75 may be disposed at the opposite side of the second front side plates 72a. Herein, a separate fastener (not illustrated) passes through the second front side plates 72a and a panel fastening hole G2a' of the front panel Ga and then may be fastened to a handle assembly part 75a of the second handle 75.

A lower frame part 73 may be provided at a lower end of the front frame part 72. The lower frame part 73 may be a part of the front frame part 72 or a separate object. The lower frame part 73 may have a shape bent from the lower end of the front frame part 72. The lower frame part 73 may include a connector inlet 73a. The connector inlet 73a may be provided at an operation position described below. A fabricator may access a connector storage part CM through the connector inlet 73a.

The image acquisition module 100 may be disposed in rear of the front panel Ga. Herein, the image acquisition module 100 may be adhered to a rear surface of the front panel Ga. More specifically, a partial surface of a front surface of the image acquisition module 100 and a partial surface of the rear surface of the front panel Ga may be adhered to each other.

For reference, the image acquisition module 100 may include an image sensing device 170. The image acquisition module 100 may include a plurality of lighting devices 180 with the image sensing device 170. The plurality of lighting devices 180 increases the illuminance of the lower storage space 41 so that the image sensing device 170 acquires a clearer image. In the embodiment, the plurality of lighting devices 180 may include a first lighting part 180a and a second lighting part 180b. As another example, the image sensing device 170 or the plurality of lighting devices 180 may be omitted.

Referring to FIG. 5, a rear panel Gc of insulation panels Gb and Gc constituting a rear surface of the lower door 70 may be exposed rearward. The rear panel Gc may also include a window V The window V of the rear panel Gc and the window V of the front panel Ga are successively disposed at a predetermined distance therebetween and assigned with the same reference numeral. Although no reference numeral is assigned, in the insulation panels Gb and Gc, the inner panel Gb unexposed outward of the lower door 70 may also have a window V

Describing the door panel G with reference to FIG. 5, the door panel G may include 3 panels in total. The 3 panels may include the front panel Ga disposed at the frontmost side, the inner panel Gb disposed in the lower door 70, and the rear panel Gc disposed at the rearmost side. Among the panels, the front panel Ga may be exposed forward (a front side of the main body 10 of the home appliance). The rear panel Gc may be exposed rearward (a rear side facing the lower storage space 41).

The inner panel Gb and the rear panel Gc may constitute the insulation panels Gb and Gc. The inner panel Gb and the rear panel Gc may be stacked to each other at a constant distance. In addition, an empty space between the inner panel Gb and the rear panel Gc becomes a vacuum, thereby increasing insulation performance. As another example, the insulation panels Gb and Gc may include only the rear panel Gc without the inner panel Gb.

Installation regions T1 to T4 may be provided between the front panel Ga and the insulation panels Gb and Gc. The installation regions T1 to T4 may be provided in the empty space between the front panel Ga and the insulation panels Gb and Gc. The installation regions T1 to T4 may be a portion where the image acquisition module 100 and the connector module 200 are disposed. As another example, the insulation panels Gb and Gc are omitted, and the installation regions T1 to T4 may be disposed between the front panel Ga and the door frame 72, 77, 80, 90.

Referring to FIG. 10, a cooling flow path A1 may be provided between the front panel Ga and the insulation panels Gb and Gc. The cooling flow path A1 may be the entire space between the front panel Ga and the insulation panels Gb and Gc. The installation regions T1 to T4 may be disposed outside the window V with the window V as the center. Therefore, the cooling flow path A1 is wider than the installation regions T1 to T4, and the installation regions T1 to T4 may constitute a part of the cooling flow path A1.

Air may flow into the door panel G along the cooling flow path A1. Accordingly, the cooling flow path A1 may be a flowing space in which air flows.

As another example, the door panel G is not provided as a separate object, but may be a part of the door frame 72, 77, 80, 90. The door panel G may be integrally provided with the door frame 72, 77, 80, 90. In this case, the door panel G is not made of a transparent material and may shield the lower storage space 41 to prevent the lower storage space 41 from being exposed. The door panel G may be made of the same material as the door body. For example, the door panel G may have a metal or nonmetal plate structure.

In FIG. 4, the installation regions T1 to T4 are indicated. The installation regions T1 to T4 are portions where the image acquisition module 100 and the connector module 200 are disposed, and a dotted line in FIG. 4 is expressed to help understand the installation regions T1 to T4. In FIG. 4, the installation regions T1 to T4 are illustrated at the rear surface of the front panel Ga, but the installation regions T1 to T4 are actually provided in the empty space between the plurality panels and the door frame 72, 77, 80, 90.

Herein, the upper frame part 77 of the door frame 72, 77, 80, 90 may cover a part of an upper end of the rear surface of the front panel Ga. A part of the installation regions T1 to T4 may be formed in a portion not covered by the upper frame part 77. More specifically, in the installation regions T1 to T4, the first installation region T1, T3 may be provided at a lower portion of the upper frame part 77 that is not covered by the upper frame part 77.

The installation regions T1 to T4 may include (i) the first installation region T 1, T3 formed in a first direction along an edge of the window V, and (ii) a second installation region T2, T3 formed in a second direction different from the first direction along an edge of the window V In the embodiment, the first direction is a transverse direction (a transverse width direction of the lower door 70), and the second direction is a vertical direction (a height direction of the lower door 70).

The first installation region T 1, T3 may be formed at each of an upper portion T1 and a lower portion T3 of the window V with the window V as the center. The second installation region T2, T3 may be formed at each side portion of the window V with the window V as the center. In other divisions, the installation region T1 to T4 may be divided into (i) the upper region T1 provided at the upper portion of the window V, (ii) the right region T2 provided at the right portion of the window V, (iii) the lower region T3 provided at the lower portion of the window V, and (iv) the left region T4 provided at the left portion of the window V The division is based on FIG. 4.

The first installation region T1, T3 and the second installation region T2, T3 may be connected to each other. Opposite end portions of the first installation region T1, T3 and the opposite end portions of the second installation region T2, T3 are connected to each other. Accordingly, the installation regions T1 to T4 may be formed in connected spaces. Then, the image acquisition module 100 and the connector module 200 may be disposed to pass through the multiple installation regions T1 to T4.

In the embodiment, a main unit 100A, i.e., a part of the image acquisition module 100 may be disposed in the first installation region T1, T3. Apart of a connection unit 100B, i.e., a remaining part of the image acquisition module 100 may be disposed in the second installation region T2, T3. The image acquisition module 100 and the connector module 200 may be electrically connected to each other through the door wire W2. In the embodiment, the connector module 200 is disposed in the second installation region T2, T3.

At least a part of the installation regions T1 to T4 may be provided at a region where a part of the door frame 72, 77, 80, 90 covers a rear surface of the front panel Ga. At this point, covering, by the rear frame part 80, a part of the image acquisition module 100 is based on the rear space of the lower door 70, i.e., a direction from the inside space of the lower storage space 41 to the rear surface of the lower door 70 when the lower door 70 is closed.

In the embodiment, the connector module 200 may be disposed in a part of the second installation region T2, T3, and a part of the first installation region T1, T3. FIG. 9 illustrates the connector module 200 disposed over the right side region T2 provided at the right side portion of the window V, and the lower region T3 provided at a lower portion of the window V both the right side region T2 and the lower region T3 are provided outside the window V, so the regions may not be exposed outward.

As another example, the connector module 200 may be disposed at one of the regions including the upper region T1, the lower region T3, and the left side region T4. As another example, the connector module 200 does not extend to the lower region T3, and may be disposed in the right side region T2.

Preferably, considering the accessibility of the fabricator, one end portion of the connector module 200 may be disposed at an outer edge of the installation region T1 to T4. Then, the fabricator can easily access one end portion of the connector module 200 to assemble or maintain the connector module 200.

The image acquisition module 100 is disposed in the first installation region T1, T3, and the door wire W2 for allowing signal transmission and power supply between the image acquisition module 100 and the main controller may be disposed in the second installation region T2, T3.

Herein, the front panel Ga may be divided into the window V, and an edge part disposed around the edges of the window V Herein, the installation regions T1 to T4 may be provided on a rear surface of the edge part. At this point, the edge part may be processed to be opaque. Accordingly, the installation regions T1 to T4 provided at a lower surface of the edge part may not be exposed from the front space of the lower door 70, i.e., from the front space of the cooking appliance. The edge part may be formed by etching a part of the front panel Ga to increase the surface roughness, or by being coated with a separate film, or by being treated opaquely by a painting process.

Meanwhile, the upper frame part 77 may be disposed above an upper portion of the front opening 72c. The upper frame part 77 may be coupled to an upper portion of the front frame part 72, more specifically, to the upper ends of the pair of front side plates 72a. The upper frame part 77 may cover a part of an upper end of the rear surface of the front panel Ga. The image acquisition module 100 described below may be fixed to the upper frame part 77. Reference numerals 147 and 147' indicate module fastening parts to which fasteners are coupled to fix the image acquisition module 100 to the upper frame part 77.

The frame outlet 77a may be open in the upper frame part 77. The frame outlet 77a may be an outlet through which air passing through the cooling flow path A1 formed in the lower door 70 is discharged outward. The frame outlet 77a may be connected to the installation regions T1 to T4 as described below.

Referring to FIG. 5, the lower door 70 may include a door hinge 78. The door hinge 78 may allow the lower door 70 to be connected to the main body 10 of the cooking appliance to be turned. The door hinge 78 may be disposed in the lower door 70, more specifically, in an empty space formed between the front frame part 72 and an inner frame part 90. A door hinge arm 78a may protrude on the door hinge 78. The hinge holding arm 78a passes through an inner hinge passage part 98 of the inner frame part 90 and a rear hinge passage part 88 of the rear frame part 80 in order, and then may be fixed by being caught by the main body 10 of the cooking appliance. Reference numeral 79 is a hinge spring 79 and may be fitted over a spring guide 78b of the door hinge 78. The hinge spring 79 may provide an elastic force to the door hinge 78 in a direction of closing the lower door 70 while being tensioned when the lower door 70 is opened.

With the door panel G located in the middle, the front frame part 72 may be disposed at the front of the door panel G, and the inner frame part 90 and the rear frame part 80 may be disposed at the rear of the door panel G. The inner frame part 90 and the rear frame part 80 are spaced apart from each other (i) to form an insulation space therebetween, and (ii) to fix the second insulation panels Gb and Gc. The inner frame part 90 is disposed between the rear frame part 80 and the front frame part 72, thereby being unexposed outward.

The rear frame part 80 may be roughly formed in a rectangular frame shape. When the lower door 70 is closed, the rear frame part 80 may face a front surface of the second cavity. The rear through part 81 may be open on a central portion of the rear frame part 80. The rear through part 81 may have a longitudinally open structure so that the internal space of the lower storage space 41 may be visible through the window V

Rear side plates 82 may be provided at side surfaces of the rear frame part 80. The rear side plates 82 may be bent forward of the lower door 70. The rear side plates 82 may be disposed inside the front side plates 72a. Reference numeral 88 is the rear hinge passage part 88 through which the door hinge arm 78a of the door hinge 78 passes.

The rear frame part 80 may cover a part of the connector module 200. Accordingly, even when the user opens the lower door 70, the connector module 200 may not be exposed through the window V

The inner frame part 90 may be coupled to the rear frame part 80. The inner frame part 90 may be formed roughly in a rectangular frame shape. When the lower door 70 is closed, the inner frame part 90 may stand vertically at a distance from the rear frame part 80. An inner through part 91 may be open on a central portion of the inner frame part 90. The inner through part 91 may have a longitudinally open structure so that the internal space of the lower storage space 41 may be visible through the window V

Inner side plates 92 may be provided at side surfaces of the inner frame part 90. The inner side plates 92 may be bent forward of the lower door 70. The inner side plates 92 may overlap with the rear side plates 82. At the overlapped portions, the inner side plates 92 and the rear side plates 82 may be coupled to each other in a method such as welding, adhesion, or fastening by a separate fastener (not illustrated).

FIG. 6 illustrates the lower door 70 when viewed from the front space of the lower door 70. A wire to achieve power supply or signal transmission may be disposed in the main body 10 and the lower door 70 of the home appliance. The wire may include the main wire W1 to connect the connector module 200 of the lower door 70 to the main controller in the main body 10, and the door wire W2 to connect the connector module 200 to the image acquisition module 100.

When necessary, the fabricator can separate the main wire W1 from the connector module 200, and perform maintenance/repairing to the image acquisition module 100. For reference, FIG. 6 is a perspective view illustrating the image acquisition module 100. However, the image acquisition module 100 may be shielded by the edge part of the front panel Ga. FIG. 6 illustrates the door connector 270 constituting the connector module 200 assembled to the relative connector 290.

The connector module 200 may be disposed in the installation region T1 to T4 of the lower door 70. More specifically, the connector storage part CM may be provided in the installation region T1 to T4. The connector module 200 may be disposed in the connector storage part CM. The connector storage part CM may be an empty space, i.e., a part of the installation region T1 to T4. As another example, the connector storage part CM may be a kind of bracket integrated with the installation region T1 to T4, or provided as a separate object.

In FIG. 6, the connector storage part CM may be disposed close to a lower end portion of a side surface of the lower door 70. When the connector storage part CM is disposed at the lower end portion of the lower door 70, the fabricator may access the connector module 200 through the lower portion of the lower door 70. When the connector storage part CM is disposed at the lower end portion of the lower door 70, the connector module 200 may be prevented from being exposed outward normally. Furthermore, as described below, the connector inlet 73a of the connector storage part CM is open through the lower end portion of the lower door 70, so the fabricator can easily access the connector module 200.

As another example, the connector storage part CM may be disposed close to an upper end portion of a side surface of the lower door 70. Furthermore, the connector inlet 73a of the connector storage part CM may be open through the side surface of the lower door 70.

FIG. 7 illustrates the connector module 200 disposed in the connector storage part CM. Herein, the view illustrates the relative connector 290 separated from the door connector 270 of the connector module 200. The door connector 270 may be disposed at a lower end portion of the connector storage part CM. Accordingly, the relative connector 290 may be easily assembled to and separated from the door connector 270.

As illustrated in FIG. 7, the connector storage part CM may be disposed outside the window V Accordingly, the connector storage part CM and the connector module 200 disposed in the connector storage part CM may not be exposed outward, or the exposed region may be minimized.

In FIG. 12, reference numeral 20 indicates a side frame 20 supporting a lower end of the main body 10. The side frame 20 may include a wire tube 23 guiding a mounting direction of the main wire W 1. The main wire W1 may be disposed at a side surface of a lower portion of the main body 10 along the wire tube 23. Reference numeral 25 is a support leg to adjust the height of the main body 10.

FIG. 8 illustrates a process in which the door connector 270 disposed in the connector storage part CM is assembled with the relative connector 290. First, the door connector 270 may be moved to the operation position in the connector storage part CM. FIG. 8A illustrates the door connector 270 disposed at the operation position. Then, the relative connector 290 may be assembled to the door connector 270.

Herein, the door connector 270 is fixed to the operation position as described below, so the fabricator can prevent from separately gripping the door connector 270 when the fabricator assembles the relative connector 290 to the door connector 270. When the assembly of the door connector 270 and the relative connector 290 (hereinbelow, which will be referred to as a connector assembly C) are inserted into the connector storage part CM (upper side based on FIG. 7), the connector assembly C may be moved to the storage position. This state is illustrated in FIG. 8B.

For reference, the storage position is a position where the connector assembly C is moved to the inside part of the connector storage part CM not to be exposed outward. Furthermore, the operation position is a position where the door connector 270 is moved to the connector inlet 73a of the connector storage part CM to be assembled to/separated from the relative connector 290 and the assembly surface 271a of the door connector 270 is exposed outward. Herein, the storage position may be a first position, and the operation position may be a second position.

FIG. 9 illustrates the rear surface of the lower door 70. As illustrated in the drawing, the connector module 200 may be disposed in the lower portion of the side surface of the lower door 70. One end of the connector module 200 may be disposed in the lower end portion of the lower door 70. The connector module 200 may be disposed vertically, i.e., in the height direction of the lower door 70.

The lower frame part 73 may be provided at the lower end of the lower door 70. The connector inlet 73a of the connector storage part CM may be open in the lower frame part 73. As illustrated in FIG. 9, the connector inlet 73a may be formed by vertically penetrating the lower frame part 73. The connector inlet 73a may be a part of air inlets I, i.e., a plurality of inlets of the cooling flow path A1 which are open in the lower frame part 73. Reference numeral 73b indicates a bracket provided in the lower frame part 73 to mount the air guide G. Furthermore, reference numeral 190 is a lighting cover to cover each lighting device 180.

The connector module 200 may include the door connector 270. The door connector 270 may be connected to a first end portion of the door wire W2. The first end portion of the door wire W2 may be coupled to the door connector 270, and a second end portion may be connected to the image acquisition module 100. FIG. 6 illustrates the second end portion of the door wire W2 connected to the image sensing device 170 of the image acquisition module 100. As another example, the second end portion of the door wire W2 may be connected to each lighting device 180. As another example, the second end portion of the door wire W2 may be connected to another electronic compartment such as the display device, etc.

The door connector 270 may be disposed in the connector storage part CM. The door connector 270 may be moved between the first position and the second position in the connector storage part CM. The first position may be the storage position. The second position may be the operation position. For reference, FIG. 9 illustrates the door connector 270 disposed at the storage position.

In the embodiment of the present disclosure, the door connector 270 is mounted to a movement supporter 250 and moved with the movement supporter 250. The movement supporter 250 may be mounted to the connector storage part CM. Herein, the movement supporter 250 may be moved along a mounting base 210 disposed in the connector storage part CM. As another example, the movement supporter 250 is omitted, and the door connector 270 may be directly disposed in the mounting base 210. The structures of the movement supporter 250 and the mounting base 210 will be described below.

FIG. 10 illustrates the connector storage part CM provided at the lower portion of the lower door 70. The connector storage part CM may be provided around a lower inlet of the cooling flow path A1. The door connector 270 may be disposed in the connector storage part CM. To move the door connector 270, there is a need to access the connector storage part CM. To this end, the connector inlet 73a may be open in the lower portion of the lower door 70.

Herein, the width of the connector inlet 73a may be larger than the thickness of the door connector 270. Herein, the width of the connector inlet 73a is based on the transverse direction of the lower door 70 and may be the transverse width based on FIG. 10. The thickness of the door connector 270 is based on the longitudinal direction of the lower door 70. When the width of the connector inlet 73a is larger than the thickness of the door connector 270, the connector inlet 73a may have a clearance. The clearance may be an operation space F. FIG. 10 illustrates the width of the operation space F. The fabricator may access the door connector 270 through the operation space F.

The operation space F may be formed between a surface of the door connector 270 and an edge of the connector inlet 73a. The operation space F may be an empty space between the surface of the door connector 270 and the inner frame part 90. The operation space F may be a space through which the fabricator can access the door connector 270 and an air inlet through which external air is introduced into the lower door 70 at the same time.

FIG. 11 illustrates an embodiment of the connector module 200. The connector module 200 may be disposed between the main wire W1 and the door wire W2. More specifically, the relative connector 290 to which the main wire W1 is connected may be connected to the door connector 270 to which the door wire W2 is connected, in the connector module 200. FIG. 11 illustrates the door wire W2 and the main wire W1 electrically connected to each other with the door connector 270 and the relative connector 290 assembled.

For convenience of description, describing the door connector 270 of the connector module 200 with reference to FIG. 20, the door connector 270 may have roughly a hexahedral structure. The door connector 270 may include a connector body 271 of an insulator in which a plurality of terminals (not illustrated) is disposed. Terminal wires 278 may be connected to the terminals. The terminal wires 278 may constitute the door wire W2. FIGS. 22 and 29 illustrate terminal holes 272 into which the terminals are inserted.

An assembly surface 271a may be provided on a front surface of the door connector 270. The assembly surface 271a may be a surface facing the connector inlet 73a. The assembly surface 271a may be a portion assembled with the relative connector 290.

A structure may be disposed on the surface of the door connector 270 to fix the door connector 270 to the movement supporter 250. Specifically, a connector lance part 275 may protrude on a surface of the door connector 270. The connector lance part 275 may pass through a mounting hole 264 provided in the movement supporter 250 and may be fixed by being caught by the opposite side of the mounting hole 264. Then, the door connector 270 is prevented from being separated in the opposite direction, i.e., an upward direction based on FIG. 20.

A connector protrusion 276 may be provided on a surface of the door connector 270. The connector protrusion 276 may fix the door connector 270 to the movement supporter 250. The connector protrusion 276 may be caught by a holding end portion 264a (referring to FIG. 19) provided at an edge of the mounting hole 264. When the connector protrusion 276 is caught by the holding end portion 264a, the door connector 270 is no longer moved in the mounting direction, i.e., in a downward direction based on FIG. 20. Eventually, the door connector 270 may be fixed in the opposite directions.

The connector module 200 may include the mounting base 210. The mounting base 210 may be fixed to the connector storage part CM. The mounting base 210 may guide the movement of the movement supporter 250 and the movement of the door connector 270. Since the mounting base 210 is fixed, the mounting base 210 may be moved relatively to the movement supporter 250 and the door connector 270. FIG. 11 illustrates the door connector 270 disposed at the storage position.

The mounting base 210 may guide the movement of the movement supporter 250 and the movement of the door connector 270. The mounting base 210 is fixed to the connector storage part CM, thereby preventing the movement supporter 250 and the door connector 270 from also being separated from the connector storage part CM. The mounting base 210 may guide an extension direction of the door wire W2 as described below.

Describing the mounting direction of the mounting base 210, as illustrated in FIG. 12, a rear surface of the mounting base 210 may face the front space of the lower door 70. When viewed from the front space of the lower door 70, the movement supporter 250 and the door connector 270 disposed on the front surface of the mounting base 210 may be covered by the mounting base 210. Of course, since the connector module 200 including the mounting base 210 is disposed outside the window V, the connector module 200 may be covered by an edge portion of the lower door 70.

As another example, the mounting base 210 may cross a portion of the window V, but a lower surface of the mounting base 210 has a flat surface structure, and the mounting base 210 may cover both the door connector 270 and the movement supporter 250, so the mounting base 210 may be partially exposed to external space (front space of the lower door 70).

The door wire W2 may extend upward of the mounting base 210. The main wire W1 may extend downward of the mounting base 210. The mounting base 210 is disposed closer to the wire tube 23 provided in the side frame 20, so an exposure area of the main wire W1 may be reduced.

Referring to FIG. 13, the movement supporter 250 and the door connector 270 may be separated from the mounting base 210. When the movement supporter 250 is mounted to the mounting base 210, the movement supporter 250 may be linearly moved along the mounting base 210. The movement supporter 250 may be separated from the mounting base 210 or assembled with the mounting base 210 only at a specific position. This structure will be described below.

FIG. 14 illustrates the movement supporter 250 mounted to the mounting base 210. For reference, FIG. 14 illustrates the movement supporter 250 in the operation position. As illustrated in the drawing, a vertical height of the mounting base 210 in a movement direction of the movement supporter 250 may be formed wider than a transverse width perpendicular to the vertical height. The transverse width of the mounting base 210 may be formed smaller than or equal to the width of the installation region T1 to T4. Accordingly, the mounting base 210 may not be separated from the installation region T1 to T4.

FIG. 15 illustrates the assembly of the movement supporter 250 and the door connector 270, the assembly being mounted to the mounting base 210. FIG. 15 illustrates the structure of the connector module 200 based on a direction from the inside part of the storage space 41 toward the lower door 70. As described above, the mounting base 210 does not completely cover the movement supporter 250 and the door connector 270, but may expose the movement supporter 250 and the door connector 270. However, the connector module 200 is disposed in the connector storage part CM provided in the door, thereby being prevented from being visible from the outside space.

FIG. 16 illustrates the connector module 200 illustrated in FIG. 15 with the relative connector 290 assembled. In FIG. 16, the door connector 270 and the relative connector 290 are in the operation position. In the operation position, the door connector 270 may be assembled with or separated from the relative connector 290. When the relative connector 290 is pushed upward from the state illustrated in FIG. 16, the door connector 270 and the movement supporter 250 may be moved with the relative connector 290. Then, the door connector 270, the relative connector 290, and the movement supporter 250 may be moved to the storage position.

Herein, the door connector 270 may be moved in a constant section with the movement supporter 250. As described below, a mounting stopper 229 provided in the mounting base 210 may interfere with a stopping holder 259 of the movement supporter 250 to limit a movement range of the movement supporter 250. More specifically, the mounting stopper 229 may limit the depths at which the movement supporter 250 and the door connector 270 are inserted.

The mounting base 210 may include a restraint maintaining part 230 provided at the opposite side of the mounting stopper 229. When the movement supporter 250 and the door connector 270 are moved to the operation position, the restraint maintaining part 230 may enable the movement supporter 250 and the door connector 270 to be fixed without being separated from the operation position. A detailed structure of the restraint maintaining part 230 will be described below again.

As illustrated in FIG. 16, a part of the door connector 270 disposed in the operation position may protrude outside the connector inlet 73a. In the drawing, CH1 indicates the entire length of the connector assembly C. The sum of the length of a part of the door connector 270 protruding outside the connector inlet 73a and the length of the relative connector 290 is indicated as CH2.

Herein, the sum CH1 of the length of the door connector 270 and the length of the relative connector 290 may be smaller than or equal to a distance X1 from a lower end of the mounting base 210, i.e. the operation position, to the mounting stopper 229. Accordingly, the entire connector assembly C may be completely seated on the mounting station 220. The distance X1 from the lower end of the mounting base 210 to the mounting stopper 229 may be longer than the length of the movement supporter 250.

The sum CH2 of the length of the part of the door connector 270 protruding outward of the connector inlet 73a and the length of the relative connector 290 may be shorter than or equal to a movement range X2 of the door connector 270. Then, when the connector assembly C is moved to the storage position, the relative connector 290 is also moved to the storage position to prevent the entire connector assembly C from being exposed outward. In other words, when the connector assembly C is moved to the storage position, the relative connector 290 is also moved to the storage position so that the entire connector assembly C may be disposed above the lower end of the mounting base 210.

FIG. 17 illustrates the connector assembly C and the movement supporter 250 in the storage position. As illustrated in the drawing, a lower end of the relative connector 290 may be disposed above the lower end of the mounting base 210. Therefore, the relative connector 290 may be prevented from protruding outward of the connector inlet 73a. On the other hand, the movement supporter 250 is no longer moved in the upward direction based on FIG. 17, due to interference with the mounting stopper 229.

The structure of the mounting base 210 will be described in detail with reference to FIG. 18. A frame of the mounting base 210 may be formed of a base body 211 of a flat plate structure. The mounting station 220 may be disposed on a first surface of the base body 211. A second surface 211' of the base body 211 (referring to FIG. 13) may be brought into close contact with a surface of the front panel. For example, the second surface 211' of the base body 211 may adhere to the surface of the front panel as a fixation surface. As another example, the base body 211 may be fixed to the door frame 72, 77, 80, 90, not a surface of the front panel.

A guide fence 212 may be provided at either side of the base body 211. The guide fence 212 may stand outside the mounting station 220. The guide fence 212 may be provided in a movement direction of the door connector 270 outside the mounting station 220. In the embodiment, the guide fence 212 is provided at either side of the mounting station 220. As another example, the guide fence 212 may be provided only on either side of the mounting station 220 or may be omitted.

The guide fence 212 may form a movement path of the movement supporter 250 and the door connector 270 with an inner fence 222 described below. The guide fence 212 and the inner fence 222 may guide the movement of the movement supporter 250 and the door connector 270. The inner fence 222 may be adjacent to the mounting station 220 and provided along a side surface of the mounting station 220. The inner fence 222 may be a part of the guide fence 212.

The base body 211 may include a wire guide 213. The wire guide 213 may guide a direction in which the door wire W2 extends. The wire guide 213 may protrude from the base body 211. The wire guide 213 may be disposed between the image acquisition module 100 and the door connector 270. The wire guide 213 covers the door wire W2 so that the door wire W2 extends in a preset direction. In the embodiment, since the door connector 270 is moved, a relative distance between the door connector 270 and the fixed wire guide 213 may change.

The base body 211 may include a plurality of wire guides 213. The plurality of wire guides 213 may be provided in an extension direction of the door wire W2. In the embodiment, the plurality of wire guides 213 may include a first guide 214 and a second guide 215.

The first guide 214 may be disposed at an edge of the mounting station 220. The second guide 215 may deviate from the mounting station 220 and be disposed outside the mounting station 220. The door wire W2 may extend toward the image acquisition module 100 while passing through the first guide 214 and the second guide 215 in order.

The first guide 214 and the second guide 215 may be disposed to be offset from each other based on the movement direction of the door connector 270. The first guide 214 may be disposed on a position passing through a central portion of the door connector 270. The second guide 215 may be provided on a position deviating from the center of the door connector 270 and biasing to a side surface of the base body 211, more specifically, to an edge of the door body. The first guide 214 and the second guide 215 may be disposed to be transversely spaced apart from each other based on a transverse width direction of the door body. Accordingly, the second guide 215 may guide the extension direction of the door wire W2 in a direction far away from the window.

The first guide 214 may have a structure of a pair of facing cantilevers. A first guide hole 214a surrounding the door wire W2 may be formed between the pair of cantilevers. As another example, the first guide 214 may have a single hook structure. In the embodiment, the first guide 214 is integrated with the base body 211. As another example, the first guide 214 may be formed into a separate object from the base body 211 and then fixed to the base body 211.

The second guide 215 may protrude roughly into a "U" shape. A second guide hole 215a surrounding the door wire W2 may be formed in the second guide 215. As another example, the second guide 215 may have a structure of a pair of cantilevers like the first guide 214. In the embodiment, the second guide 215 is integrated with the base body 211. As another example, the second guide 215 may be formed into a separate obj ect from the base body 211 and then fixed to the base body 211. The structure of the wire guide 213 will be described again with a wire fixation part 254 described below.

Herein, a wire insertion port (not assigned with reference numeral) into which the door wire W2 is inserted may be provided at one side portion of the second guide 215. The wire insertion port may be open in a direction toward the edge of the door body. Accordingly, the door wire W2 inserted into the wire insertion port may be separated only in the edge direction of the door body, and not be separated in a direction toward the window V

The first guide hole 214a and the second guide hole 215a may be open in different directions. The first guide hole 214a may be open in the movement direction of the movement supporter 250. The second guide hole 215a may be open in a direction different from the movement direction of the movement supporter 250. In the embodiment, the second guide hole 215a is open in a direction biasing toward the edge of the door body.

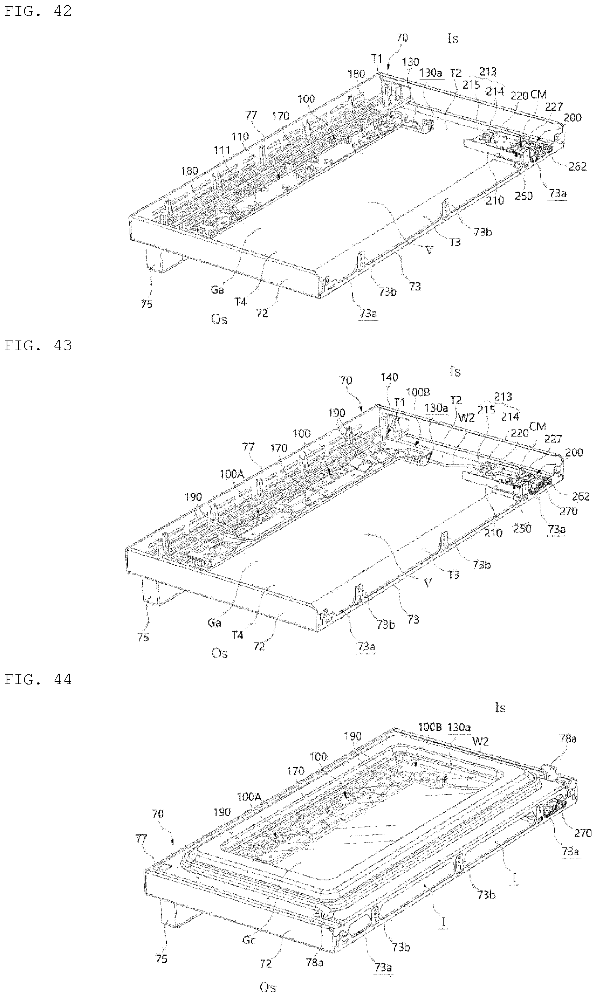

Meanwhile, referring to FIG. 43, the connection unit 130 may a connection hole 130a open in a direction toward the connector module 200. The door wire W2 may extend from the wire guide 213 toward the connection hole 130a. The door wire W2 may be guided by the wire guide 213 and face the connection unit 130 without biasing in a direction toward the window V or the opposite direction, i.e., a direction toward the side surface of the door body.

A seating surface 221 may be formed on a surface of the mounting station 220. The seating surface 221 may be a surface on which the movement supporter 250 slides on the surface of the mounting station 220. Since the mounting station 220 is a protruding portion of the base body 211, the seating surface 221 may be formed higher than other portions of the base body 211.

The seating surface 221 may include a supporter guide groove 223. The supporter guide groove 223 may be recessed from the seating surface 221. The supporter guide groove 223 may guide sliding of the movement supporter 250. A guide block 253a of the movement supporter 250 (referring to FIG. 22) may be inserted into the supporter guide groove 223 and the guide block 253a will be described below. While the guide block 253a is inserted into the supporter guide groove 223, the movement supporter 250 may be moved. Therefore, the supporter guide groove 223 may guide the movement of the movement supporter 250 in a constant direction. As another example, the supporter guide groove 223 may be omitted.

The seating surface 221 may include a guide slot 225. The guide slot 225 may be formed longitudinally through the seating surface 221. The guide slot 225 may be provided at either side of the supporter guide groove 223 with the supporter guide groove 223 as the center. A guide arm 255 of the movement supporter 250 may be inserted into each guide slot 225, and the guide arm 255 will be described below. While the guide arm 255 is inserted into the guide slot 225, the movement supporter 250 may slide on the seating surface 221. Therefore, the guide arm 255 may guide the movement of the movement supporter 250 in a constant direction with the supporter guide groove 223. As another example, one guide slot 225 and one guide arm 255 may be provided.

Herein, a direction in which the guide arm 255 is inserted into the guide slot 225 may be a first direction. A direction in which the guide arm 255 guides the movement of the movement supporter 250 with the supporter guide groove 223 may be a second direction. Herein, the first direction and the second direction may be different from each other. For example, the first direction and the second direction may be perpendicular to each other. As another example, the first direction may oppose the second direction.

The guide slot 225 may include a slot entrance 225a. The slot entrance 225a may be a portion where the width of the guide slot 225 is widened. A guide head 255a of the guide arm 255 may be inserted into the slot entrance 225a. The guide head 255a may have a thicker portion than other portions of the guide arm 255. Therefore, after the guide head 255a is inserted into the slot entrance 225a, when the movement supporter 250 is moved from the slot entrance 225a, the guide head 255a is caught by the guide slot 225 not to be separated.

Referring to FIGS. 24 and 36, the guide head 255a and an edge of the guide slot 225 are spaced apart from each other, so a spacing may be provided therebetween. The spacing may prevent the guide head 255a from interfering with the edge of the guide slot 225 when the entire movement supporter 250 is turned. The movement supporter 250 may be relatively turned in a direction of reducing the spacing with respect to the mounting base 210.

A first position fixation part 227 may be provided at either side of the seating surface 221. The first position fixation part 227 may constitute a storage fixation part 227, 257 with a second position fixation part 257 described below. The first position fixation part 227 may interfere with the movement supporter 250 to fix the movement supporter 250 and the connector assembly C to the storage position. When the movement supporter 250 and the connector assembly C are fixed to the storage position by the storage fixation part 227, 257, the movement supporter 250 and the connector assembly C are not returned to the operation position, and may remain fixed to the connector storage part CM.

The storage fixation part 227, 257 may be continuously or discontinuously disposed in the movement direction of the door connector 270. When the storage fixation part 227, 257 is continuously provided in the movement direction of the door connector 270, the movement supporter 250 and the connector assembly C may be fixed to a plurality of storage positions in phases. When the storage fixation part 227, 257 is discontinuously provided in the movement direction of the door connector 270, the movement supporter 250 and the connector assembly C may be fixed to a limited specific storage position.

The storage fixation part 227, 257 may include the first position fixation part 227 and the second position fixation part 257. The first position fixation part 227 may be provided in the mounting base 210 of the connector module 200. The second position fixation part 257 may be provided in the movement supporter 250 or the door connector 270. The second position fixation part 257 may be engaged with the first position fixation part 227. When the second position fixation part 257 is engaged with the first position fixation part 227, the second position fixation part 257 may remain caught by and fixed to the first position fixation part 227.

Referring to FIG. 17, the first position fixation part 227 may be continuously provided along the guide fence 212. The first position fixation part 227 may have an uneven structure. The first position fixation part 227 may be configured by repeatedly arranging a structure protruding in a central direction of the seating surface 221, i.e., a central direction of the movement supporter 250, and a structure recessed in the opposite direction. For example, the first position fixation part 227 may have a sawtooth structure. The first position fixation part 227 of the sawtooth structure may form a kind of multistep structure. The second position fixation part 257 may be fixed to a portion of a plurality of positions of the first position fixation part 227 of the multistep structure. Accordingly, the movement supporter 250 may have a plurality of storage positions. In other words, in the embodiment, the storage fixation part 227, 257 may have a kind of a free stop structure.

The storage fixation part 227, 257 may include a pair of first position fixation parts 227. The pair of first position fixation parts 227 may be disposed to face each other. The pair of first position fixation parts 227 may be engaged with a pair of second position fixation parts 257 provided in the movement supporter 250.

Referring to FIG. 18, each first position fixation part 227 may include a storage locking end 227a.

The storage locking end 227a may be disposed at the innermost portion in the storage position. In the embodiment, based on the drawing, the storage locking end 227a may be disposed at the uppermost end of the first position fixation part 227. When the second position fixation part 257 is caught by the storage locking end 227a, the movement supporter 250 and the connector assembly C may be stored in the deepest position in the connector storage part CM. This figure as described above is illustrated in FIG. 17.

The storage locking end 227a may further protrude than other portions of the first position fixation part 227. When a protruding length of the storage locking end 227a is relatively longer than other portions, the movement supporter 250 disposed at the uppermost storage position may be prevented from deviating from the first position fixation part 227 when being moved to the operation position. When the movement supporter 250 disposed at the storage position in the uppermost end is pulled and moved, the greatest force is generated. Herein, the second position fixation part 257 of the movement supporter 250 may deviate from the first position fixation part 227. However, in the embodiment, the storage locking end 227a extends long, so the second position fixation part 257 may stay in the storage locking end 227a even when deviating.

The storage locking end 227a may be provided on a first end portion of the first position fixation part 227. A distance from the storage locking end 227a to a second end portion of the first position fixation part 227 may be the entire length of the first position fixation part 227. The entire length of the first position fixation part 227 may be longer or equal to the movement distance of the movement supporter 250 and the connector assembly C. Accordingly, in the process in which the movement supporter 250 and the connector assembly C are moved, the second position fixation part 257 may be continuously engaged with the first position fixation part 227.

In the embodiment, the second position fixation part 257 has an elastic deformable structure. Therefore, the second position fixation part 257 may be elastically deformed in the process in which the second position fixation part 257 is engaged with the first position fixation part 227. As another example, the first position fixation part 227 may have an elastic deformable structure. The first position fixation part 227 has a cantilever structure, and the movement supporter 250 may be moved with the second position fixation part 257 elastically deforming the first position fixation part 227.

As another example, the storage fixation part 227, 257 may have a structure in which the movement supporter 250 is press-fitted into the mounting base 210, not the elastic deformation structure. As another example, the movement supporter 250 may be assembled to the storage fixation part 227, 257 to be turned, or have a latch structure. Otherwise, the movement supporter 250 may be fixed to the mounting base 210 through a separate fastener.

The mounting station 220 may include the mounting stopper 229. The mounting stopper 229 may interfere with the movement supporter 250 to limit the movement range of the movement supporter 250. The mounting stopper 229 may be provided with a cantilever structure in the mounting station 220. The mounting stopper 229 may have a cylindrical shape. The mounting stopper 229 may be disposed between the first guide 214 and the guide slot 225.

The mounting stopper 229 may interfere with the stopping holder 259 of the movement supporter 250. When the stopping holder 259 is brought into contact with the mounting stopper 229, the movement supporter 250 can no longer be moved. The figure as described above is illustrated in FIG. 17. The stopping holder 259 may be caught in a shape covering a surface of the mounting stopper 229. In the embodiment, a pair of mounting stoppers 229 may be provided. As another example, the mounting stopper 229 may include one mounting stopper or three or more mounting stoppers.

The mounting base 210 may include the restraint maintaining part 230 at the opposite side of the mounting stopper 229. The restraint maintaining part 230 may enable the movement supporter 250 and the door connector 270 to remain fixed to the operation position. The restraint maintaining part 230 may fix the movement supporter 250 fixed to the operation position, and prevent the movement supporter 250 from being moved toward the storage position. Adetailed structure of the restraint maintaining part 230 will be described below again.

The movement supporter 250 will be described with reference to FIGS. 19 and 20. The door connector 270 may be mounted to the movement supporter 250. The door connector 270 may be moved along the mounting station 220 with the movement supporter 250. The movement supporter 250 may be moved between the storage position and the operation position. The movement supporter 250 may remain fixed to the storage position and the operation position respectively.

A plurality of surfaces of the movement supporter 250 may be brought into close contact with a plurality of different surfaces of the mounting base 210. Then, the movement supporter 250 may be linearly moved while being stably seated on the mounting base 210. In the embodiment, the movement supporter 250 may maintain a state in close contact with the mounting base 210 at a lower surface, i.e., a surface facing the mounting station 220, and both side surfaces facing the first position fixation part 227. Accordingly, the movement supporter 250 may be operated while being supported by the mounting base 210 in at least three different portions.

A frame of the movement supporter 250 may be formed of a supporter body 251. The supporter body 251 may have a flat plate structure. A first surface of the supporter body 251 may be a supporting board 253 on which the door connector 270 is seated. A second surface of the supporter body 251 may be brought into close contact with the seating surface 221 of the mounting base 210. The entire length of the supporter body 251 (a vertical length based on the drawing) may be shorter than or equal to the length of the mounting station 220.

The supporter body 251 may include a supporter fence 252. The supporter fence 252 may protrude while surrounding an edge of the supporter body 251. The supporter fence 252 may form a connector mounting space on one surface of the supporter body 251. An upper fence 252' may be provided on an upper end of the supporter body 251. The upper fence 252' may protrude more than the supporter fence 252.

The supporter body 251 may include the supporting board 253. The supporting board 253 may be disposed in a central portion of the surface of the supporter body 251. The door connector 270 may be seated on the supporting board 253. In the mounting process of the door connector 270, the door connector 270 may be assembled to a connector holder 262 while sliding on the supporting board 253.

The guide block 253a may be disposed in the supporting board 253. The guide block 253a may be recessed suitable to the shape of the door connector 270. On the other hand, the guide block 253a may protrude on a second surface of the supporting board 253. While the guide block 253a is inserted into the supporter guide groove 223, the movement supporter 250 may be moved. When the door connector 270 is mounted to the supporter body 251, the guide block 253a may guide the movement of the door connector 270.

Herein, the vertical length of the supporting board 253 may be longer than the vertical length of the door connector 270. Herein, the vertical length may be equal to the movement direction of the movement supporter 250. The door connector 270 may slide downward while being seated on an upper portion of the supporting board 253 to be mounted to the connector holder 262 described below. Therefore, the length of the supporting board 253 is preferably longer than the length of the door connector 270.

The supporter body 251 may include the wire fixation part 254. The wire fixation part 254 may guide a direction in which the door wire W2 connected to the door connector 270 extends. The wire fixation part 254 may have a kind of clip structure. The wire fixation part 254 may have a clip structure to fix the door wire W2 while covering both side portions thereof. In the embodiment, the wire fixation part 254 may be provided in a central portion of the upper fence 252'. A wire fixation hole 254a is open in a central portion of the wire fixation part 254, so the door wire W2 may pass through the wire fixation hole.

The wire fixation part 254 may be disposed on a vertical line Y1 same as the first guide 214. FIG. 15 illustrates the wire fixation part 254 disposed on the extension line Y1 same as the first guide 214. The wire fixation part 254 and the second guide 215 are not disposed on the same extension line Y1. Accordingly, the door wire W2 may extend vertically, i.e., in the movement direction of the movement supporter 250 and the door connector 270, while passing through the wire fixation part 254 to the first guide 214.

A first portion W2a of the door wire W2 that passes through the first guide 214 may pass through the second guide 215 and deviate from the extension line Y1 to be guided in a direction of an extension line Y2 biasing to one side. For reference, FIG. 24 illustrates the wire fixation hole 254a of the wire fixation part 254 and the first guide hole 214a of the first guide 214 aligned concentrically. In the embodiment, the imaginary extension line Y1 between the wire fixation part 250 and the first guide 214 and the imaginary second extension line Y2 connecting the first guide 214 to the second guide 215 may form an acute angle therebetween.

In the embodiment, since the movement supporter 250 is moved, a distance between the wire fixation part 254 and the wire guide 213 may change. As described above, when the relative distance between the wire fixation part 254 and the wire guide 213 changes, a part of the door wire W2 may be bent.

Comparing FIGS. 25 and 27, when the movement supporter 250 and the door connector 270 are located in the storage position (FIG. 25), the door wire W may be pushed toward the image acquisition module 100 (an upward direction based on the drawing) to be partially bent. Herein, a part of the door wire W2 between the first guide 214 and the second guide 215 may be referred to as the first portion W2a, and a part of the door wire W2 that passes through the second guide 215 may be referred to as a second portion W2b.

As illustrated in FIG. 25, when the door wire W is pushed toward the image acquisition module 100 (upward direction based on the drawing), a part that passes through the second portion W2b may be naturally bent, and the portion may be referred to as a third portion W2c. The extension direction of the door wire W to the second portion W2b may be fixed by the second guide 215. The second guide 215 may induce the second portion W2b in a direction far away from the window V, i.e., toward the edge of the door body. Therefore, even when the third portion W2c is bent, the door wire does not cross the window V

On the other hand, as illustrated in FIG. 27, when the movement supporter 250 is moved to the operation position, the door wire W is unfolded and recovered from the bent state of the third portion W2c. Eventually, the second guide 215 may induce the portion where the bending of the door wire W starts to be moved as far away from the window V as possible.

The supporter body 251 may include the guide arm 255. The guide arm 255 may protrude from the surface of the supporter body 251 toward the seating surface 221 of the mounting base 210. The guide arm 255 may be inserted into the guide slot 225. When the guide arm 255 passes through the guide slot 225, the guide arm 255 is prevented from being separated from the mounting base 210. The guide arm 255 is moved along the guide slot 225, so the movement of the guide arm may be guided by the guide slot 225.

Referring to FIG. 21, one end of the guide arm 255 may include the guide head 255a. The guide head 255a may prevent the guide arm 255 from being removed from the guide slot 225. The guide head 255a may pass through the guide slot 225 through the slot entrance 225a of the guide slot 225. Since the thickness of the guide head 255a is thicker than other portions of the guide arm 255, when the guide arm 255 is moved along the guide slot 225 after passing through the slot entrance 225a, the guide arm 255 is prevented from being removed from the guide slot 225.

Referring to FIGS. 19 and 20, the supporter body 251 may include the second position fixation part 257. The second position fixation part 257 may be caught by the first position fixation part 227, thereby fixing a position of the movement supporter 250. The second position fixation part 257 may extend into a cantilever shape from the supporter body 251. The second position fixation part 257 may be an elastic fixation arm having a cantilever shape in which a first end portion is a fixation end fixed on the surface of the supporter body 251 and a second end portion is a free end. Accordingly, the second position fixation part 257 may be elastically deformed in the interference process with the first position fixation part 227. For the elastic deformation, the free end of the second position fixation part 257 may have a spreading form spaced apart from the surface of the supporter body 251. In the embodiment, the second position fixation part 257 may be provided into a cantilever shape on either side surface of the supporter body 251.

One end of the second position fixation part 257 may include a fixation end portion 257a. The fixation end portion 257a may be a portion relatively thicker than other portions in the second position fixation part 257. The fixation end portion 257a may be fixed by being caught by the first position fixation part 227 of the uneven shape. The fixation end portion 257a may have a shape engaged with the gear shape structure of the first position fixation part 227.

The movement supporter 250 may include the stopping holder 259. The stopping holder 259 may interfere with the mounting stopper 229 provided on the mounting base 210, thereby limiting the movement range of the movement supporter 250. The stopping holder 259 may be provided on the upper end of the supporter body 251. More precisely, the stopping holder 259 may protrude upward from a surface of the upper fence. The stopping holder 259 may have a shape generally resembling a clip. In the embodiment, the movement supporter 250 may include the stopping holder 259 on either portion of the wire fixation part 254 with the wire fixation part 254 as the center. As another example, only one stopping holder 259 may be provided, or the stopping holder 259 may be omitted. When the stopping holder 259 is omitted, the surface of the movement supporter 250 may directly interfere with the mounting stopper 229.

The stopping groove (not assigned with reference numeral) may be formed inside the stopping holder 259. Apart of an upper end of the stopping groove may be open. The mounting stopper 229 may be inserted through the open portion. The stopping groove may cover the surface of the mounting stopper 229 provided on the mounting base 210. Accordingly, the mounting stopper 229 may limit the depth at which the movement supporter 250 and the door connector 270 are inserted.

The movement supporter 250 may include a supporter restraint arm 260. The supporter restraint arm 260 may protrude from the movement supporter 250. The supporter restraint arm 260 may have a cantilever structure in which a first end portion is a fixation end portion fixed to a side surface of the supporter body 251 and a second end portion is a free end portion. Therefore, the supporter restraint arm 260 may be elastically deformed. Herein, for the elastic deformation, the free end portion of the supporter restraint arm 260 may have a spreading structure spaced apart from the side surface of the movement supporter 250. The supporter restraint arm 260 may be fixed to the restraint maintaining part 230 of the mounting base 210. When the supporter restraint arm 260 is fixed to the restraint maintaining part 230, the movement supporter 250 and the connector assembly C may remain fixed to the operation position.

Reference numeral 260a is a restraint head 260a provided at the supporter restraint arm 260. The restraint head 260a may be a portion substantially caught by the restraint maintaining part 230 and fixed. The supporter restraint arm 260 including the restraint head 260a may have a kind of hook structure.

Referring to FIG. 17, a distance of the supporter restraint arm 260 protruding from the side surface of the movement supporter 250 may be shorter than the second position fixation part 257. In other words, the second position fixation part 257 may protrude in a direction further spreading from the side surface of the movement supporter 250 than the supporter restraint arm 260. Then, the supporter restraint arm 260 may be prevented from interfering with the first position fixation part 227 in the movement process of the movement supporter 250.

The movement supporter 250 may include the connector holder 262. The connector holder 262 may fix the door connector 270 to the movement supporter 250. In other words, the connector holder 262 may enable the movement supporter 250 to transfer the door connector 270. The connector holder 262 may be provided below the supporting board 253. The connector holder 262 may have roughly a kind of rectangular frame structure surrounding a surface of the door connector 270. The mounting hole 264 is provided in a central portion of the connector holder 262, and the door connector 270 may be disposed in the mounting hole 264.

The connector holder 262 may include a connector support end 263. The connector support end 263 may make the mounting hole 264 with the connector holder 262. The connector support end 263 may be disposed below the guide block 253a. When the connector holder 262 surrounds a first surface and both side surfaces of the door connector 270, the connector support end 263 may support a second surface of the door connector 270. Reference numeral 263a indicates a support end recessed part that is recessed to match the shape of the door connector 270.

Referring to FIG. 20, when the door connector 270 is mounted to the mounting hole 264, the connector lance part 275 of the door connector 270 may pass through the mounting hole 264 and be fixed by being caught by the opposite side portion of the mounting hole 264. Then, the door connector 270 is prevented from being separated in the opposite direction, i.e., an upward direction based on FIG. 20.

An edge portion of the mounting hole 264 may include a holding end portion (referring to FIG. 19). The holding end portion 264a may be a portion by which the connector protrusion 276 of the door connector 270 is caught. When the connector protrusion 276 is caught by the holding end portion 264a, the door connector 270 is no longer moved in the mounting direction, i.e., in a downward direction based on FIG. 20. Eventually, the door connector 270 may be fixed in the opposite directions.

The movement supporter 250 may include an operation lever 265. The operation lever 265 may be a portion fixed by being caught by the restraint maintaining part 230 of the mounting base 210. When the operation lever 265 is caught by the restraint maintaining part 230, the movement supporter 250 is not moved back, i.e., toward the storage position, and may be fixed to the operation position.

The fabricator can operate the operation lever 265 to make the movement supporter 250 into a movable state. When the fabricator lifts the operation lever 265, the entire movement supporter 250 may be turned at a predetermined angle. In the above process, a locked state in which the restraint head 260a of the supporter restraint arm 260 is caught by the restraint maintaining part 230 of the mounting base 210 may be released. For reference, based on the front space of the lower door 70, when the fabricator pushes the operation lever 265 toward the storage space 41, the entire movement supporter 250 may be turned by a predetermined angle. Herein, as described above, the guide head 255a and the edge of the guide slot 225 are spaced apart from each other, so the guide head 255a is prevented from interfering with a bottom surface of the mounting base 210 when the movement supporter 250 is turned.

For convenience of operation, in the embodiment, the movement supporter 250 may include a pair of operation levers 265 protruding from a lower end portion of the movement supporter 250. More specifically, a first end of the pair of operation levers 265 may be connected to the lower end of the movement supporter 250, and a second end thereof may protrude downward, i.e., toward the connector inlet 73a of the connector storage part CM. The operation lever 265 may have a kind of cantilever structure.

The operation lever 265 may include the gripping end 267. The gripping end 267 may have a shape bent from the second end of each operation lever 265. The gripping end 267 may have roughly a "U" shape. Accordingly, the fabricator can easily grip the gripping end 267 and lift the operation lever 265. The process in which the fabricator lifts the operation lever 265 to release the locked state will be described below again.

Referring to FIG. 22, the movement supporter 250 and the connector assembly C may be assembled to the mounting base 210. Herein, the movement supporter 250 and the connector assembly C may be disposed at the storage position. Therefore, not only the movement supporter 250 but also the connector assembly C may not be exposed downward of the connector storage part CM (leftward direction based on the drawing). Herein, the second position fixation part 257 of the movement supporter 250 may be caught by the storage locking end 227a in the first position fixation part 227 of the mounting base 210. Therefore, the movement supporter 250 and the connector assembly C may not be moved in a direction toward the operation position (leftward direction based on the drawing) and remain fixed. Reference numeral 221a indicates a movement space having a shape in which a part of the mounting base 210 is recessed so that the guide head 255a is moved.

Herein, as illustrated in the drawing, the guide head 255a provided in the guide arm 255 of the movement supporter 250 may pass through the guide slot 225 of the mounting base 210. Therefore, the movement supporter 250 and the connector assembly C may be prevented from being separated in a direction (upward direction based on the drawing) perpendicular to the movement direction of the movement supporter 250. Since the movement arm is inserted into the guide slot 225, the movement of the movement supporter 250 may also be guided.

Referring to FIG. 23 without the movement supporter 250 and the connector assembly C, the movement supporter 250 may be moved in the arrow direction. To this end, first, the fabricator can access the connector inlet 73a to lift the gripping end 267 of the operation lever 265. The lifting direction may be a direction (upward direction based on the drawing) perpendicular to the movement direction of the movement supporter 250.

FIG. 24 illustrates the movement supporter 250 fixed to the mounting base 210. As illustrated in the drawing, the guide head 255a of the guide arm 255 is inserted into the guide slot 225. Accordingly, vertical movement (based on the drawing) of the movement supporter 250 is limited. At the same time, the second position fixation part 257 may be caught by the first position fixation part 227. Since either side surface of the movement supporter 250 are surrounded by the guide fence 212, transverse movement (based on the drawing) may also be limited. Eventually, the movement supporter 250 and the connector assembly C may be fixed in all directions at the storage position.

For reference, in FIG. 24, reference numeral 268 indicates a supporter foot provided at the movement supporter 250. The supporter foot 268 may protrude on a lower surface of the movement supporter 250 facing the surface of the mounting base 210. The supporter foot 268 may reduce a contact area between the movement supporter 250 and the mounting station 220, thereby reducing a friction force when the movement supporter 250 is moved. Referring to FIG. 21, the supporter foot 268 may have an elongated structure extending long in a longitudinal direction of the movement supporter 250, i.e., the movement direction of the movement supporter 250.

FIGS. 25 and 26 illustrate the movement supporter 250 and the connector assembly C in the storage position at different angles. As illustrated in the drawings, the movement supporter 250 and the connector assembly C may be spaced apart upward from the lower end of the mounting base 210. The mounting stopper 229 may be caught by the stopping holder 259, so the movement supporter 250 may no longer be moved upward. The second position fixation part 257 may be caught by the storage locking end 227a provided at the first end of the first position fixation part 227. Furthermore, the guide head 255a of the guide arm 255 is in a state of being inserted into the guide slot 225.

In this state, when the movement supporter 250 is moved in the arrow direction, the connector assembly C may also be moved with the movement supporter 250. When the movement supporter 250 starts to be moved from the storage position, the second position fixation part 257 should pass over the storage locking end 227a. When the fabricator pulls the movement supporter 250, the second position fixation part 257 is elastically deformed in a direction toward the surface of the movement supporter 250 and may pass over the storage locking end 227a. Herein, the fabricator can access the movement supporter 250 through the connector inlet 73a (referring to FIG. 10) and pull the operation lever 265.

FIGS. 27 and 28 illustrate the movement supporter 250 and the connector assembly C moved and disposed in the operation position. The movement of the movement supporter 250 and the connector assembly C may be guided by the guide arm 255 inserted in the guide slot 225. In the movement process, the second position fixation part 257 may continuously pass the first position fixation part 227. Herein, the second position fixation part 257 is engaged with the continuous uneven part of the first position fixation part 227, thereby repeating elastic deformation and recovery of an original form.

When the movement supporter 250 and the connector assembly C are moved to the operation position, the entire relative connector 290 and a part of the door connector 270 may be exposed outward of the mounting base 210. The protruding portion may be disposed at the connector inlet 73a so the fabricator can check with the naked eye.

When the movement supporter 250 is moved to the operation position, the movement supporter 250 may be fixed at the operation position. Herein, fixing means a state of the movement supporter 250 not arbitrarily moved by an external force and may be a locked state of the movement supporter 250. When the movement supporter 250 is in the locked state, the connector assembly C may also be in the locked state. Therefore, an operation of assembling or separating the connector assembly C can be easily performed.

Specifically, in the embodiment, the door connector 270 may be mounted to the movement supporter 250 and moved together, so that the door connector 270 can be moved while facing in a constant direction. More specifically, the assembly surface 271a of the door connector 270 may be moved while facing the connector inlet 73a. Accordingly, when the door connector 270 is moved to the operation position, the assembly surface 271a may be exposed outward of the connector inlet 73a, and the assembling/separating operation of the connector can be easily performed.

When the movement supporter 250 is moved to the operation position, the restraint head 260a of the supporter restraint arm 260 may maintain the locked state in which the restraint head 260a is caught by the restraint maintaining part 230 of the mounting base 210. FIG. 29 illustrates the movement supporter 250 and the connector assembly C, the movement supporter 250 and the connector assembly C being moved to the operation position and the assembly surface 271a of the door connector 270 and the operation lever 265 being exposed outward of the mounting base 210. For reference, the relative connector 290 is omitted in FIG. 29.

Herein, the restraint head 260a of the supporter restraint arm 260 is caught by the restraint maintaining part 230 provided on either end of the mounting base 210. Accordingly, the movement supporter 250 may not be returned to the storage position and remain fixed at the operation position. In this state, when the relative connector 290 is assembled to the door connector 270, the door connector 270 maintains the fixed state, and connector assembly can be easily performed.

Referring to FIGS. 30 and 33, the structure in which the restraint head 260a is fixed to the restraint maintaining part 230 will be described. Referring to FIG. 30, the movement supporter 250 and the door connector 270 are disposed at the operation position, and the relative connector 290 may face the door connector 270 to be assembled. In this state, when the relative connector 290 is pushed toward the door connector 270, the two connectors may be assembled. Then, after the locked state is released by lifting the operation lever 265, the movement supporter 250 and the connector assembly C may be moved.

In part A of FIG. 30, the restraint maintaining part 230 is coupled to the restraint head 260a. FIG. 31 illustrates the restraint maintaining part 230 enlarged from part A of FIG. 30. As illustrated in the drawing, the restraint maintaining part 230 may be provided on the lower end of the mounting base 210. The restraint maintaining part 230 may include a locking step 231 and a releasing step 235. When the restraint head 260a of the supporter restraint arm 260 is caught by the locking step 231, the movement supporter 250 may be in the locked state. When the restraint head 260a is caught by the releasing step 235, the movement supporter 250 may be in the released state.

More specifically, the locking step 231 may be disposed below the releasing step 235. The locking step 231 may include a locking surface 232. The locking surface 232 may include a flat surface structure toward the connector inlet 73a. The restraint head 260a is fixed by being substantially caught by the locking surface 232.

The releasing step 235 may be provided above the locking step 231. When the supporter restraint arm 260 is raised, the restraint head 260a faces the releasing step 235. The releasing step 235 may be formed with a width gradually widened in the second direction toward the operation position.

The releasing step 235 may include a releasing surface 236 having an inclined surface or a curved surface. The releasing surface 236 may be formed in a direction of widening the width of the lower end of the mounting base 210. Accordingly, the restraint head 260a may be guided by the releasing surface 236. In this process, the supporter restraint arm 260 may be elastically deformed in a shape closed in a direction toward a side surface of the movement supporter 250.

The restraint maintaining part 230 may include an assembly guide 238. The assembly guide 238 may protrude from a lower end surface of the restraint maintaining part 230. The assembly guide 238 may be formed in a rib shape on the lower end surface of the restraint maintaining part 230. In the embodiment, an end portion 239 of the assembly guide 238 may have a shape partially surrounding the locking surface 232 and the releasing surface 236 and may be formed into a curved path. The assembly guide 238 may have a shape corresponding to the shape of the connector inlet 73a.

The assembly guide 238 may have a spacing between the assembly guide 238 and the operation lever 265. When the fabricator pushes a finger into the spacing, the fabricator can easily lift the operation lever 265. The fabricator can clear a position where the operation lever 265 should be operated, through the assembly guide 238.

FIG. 32 illustrates the restraint head 260a caught by the locking surface 232 of the locking step 231. In this state, the restraint head 260a and the locking surface 232 are brought into surface contact with each other, so that the movement of the restraint head 260a may be limited as the restraint head 260a is caught by the locking surface 232. To release the locked state, the fixation end portion 257a should be separated from the locking surface 232.

As illustrated in FIG. 32, the releasing step 235 may have a transverse width smaller than the locking step 231. Accordingly, a releasing space 237, i.e., a kind of empty space, may be provided between the locking step 231 and the releasing step 235. When the restraint head 260a is located in the releasing space 237, releasing of the movement supporter 250 may start.

FIG. 33 illustrates the restraint head 260a facing the releasing surface 236. In FIG. 32, when the supporter restraint arm 260 is raised in the arrow direction, the restraint head 260a may face the releasing surface 236. Herein, the restraint head 260a and the releasing surface 236 are not in surface contact with each other, and the curved surface or the inclined surface of the releasing surface 236 and the restraint head 260a may be brought into linear contact with each other. Therefore, the restraint head 260a may be guided along the releasing surface 236, and the supporter restraint arm 260 may be elastically deformed in a direction closed inward.

FIGS. 34 and 35 illustrate the connector assembly C mounted to the movement supporter 250. Herein, in FIG. 34, the movement supporter 250 is locked at the operation position, and in FIG. 35 the movement supporter 250 is released at the operation position. In the enlarged view of FIG. 34, the restraint head 260a of the supporter restraint arm 260 is caught by the locking surface 232 of the locking step 231. In this state, the restraint head 260a and the locking surface 232 are brought into surface contact with each other, so that the movement of the restraint head 260a may be limited as the restraint head 260a is caught by the locking surface 232. Herein, the operation lever 265 may be spaced apart from the assembly guide 238.

In this state, when the fabricator lifts the gripping end 267 of the operation lever 265, the restraint head 260a may be released from the state caught by the locking surface 232. The released state is illustrated in the enlarged view of FIG. 35. In FIG. 35, the fabricator lifts the operation lever 265, and the movement supporter 250 and the connector assembly C are entirely turned. When the movement supporter 250 is turned, the restraint head 260a is separated from the locking surface 232 and faces the releasing surface 236.

Herein, the turning direction of the movement supporter 250 may be a third direction that is different from both the first direction in which the movement supporter 250 is mounted to the mounting base 210 and the second direction in which the movement supporter 250 is moved along the mounting base 210.

FIG. 36 illustrates an angle of a in which the movement supporter 250 is turned. The guide head 255a secures an extra length by a predetermined distance with respect to the guide slot 225, so the movement supporter 250 may be turned. As described above, while the movement supporter 250 is turned by the angle of a, the movement supporter 250 may be moved to the storage position. Of course, in the movement process, the second position fixation part 257 may be moved by being continuously engaged with the first position fixation part 227. In the process, the second position fixation part 257 may perform continuously elastic deformation and recovery of an original form.

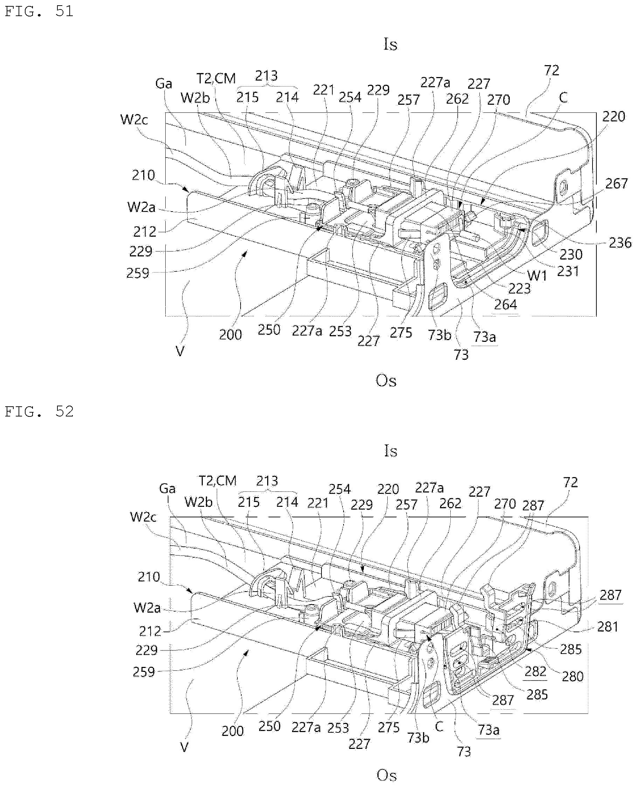

The connector inlet 73a may include a mounting cover 280. Referring to FIG. 52, the mounting cover 280 may block the connector inlet 73a, thereby covering the connector assembly C. More specifically, the mounting cover 280 may allow the pass of the main wire W1 extending from the relative connector 290, and cover the lower portion of the relative connector 290.

The mounting cover 280 may block the connector inlet 73a, and a frame of the mounting cover 280 is formed of a cover body 281 in which a cover tension part 282 is open on a central portion. The cover tension part 282 may have a shape in which a part of the central portion of the cover body 281 is cut off. When the mounting cover 280 is mounted to or separated from the connector inlet 73a, the cover body 281 may be elastically deformed in a direction of closing the cover tension part 282. To this end, an edge of the cover tension part 282 may have a cover gripping part 285 to adjust the width of the cover tension part 282. The main wire W1 may extend outward through the cover tension part 282.

The mounting cover 280 may include a cover fixation finger 286. The cover fixation finger 286 may protrude from the cover body 281. The cover fixation finger 286 may protrude from an opening of the cover tension part 282. The cover fixation finger 286 may be caught by an edge of the connector inlet 73a so that the mounting cover 280 is fixed to the connector inlet 73a. Reference numeral 287 indicates an air inlet to induce introduction of air.

FIGS. 37 to 45 are views successively illustrating a manufacturing process of the lower door 70. Referring to FIG. 37, in the door frame 72, 77, 80, 90 constituting the door body, the front frame part 72, the lower frame part 73, and the upper frame part 77 are assembled. Furthermore, the front panel Ga may be disposed in a central portion of the frames. The window V may be provided in a central portion of the front panel Ga. With the window V as the center, the installation regions T1 to T4 may be provided outside the window V The installation regions T1 to T4 may be a portion where the image acquisition module 100 and the connector module 200 are disposed.

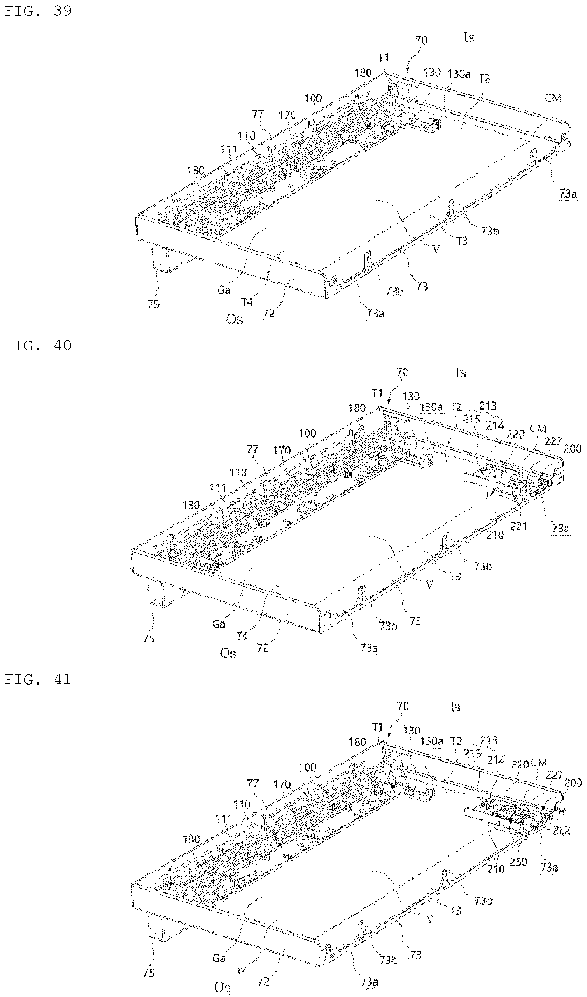

Referring to FIG. 38, a first housing 110 constituting the image acquisition module 100 may be seated on the front panel Ga. The first housing 110 may be fixed on a surface of the front panel Ga with a double faced adhesive tape, etc. In this state, as illustrated in FIG. 39, the image sensing device 170 and the lighting device 180 may be mounted to the first housing 110.

In the embodiment, a portion formed in the first direction and a portion formed in the second direction are connected to each other to form the first housing 110. Herein, the portion formed in the first direction may be a mounting plate 111. The portion formed in the second direction may be a first connection body 130. The first connection body 130 may extend toward the connector module 200. The first connection body 130 may guide the installation direction of the door wire W2 disposed between the image sensing device 170 and the lighting device 180, and the connector module 200.

Referring to FIG. 40, the mounting base 210 constituting the connector module 200 may be disposed in the connector storage part CM provided at the installation regions T1 to T4 of the front panel Ga. The mounting base 210 may be provided such that the restraint maintaining part 230 provided at the lower end portion faces the connector inlet 73a of the lower frame part 73. Accordingly, the fabricator can access the restraint maintaining part 230 through the connector inlet 73a.

As illustrated in FIG. 41, the movement supporter 250 may be disposed in the mounting base 210. The movement supporter 250 may first disposed on the mounting station 220 provided in the mounting base 210. In this state, the movement supporter 250 is moved toward the connector inlet 73a, thereby being disposed at the operation position. The movement supporter 250 may maintain the locked state at the operation position. Furthermore, the door connector 270 may be mounted to the movement supporter 250. FIG. 42 illustrates the movement supporter 250 and the door connector 270 disposed at the operation position. Herein, first, the door connector 270 is assembled to the movement supporter 250, and the movement supporter 250 may be disposed in the mounting base 210 with the door connector 270.

The door wire W2 may be connected to the door connector 270. The door wire W2 may extend toward the first connection body 130 through the wire guide 213 of the mounting base 210. In addition, the door wire W2 that passes through the first connection body 130 may be connected to the image sensing device 170 and the lighting device 180.

Referring to FIG. 43, a second housing 140 may be assembled to the first housing 110 constituting the image acquisition module 100. A first surface of the second housing 140 may cover and shield the image sensing device 170 and the lighting device 180. Herein, a lighting cover 190 may be disposed in the second housing 140, and the lighting cover 190 may transmit light emitted from a light source of the lighting device 180.

When the second housing 140 is assembled to the first housing 110, a part of the door wire W2 may be disposed in the image acquisition module 100. Apart of the door wire W2 may be exposed between the image acquisition module 100 and the connector module 200.

Referring to FIG. 44, the rear frame part 80 may be coupled to the front frame part 72. Although not illustrated in the drawing, the inner frame part 90 (referring to 5) may be coupled to. While the second rear panel Gc constituting the door panel G and a second inner panel (not illustrated) are mounted to the rear frame part 80, the rear frame part 80 may be assembled to the front frame part 72. When the rear frame part 80 covers a rear surface of the front frame part 72, the connector storage part CM and the connector module 200 disposed in the connector storage part CM may be covered.

When the rear frame part 80 is assembled, inlets I of the cooling flow path A1 may be formed between the lower frame part 73 and the rear frame part 80. A part of the inlets I may be the connector inlet 73a, and the door connector 270 may be exposed. Based on FIG. 44, the connector inlet 73a may be formed at the leftmost part of the inlets I.

In addition, in the connector inlet 73a, the relative connector 290 may be assembled to the door connector 270. The assembled connector assembly C may be moved from the operation position to the storage position. To this end, the fabricator can lift the operation lever 265, and then push the movement supporter 250 to the inside space of the connector storage part CM.

Finally, as illustrated in FIG. 45, the mounting cover 280 may be assembled to the connector inlet 73a. The mounting cover 280 may block the connector inlet 73a, thereby covering the connector assembly C. More specifically, the mounting cover 280 may allow the pass of the main wire W1 extending from the relative connector 290, and cover the lower portion of the relative connector 290. For reference, the main wire W1 is omitted in FIG. 45.

As another example, the mounting cover 280 may be omitted. Since the connector inlet 73a is disposed at the lower portion of the lower door 70, the connector inlet 73a may be exposed only at a specific angle even when the mounting cover 280 is omitted.

FIGS. 46 to 52 illustrates a process of mounting the connector module 200 to the connector storage part CM. As described above, the installation region T1 to T4 may be disposed outside the window V of the front panel Ga. The connector storage part CM may be provided in the installation region T1 to T4. The connector inlet 73a of the lower frame part 73 is open at a lower portion of the connector storage part CM.

As illustrated in FIG. 47, the mounting base 210 may be seated on the connector storage part CM. Describing the mounting direction of the mounting base 210, the rear surface of the mounting base 210 may face the front space of the lower door 70. When viewed from the front space of the lower door 70, the movement supporter 250 and the door connector 270 disposed on the front surface of the mounting base 210 may be covered by the mounting base 210. The rear surface of the mounting base 210 may be fixed to the front panel Ga in an adhesive manner.

The restraint maintaining part 230 provided at the lower portion of the mounting base 210 may be connected to the connector inlet 73a. Since the assembly guide 238 provided at the mounting base 210 may correspond to the shape of the connector inlet 73a, the lower end of the mounting base 210 may include an entrance with both end portions having a curved line shape.

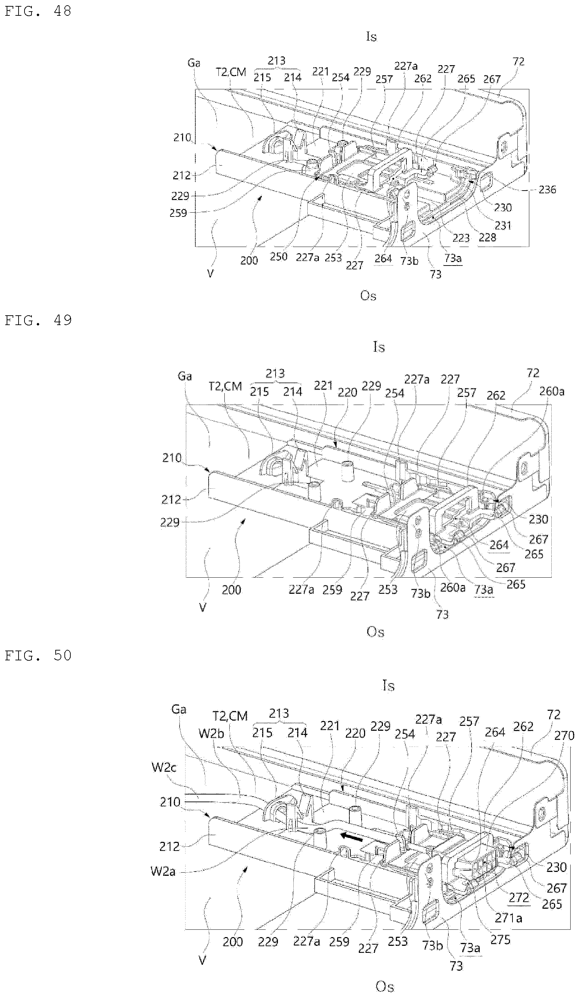

Referring to FIG. 48, the movement supporter 250 may be disposed in the mounting base 210. The movement supporter 250 may be seated on the upper portion of the mounting station 220 first. Herein, the guide head 255a of the movement supporter 250 may be inserted into the slot entrance 225a provided in the guide slot 225 of the mounting base 210 (referring to FIG. 29). When the movement supporter 250 is moved along the guide slot 225, as illustrated in FIG. 49, the movement supporter 250 may be moved to the operation position. As described above, in the movement process of the movement supporter 250, the second position fixation part 257 may continuously pass over the first position fixation part 227.

When the movement supporter 250 is moved to the operation position, the restraint head 260a of the supporter restraint arm 260 provided in the movement supporter 250 may be in the locked state of the mounting base 210 caught by the restraint maintaining part 230. Accordingly, the movement supporter 250 may be fixed in both directions. In this state, the fabricator can easily mount the door connector 270 to the fixed movement supporter 250. FIG. 50 illustrates the door connector 270 mounted to the movement supporter 250.

When the door connector 270 is mounted to the movement supporter 250, the door connector 270 is in a state in which the assembly surface 271a faces the connector inlet 73a. The connector lance part 275 of the movement supporter 250 may pass through the mounting hole 264 provided in the movement supporter 250 and may be fixed by being caught by the opposite side of the mounting hole 264. Then, when the relative connector 290 is mounted to the assembly surface 271a, the door connector 270 is fixed so that the connector assembly C may be fixed without being pushed in the arrow direction of FIG. 50.

As illustrated in FIG. 35 above, when the fabricator lifts the operation lever 265, the restraint head 260a of the movement supporter 250 is released from the locked state caught by the restraint maintaining part 230, thereby being in the released state. When the fabricator pushes the movement supporter 250 and the connector assembly C toward the inside space of the connector storage part CM while lifting the operation lever 265, the movement supporter 250 and the connector assembly C may be moved to the storage position. Herein, the second position fixation part 257 may be moved while continuously passing through the uneven structure of the first position fixation part 227. In this process, the second position fixation part 257 may repeat elastic deformation and recovery of an original form.

FIG. 51 illustrates the movement supporter 250 and the connector assembly C disposed in the storage position. As described above, the mounting stopper 229 provided in the mounting base 210 may limit movement of the movement supporter 250 in a first direction (a direction of 10 o'clock based on the drawing) while interfering with the stopping holder 259 of the movement supporter 250. On the other hand, movement of the movement supporter 250 in a second direction (a direction of 5 o'clock based on the drawing) may be limited as the second position fixation part 257 is caught by the storage locking end 227a of the first position fixation part 227.

As illustrated in FIG. 52, when the movement supporter 250 and the connector assembly C are disposed in the storage position, the connector assembly C is moved to the inside space of the connector inlet 73a, thereby preventing from being exposed outward. Furthermore, the mounting cover 280 may shield the connector inlet 73a. Although omitted in 52, only the main wire W2 connected to the relative connector 290 may extend outward through the mounting cover 280.

Next, FIGS. 53 to 61 illustrate the second embodiment of a connector module 300 constituting the doors for a home appliance according to the present disclosure. The structure overlapped with the above-described embodiment is assigned with the same reference numeral in the 300's, and a detailed description will be omitted.

In FIG. 53, the connector module 300 may include the mounting base 310, the movement supporter 350, and the door connector 370. The mounting base 310 may be fixed to the door body. The movement supporter 350 and the door connector 370 may be relatively moved with respect to the door body. The movement supporter 350 and the door connector 370 may be moved between the storage position and the operation position along the mounting base 310. FIG. 53 illustrates the movement supporter 350 and the door connector 370 disposed in the storage position.

Referring to FIG. 54, the guide fences 312 may be provided at both sides of the mounting base 310. The guide fences 312 may include respective guide steps 312a. The guide steps 312a may be provided at the pair of guide fences 312. The pair of guide steps 312a may protrude in facing directions. The guide steps 312a covers an assembly wing 352 of the movement supporter 350, and the movement supporter 350 may be prevented from being separated from the seating surface 321 in a separating direction (upward based on FIG. 55).

A first end of each guide step 312a may be adjacent to an assembly piece 325 described below. A second end of the guide step 312a may be adjacent to the restraint maintaining part 330. Therefore, the assembly wing 352 of the movement supporter 350 guided by the guide step 312a may be moved along the guide step 312a below the assembly piece 325 and be disposed adjacent to the restraint maintaining part 330.

The seating surface 321 may be provided at the mounting station 320 of the mounting base 310. The seating surface 321 may be a surface on which the movement supporter 350 is seated. The seating surface 321 may have a flat surface structure for sliding the movement supporter 350.

The seating surface 321 may include the supporter guide groove 323. The supporter guide groove 323 may be recessed from the seating surface 321. The supporter guide groove 323 may guide sliding of the movement supporter 350. The guide block 365a of the movement supporter 350 (referring to FIG. 55) may be inserted into the supporter guide groove 323 and the guide block 365a will be described below. While the guide block 365a is inserted into the supporter guide groove 323, the movement supporter 350 may be moved. Therefore, the supporter guide groove 323 may guide the movement of the movement supporter 350 in a constant direction.

Referring to FIG. 54, a part of the first end portion of the supporter guide groove 323 may be open. The first end portion of the supporter guide groove 323 may be open toward the lower portion of the mounting base 310, i.e., toward the connector inlet 73a. Using the empty space of the open portion, the operation lever 365 of the movement supporter 350 described below may be turned.

The second end of the supporter guide groove 323 may include the mounting stopper 323a of a step structure. A part of the movement supporter 350 may interfere with the mounting stopper 323a. The mounting stopper 323a may be formed by a step difference between the recessed portion of the supporter guide groove 323 and the seating surface 321 which are different in height. A part of the movement supporter 350 may directly interfere with the mounting stopper 323a. As another example, the movement supporter 350 may interfere with another portion of the mounting base 310.

The supporter guide groove 323 may include the storage fixation part 327, 357. The storage fixation part 327, 357 interfere with the movement supporter 350 to fix the movement supporter 350 and the connector assembly C to the storage position. When the movement supporter 350 and the connector assembly C are fixed to the storage position by the storage fixation part 327, 357, the movement supporter 350 and the connector assembly C are not returned to the operation position, and remain fixed to the connector storage part CM.

The storage fixation part 327, 357 may be disposed in the movement direction of the door connector 370 continuously or discontinuously. When the storage fixation part 327, 357 is provided in the movement direction of the door connector 370 continuously, the movement supporter 350 and the connector assembly C may be fixed to a plurality of storage positions in phases. When the storage fixation part 327, 357 is moved provided in the movement direction of the door connector 370 discontinuously, the movement supporter 350 and the connector assembly C may be fixed to a limited storage position.

The storage fixation part 327, 357 may include the first position fixation part 327 and the second position fixation part 357. The mounting base 310 of the connector module 300 may include the first position fixation part 327. The second position fixation part 357 may be provided in the movement supporter 350 or the door connector 370. The second position fixation part 357 may be engaged with the first position fixation part 327. When the second position fixation part 357 is engaged with the first position fixation part 327, the second position fixation part 357 may remain caught by and fixed to the first position fixation part 327.

Referring to FIG. 54, the first position fixation part 327 may be provided on the surface of the supporter guide groove 323. The first position fixation part 327 may be provided on a bottom surface of the recessed supporter guide groove 323. The first position fixation part 327 may extend in the movement direction of the movement supporter 350. The first position fixation part 327 may be continuously provided in the longitudinal direction of the supporter guide groove 323.

The first position fixation part 327 may have an uneven structure. The first position fixation part 327 may be configured by repeatedly arranging the structure recessed in the recessed direction of the supporter guide groove 323 and the protruding structure in the opposite direction. For example, the first position fixation part 327 may have a sawtooth structure. The first position fixation part 327 may have a sawtooth structure in which the height is gradually lowered toward the lower end of the mounting base 310. Then, the first position fixation part 327 may catch the second position fixation part 357 so that the movement supporter 350 is not moved in the direction toward the lower end of the mounting base 310 (downward based on the drawing).

The guide fence 312 may include the assembly piece 325. The assembly piece 325 may have a shape formed by cutting off a portion of the guide fence 312. The assembly piece 325 may enable the movement supporter 350 to be assembled and separated only at a specific position when being assembled to or separated from the mounting base 310.

The assembly piece 325 may be provided on the guide fence 312 into a kind of cantilever structure. The assembly piece 325 may be elastically deformed in the direction spreading from the guide fence 312 in the process in which the movement supporter 350 is seated on the seating surface 321. When the movement supporter 350 is seated on the seating surface 321, the assembly piece 325 may be recovered to the original form to prevent separation of the movement supporter 350.

The assembly piece 325 may include an assembly protrusion 325a. The assembly protrusion 325a may interfere with the movement supporter 350 when the movement supporter 350 is assembled. The assembly protrusion 325a may be formed such that the wide is gradually widened toward the seating surface 321. Accordingly, in the process of mounting the movement supporter 350, the assembly protrusion 325a may interfere with the movement supporter 350 to enable the entire assembly piece 325 to be naturally elastically deformed. More specifically, the assembly protrusion 325a may interfere with a portion of the assembly wing 352 of the movement supporter 350.

The assembly piece 325 may be disposed adjacent to the guide step 312a. The assembly wing 352 inserted into the assembly piece 325 may be moved below the guide step 312a. When the movement supporter 350 is moved, the assembly wing 352 may be moved along the guide step 312a.

The lower end of the mounting base 310 may include a cover fixation part 329a, 329b. The cover fixation part 329a, 329b may fix the mounting cover 380 described in the previous embodiment. The cover fixation part 329a, 329b may include a first cover fixation part 329a and a second cover fixation part 329b. The first cover fixation part 329a and the second cover fixation part 329b may be respectively provided on both portions of the lower end of the mounting base 310. The first end of the mounting cover 380 may be caught by the first cover fixation part 329a. The second end of the mounting cover 380 may be caught by the second cover fixation part 329b. The mounting cover 380 is turned with the first end caught by the first position fixation part 327, and the second end thereof may be assembled to the second cover fixation part 329b.

The mounting base 310 may include the restraint maintaining part 330. The restraint maintaining part 330 may fix the movement supporter 350 into the locked state when the movement supporter 350 is moved to the operation position. When a restraint head 360a of the movement supporter 350 is caught by a locking surface 332 of the restraint maintaining part 330, movement of the movement supporter 350 may be limited. The structure of the restraint maintaining part 330 may be configured equal to the previous embodiment, and detailed description will be omitted.

The movement supporter 350 may be disposed in the mounting base 310. The door connector 370 may be mounted to the movement supporter 350. The door connector 370 may be moved along the mounting station 320 with the movement supporter 350. The movement supporter 350 may be moved between the storage position and the operation position. The movement supporter 350 may remain fixed to each of the storage position and the operation position.

A frame of the movement supporter 350 may be formed of the supporter body 351. The supporter body 351 may have a flat plate structure. The first surface of the supporter body 351 may be the supporting board 353 on which the door connector 370 is seated. The second surface of the supporter body 351 may be brought into close contact with the seating surface 321 of the mounting base 310. The entire length of the supporter body 351 (a vertical length based on the drawing) may be shorter than or equal to the length of the mounting station 320.

The supporter body 351 may include the assembly wing 352. The assembly wing 352 may protrude from an edge of the supporter body 351. The assembly wing 352 may protrude in the direction of widening the width of the supporter body 351. The assembly wing 352 may be symmetrically provided at either portion of the supporter body 351.

The assembly wing 352 may be assembled to the mounting base 310 while elastically deforming the assembly piece 325. The assembly wing 352 may be disposed below the guide step 312a adjacent to the assembly piece 325. The assembly wing 352 inserted into the assembly piece 325 may be moved below the guide step 312a. When the movement supporter 350 is moved, the assembly wing 352 may be moved along the guide step 312a.

The movement supporter 350 may include the connector holder 362. The connector holder 362 may fix the door connector 370 to the movement supporter 350. The connector holder 362 may be provided below the supporting board 353. The connector holder 362 may have roughly a kind of rectangular frame structure surrounding a surface of the door connector 370. The mounting hole 364 is provided in a central portion of the connector holder 362, and the door connector 370 may be disposed in the mounting hole 364.

The movement supporter 350 may include the operation lever 365. The operation lever 365 may turn the movement supporter 350 into the locked state. The operation lever 365 may turn the movement supporter 350 into the released state. The operation lever 365 may extend from one end of the connector holder 362.

When the fabricator lifts the operation lever 365, the entire movement supporter 350 may be turned. When the movement supporter 350 is turned, the supporter restraint arm 360 of the movement supporter 350 may be released from the state of being caught by the restraint maintaining part 330 of the mounting base 310. The above structure is similar to the previous embodiment, so detailed description will be omitted.

Meanwhile, the operation lever 365 may have roughly a "U" shape. A central portion of the operation lever 365 is formed by being penetrated, and the second position fixation part 357 may be provided in the penetrated portion. The second position fixation part 357 may be fixed by being caught by the first position fixation part 327. The second position fixation part 357 may have a kind of hook structure. The second position fixation part 357 of a hook structure may be fixed by being caught by the first position fixation part 327 of a sawtooth shape.

As illustrated in FIG. 55, the operation lever 365 may include the guide block 365a. While the guide block 365a is located in the supporter guide groove 323, the movement supporter 350 may be linearly moved. The guide block 365a may be provided at a portion where the operation lever 365 and the supporting board 353 are connected to each other.

The guide block 365a may have a lower height than the supporting board 353. A step difference surface between the guide block 365a and the supporting board 353 may be caught by the mounting stopper 323a, i.e., a step structure at a second end portion of the supporter guide groove 323. When the guide block 365a is caught by the mounting stopper 323a, the movement range of the movement supporter 350 may be limited.

Referring to FIG. 55, the operation lever 365 may include a connection bridge 366. The connection bridge 366 may connect the operation lever 365 to a release lever 367. The release lever 367 may separate the second position fixation part 357 from the first position fixation part 327 while being turned. For reference, FIG. 55 illustrates the release lever 367 pushed to raise the second position fixation part 357. Then, the second position fixation part 357 may be separated from being caught by the first position fixation part 327.

On the connection bridge 366 as the center, the second position fixation part 357 may be provided at a first end, and the release lever 367 may be provided at a second end. Accordingly, when the release lever 367 is pushed or raised on the connection bridge 366 as the center, the second position fixation part 357 may be raised or pushed on the contrary. In other words, the operation part may have a kind of lever structure. Herein, the connection bridge 366 may be a supporting point, and the release lever 367 may be a target point.

Referring to FIGS. 55 to 57, describing the catching structure between the first position fixation part 327 and the second position fixation part 357, first, FIG. 55 illustrates the movement supporter 350 and the connector assembly C disposed in the storage position. Herein, the second position fixation part 357 of the movement supporter 350 may be engaged with the first position fixation part 327 to be fixed to the storage position. To release the fixed state, the release lever 367 should be pushed, and FIG. 55 illustrates the release lever 367 in a pushed state. When the fabricator pushes the release lever 367, the second position fixation part 357 at the opposite side of the release lever 367 based on the connection bridge 366 may be raised.

In this state, when the movement supporter 350 is pulled downward (leftward based on the drawings), the movement supporter 350 and the connector assembly C disposed at the movement supporter 350 may be moved together. Herein, when the movement supporter 350 is pulled with the release lever 367 remaining pushed, the second position fixation part 357 does not interfere with the first position fixation part 327 and may be moved.

FIG. 56 illustrates the movement supporter 350 and the connector assembly C moved along the supporter guide groove 323 to be disposed at the lower portion of the mounting base 310. In other words, the movement supporter 350 and the connector assembly C are moved to the operation position. When the movement supporter 350 and the connector assembly C are moved to the operation position, the fabricator can remove a force pushing the release lever 367. Then, with the connection bridge 366 as the center, the release lever 367 may be recovered upward, and the second position fixation part 357 at the opposite side may be moved downward. The above state is illustrated in FIG. 57.

Herein, the movement supporter 350 and the connector assembly C may be in the locked state at the operation position. The supporter restraint arm 360 of the movement supporter 350 may be fixed to the restraint maintaining part 330 of the mounting base 310 to be in the locked state. The second position fixation part 357 is engaged with the first position fixation part 327 of the lowermost end (a leftmost side based on the drawing) of the first position fixation part 327.

On the contrary, to move the movement supporter 350 and the connector assembly C to the storage position, the fabricator should lift the operation lever 365. When the operation lever 365 is raised, the state in which the restraint head 360a of the supporter restraint arm 360 of the movement supporter 350 is caught by the restraint maintaining part 330 of the mounting base 310 is released. In this state, when the movement supporter 350 is pushed, the movement supporter 350 and the connector assembly C may be moved to the storage position.

Herein, there is no need to push the release lever 367. When the movement supporter 350 is moved rightward based on FIG. 57, the second position fixation part 357 may pass over inclination of the first position fixation part 327, so there is no need to push the release lever 367. In the process in which the second position fixation part 357 passes over the first position fixation part 327, the release lever 367 may be repeatedly raised and then recovered to the original form by using an elastic force of the connection bridge 366.

FIGS. 58 to 61 illustrate assembly of the connector module 300 of the second embodiment, movement of the movement supporter 350, and the assembly process between the movement supporter and the relative connector 390 in order. FIG. 58 illustrates the movement supporter 350 and the door connector 370 spaced apart from the mounting base 310. The door connector 370 is mounted to the connector holder 362 of the movement supporter 350. The connector lance part 375 of the door connector 370 may pass through the mounting hole 264 provided in the movement supporter 350 and may be fixed by being caught by the opposite side of the mounting hole 264.

In this state, the movement supporter 350 and the door connector 370 may be seated on the mounting station 320 of the mounting base 310. When the movement supporter 350 and the door connector 370 are moved in the direction toward the mounting station 320 (a direction of arrow CD), the assembly wing 352 of the movement supporter 350 may interfere with the assembly protrusion 325a of the assembly piece 325. In the interference process, the assembly wing 352 may elastically deform the assembly piece 325 in a direction spreading from the mounting station 320 (a direction of arrow (2)).

As illustrated in FIG. 59, when the assembly wing 352 is moved below the assembly protrusion 325a, the assembly piece 325 may be recovered to the original form. At the same time, the guide block 365a of the movement supporter 350 may be inserted into the supporter guide groove 323. The guide block 365a is disposed on a lower surface of the movement supporter 350, so the guide block 365a is invisible due to the angle in FIG. 59.

When the movement supporter 350 and the door connector 370 are assembled as described above, the movement supporter 350 and the door connector 370 are disposed in the storage position. In this state, the movement supporter 350 may be moved in the arrow direction of FIG. 59. In other words, the movement supporter 350 and the door connector 370 are moved to the operation position.

At this point, since the second position fixation part 357 is caught by the first position fixation part 327, the fabricator should push the release lever 367 first in order to move the movement supporter 350. Referring to FIG. 55, when the release lever 367 is pushed, the second position fixation part 357 is separated from the first position fixation part 327 and released from the locked state.

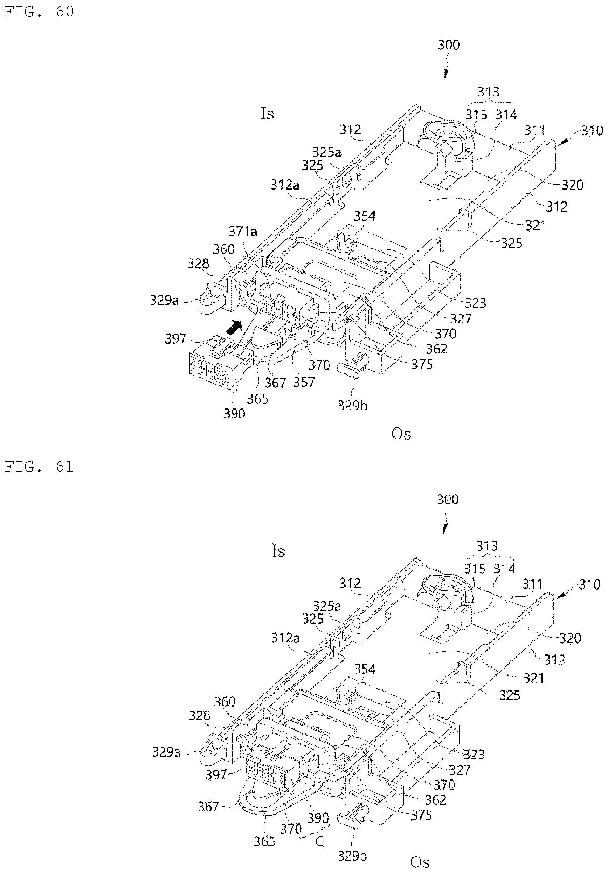

In this state, when the movement supporter 350 is pulled in the arrow direction of FIG. 59, the movement supporter 350 may be moved the operation position. The movement supporter 350 moved to the operation position may be fixed at the operation position by being caught by the restraint maintaining part 330. In other words, the movement supporter 350 and the door connector 370 are in the locked state. The figure as described above is illustrated in FIG. 60.

Next, the relative connector 390 may be assembled to the door connector 370. Since the assembly surface 371a of the door connector 370 faces the relative connector 390 in the locked state, the relative connector 390 may be easily assembled to the door connector 370. The arrow of FIG. 60 indicates an assembly direction of the relative connector 390.

The door connector 370 fixed to the restraint maintaining part 330 may be prevented from being pushed rearward, i.e., toward the storage position when being assembled with the relative connector 390. Accordingly, the fabricator can easily assemble the connector assembly C. Specifically, since the door connector 370 is fixed in a specific direction, the fabricator does not need to reconfirm the directionality of the door connector 370. FIG. 61 illustrates the completed assembly of the connector assembly C.

Next, FIGS. 62 to 72 illustrate the third embodiment of a connector module 400 constituting the doors for a home appliance according to the present disclosure. The structure overlapped with the above-described embodiment is assigned with the same reference numeral in the 400's, and a detailed description will be omitted.

In FIG. 62, the connector module 400 may include the mounting base 410, the movement supporter 450, and the door connector 470. The mounting base 410 may be fixed to the door body. The movement supporter 450 and the door connector 470 may be relatively moved with respect to the door body. The movement supporter 450 and the door connector 470 may be moved between the storage position and the operation position along the mounting base 410 (a direction of arrow CD). In addition, in the embodiment, the door connector 470 disposed at the operation position may be configured such that the assembly surface 471a faces the relative connector 490 through turning/rotating (a direction of arrow (2)). In addition, the relative connector 490 may be assembled to the door connector 470 (a direction of arrow (3)). FIG. 62 illustrates the movement supporter 450 and the door connector 470 disposed in the operation position.

Referring to FIGS. 62 and 63, the mounting base 410 may include the mounting station 420. The mounting station 420 may be provided on the mounting base 410 in the movement direction of the movement supporter 450. A surface of the mounting station 420 may be a flat surface structure.

A fixation rail 422 may be provided at either side portion of the mounting station 420. The fixation rail 422 may stand on either side of the mounting station 420 in a parallel direction. The fixation rail 422 may have roughly a unidirectionally long rod structure. The fixation rail 422 may extend from the storage position of the movement supporter 450 to the operation position.

The fixation rail 422 may be spaced apart from the mounting station 420. A guide slot 425 may be open at a spacing between the fixation rail 422 and the mounting station 420. The guide slot 425 may be a hole continuously formed in a longitudinal direction of the fixation rail 422. A supporter shaft 455 of the movement supporter 450 may be inserted into the guide slot 425.

Herein, the guide slot 425 may protrude from one end of the mounting station 420 outward of the mounting station 420. Referring to FIG. 64, the guide slot 425 may protrude lower than the lower end of the mounting station 420, i.e., further protrude in the movement direction of the movement supporter 450. Accordingly, the movement supporter 450 may be moved to a position deviating from the mounting station 420. As described above, at the position where the movement supporter 450 deviates from the mounting station 420, the movement supporter 450 does not interfere with the mounting station 420 and may be turned.

A terminal end of the guide slot 425 may be a turning part (not assigned with reference numeral). As illustrated in FIG. 62, the movement supporter 450 moved to the terminal end of the guide slot 425 may change into a turnable state. Specifically, the turning part may have a curved structure corresponding to a surface of the supporter shaft 455. Accordingly, the supporter shaft 455 may be turned while being in surface contact with the turning part.

The guide slot 425 may include the slot entrance 425a. The slot entrance 425a may be a portion further extending in a different direction from the extending direction of the guide slot 425. For example, the slot entrance 425a may be provided in a first direction (an arrow direction of FIG. 65). The guide slot 425 may be provided in a second direction different from the first direction (an arrow direction ① of FIG. 62). The guide slot 425 and the slot entrance 425a may form roughly an "L" shape. The slot entrance 425a is connected to an insertion guide 426 described below, thereby forming an entrance into which the supporter shaft 455 is inserted.

The fixation rail 422 may include the first position fixation part 427. The first position fixation part 427 may constitute the storage fixation part 427, 457 with the second position fixation part 457 of the movement supporter 450 described below. The storage fixation part 427, 457 may fix the movement supporter 450 and the connector assembly C to the storage position. When the movement supporter 450 and the connector assembly C are fixed to the storage position by the storage fixation part 427, 457, the movement supporter 450 and the connector assembly C are not returned to the operation position, and remain fixed to the connector storage part CM.

The storage fixation part 427, 457 may be disposed in the movement direction of the door connector 470 continuously or discontinuously. When the storage fixation part 427, 457 is provided in the movement direction of the door connector 470 continuously, the movement supporter 450 and the connector assembly C may be fixed to a plurality of storage positions in phases. When the storage fixation part 427, 457 is discontinuously provided in the movement direction of the door connector 470, the movement supporter 450 and the connector assembly C may be fixed to a limited storage position.

The storage fixation part 427, 457 may include the first position fixation part 427 and the second position fixation part 457. The first position fixation part 427 may be provided on the fixation rail 422 of the connector module 400. The second position fixation part 457 may be provided in the movement supporter 450 or the door connector 470. The second position fixation part 457 may be engaged with the first position fixation part 427. When the second position fixation part 457 is engaged with the first position fixation part 427, the second position fixation part 457 may remain caught by and fixed to the first position fixation part 427.

Referring to FIG. 62, the first position fixation part 427 may be continuously provided along the surface of the fixation rail 422. The first position fixation part 427 may have an uneven structure. The first position fixation part 427 may include a pair of first position fixation parts 427 facing each other. The pair of first position fixation parts 427 may face each other. Accordingly, each first position fixation part 427 may be configured by repeatedly arranging the structure protruding toward the first position fixation part 427 at the opposite side and the structure recessed in the opposite direction. For example, the first position fixation part 427 may have a sawtooth structure.

Meanwhile, the guide slot 425 may be provided along the movement direction of the movement supporter 450 to be relatively longer than the first position fixation part 427. When the guide slot 425 is longer than the first position fixation part 427, the movement supporter 450 may be moved to a position deviating from the first position fixation part 427. The movement supporter 450 may not be fixed to the first position fixation part 427 at a position deviating from the first position fixation part 427, i.e., at the operation position, and may be freely turned.

The insertion guide 426 may be provided at one end of the fixation rail 422. The insertion guide 426 may be provided at one end portion of the fixation rail 422 close to the storage position. The insertion guide 426 may form an entrance through which the supporter shaft 455 of the movement supporter 450 is inserted into the guide slot 425. The insertion guide 426 may protrude from the mounting station 420 with a cantilever structure. The insertion guide 426 may include a pair of guide ribs 426b, and an insertion channel 426a may be formed between the pair of guide ribs. The slot entrance 425a of the guide slot 425 may be connected to an inside part of the insertion channel 426a.

The mounting base 410 may include a side surface fence 428. The side surface fence 428 may stand on either end of the mounting base 410. The side surface fence 428 may be formed higher than the fixation rail 422. The side surface fence 428 may guide either side surface of the movement supporter 450 when the movement supporter 450 is inserted into the mounting base 410.

Describing the movement supporter 450, the supporter body 451 of the movement supporter 450 may include the supporter shaft 455. The supporter shaft 455 may be provided at either side surface of the supporter body 451. The supporter shaft 455 may have a cylindrical shape. The supporter shaft 455 may be a turning shaft enabling the movement supporter 450 to be moved between the storage position and the operation position and the movement supporter 450 to be turned at the same time. FIG. 62 illustrates that the supporter shaft 455 is moved to the lowermost end of the guide slot 425 and then the movement supporter 450 is turned on the supporter shaft 455.

The supporter body 451 may include the second position fixation part 457. The second position fixation part 457 may be engaged with the first position fixation part 427. The second position fixation part 457 may extend with a cantilever shape from the supporter body 451. The second position fixation part 457 may be a cantilever shape in which a first end portion is a fixation end fixed on the surface of the supporter body 451 and a second end portion is a free end. Accordingly, the second position fixation part 457 may be elastically deformed in the interference process with the first position fixation part 427. In the embodiment, the second position fixation part 457 may be provided into a cantilever shape on either side surface of the supporter body 451.

One end of the second position fixation part 457 may include a fixation end portion 457a. The fixation end portion 457a may be a portion relatively thicker than other portions in the second position fixation part 457. The fixation end portion 457a may be fixed by being caught by the first position fixation part 427 of the uneven shape. The fixation end portion 457a may have a shape engaged with the gear shape structure of the first position fixation part 427.

Referring to FIG. 64, the supporter body 451 may include the supporting board 453. The connector holder 462 may be provided on a lower end of the supporting board 453. The connector holder 462 may fix the door connector 470 to the movement supporter 450. The connector holder 462 may have roughly a kind of rectangular frame structure surrounding a surface of the door connector 470. The mounting hole 464 is provided in a central portion of the connector holder 462, and the door connector 470 may be disposed in the mounting hole 464.

The connector holder 462 may include the connector support end 463. The connector support end 463 may form the mounting hole 464 with the connector holder 462. When the connector holder 462 surrounds the first surface and both side surfaces of the door connector 470, the connector support end 463 may support the second surface of the door connector 470.

The supporter foot 468 may be provided on the lower surface of the movement supporter 450. The supporter foot 468 may protrude a lower surface of the movement supporter 450 facing the surface of the mounting base 410. The supporter foot 468 may have an elongated structure extending long in a longitudinal direction of the movement supporter 450, i.e., the movement direction of the movement supporter 450. Reference to FIG. 68, the supporter foot 468 may reduce a contact area between the movement supporter 450 and the mounting station 420, thereby reducing a friction force when the movement supporter 450 is moved.

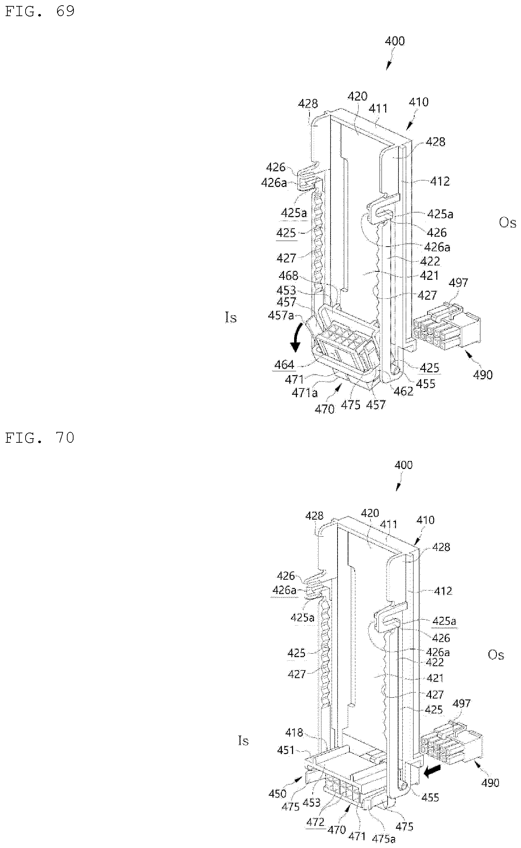

A connector body 471 of the door connector 470 may include the assembly surface 471a. The assembly surface 471a may be a portion coupled to the relative connector 490. While the assembly surface 471a faces the operation position, the door connector 470 may be linearly moved along the movement supporter 450. The door connector 470 moved to the operation position may be turned with the movement supporter 450 so that the assembly surface 471a may face the relative connector 490. This figure as described above is illustrated in FIG. 70.

The connector lance part 475 may be provided at either side of the connector body 471. The connector lance part 475 may pass through a mounting hole 464 provided in the movement supporter 450 and may be fixed by being caught by the opposite side of the mounting hole 464. Then, the door connector 470 is prevented from being separated in the opposite direction, i.e., an upward direction based on FIG. 65. Reference numeral 472 indicates a terminal hole, and a plurality of terminals (not shown in the drawing) may be stored in the terminal hole.

FIG. 66 illustrates a side structure of the assembly of the door connector 470 and the movement supporter 450. Herein, an imaginary vertical line passing through the supporter shaft 455 may be expressed as C1, and an imaginary vertical line passing through the center of gravity of the assembly of the door connector 470 and the movement supporter 450 may be expressed as C2. Herein, the imaginary vertical line passing through the supporter shaft 455 and the imaginary vertical line passing through the center of gravity of the assembly may extend in parallel to each other. The imaginary vertical line passing through the supporter shaft 455 and the imaginary vertical line passing through the center of gravity of the assembly may be spaced apart from each other by a predetermined distance T. In other words, the center of gravity of the assembly of the door connector 470 and the movement supporter 450 may be disposed on a position eccentric from the supporter shaft 455.

Preferably, the center of gravity of the assembly of the door connector 470 and the movement supporter 450 may be disposed at a position further away from the mounting station 420 than the supporter shaft 455. Then, the assembly of the door connector 470 and the movement supporter 450 may be turned in one direction (an arrow direction of FIG. 66) on the supporter shaft 455 as a turning center. Therefore, the assembly of the door connector 470 moved to the operation position and the movement supporter 450 may be automatically turned and the assembly surface 471a may face the relative connector 490.

FIGS. 67 and 70 sequentially illustrate a process in which the door connector 470 is assembled with the relative connector 490 after the door connector 470 is moved from the storage position to the operation position. Referring to FIG. 67, the assembly of the door connector 470 and the movement supporter 450 may be disposed at the storage position. In this state, after the fabricator accesses the movement supporter 450 through the connector inlet 73a (referring to FIG. 71), the fabricator can pull the movement supporter 450. The arrow of FIG. 67 indicates a direction in which the fabricator pulls the movement supporter 450. Of course, the fabricator can directly pull the door connector 470, not the movement supporter 450.

The movement supporter 450 may be linearly moved along the mounting station 420. In the movement process, the second position fixation part 457 may continuously pass the first position fixation part 427. Herein, the second position fixation part 457 is engaged with the continuous uneven part of the first position fixation part 427, thereby repeating elastic deformation and recovery of an original form.

FIG. 68 illustrates the assembly of the door connector 470 and the movement supporter 450 moved to the storage position. Herein, the assembly surface 471a of the door connector 470 faces the lower space. In other words, the door connector 470 may maintain a constant direction in the linear movement process.

The assembly of the door connector 470 and the movement supporter 450 which are moved to the storage position may be turned. The assembly of the door connector 47 and the movement supporter 450 may be turned on the supporter shaft 455 by gravity. FIG. 69 illustrates a middle state in which the assembly of the door connector 470 and the movement supporter 450 are turned. As described above, the center of gravity of the assembly of the door connector 470 and the movement supporter 450 is eccentric from the supporter shaft 455, so the assembly of the door connector 470 and the movement supporter 450 may be automatically turned by gravity.

FIG. 70 illustrates that the assembly of the door connector 470 and the movement supporter 450 is turned at 90 degrees and the assembly surface 471a faces the relative connector 490. In this state, when the relative connector 490 is moved in a direction toward the door connector 470 (arrow direction in FIG. 70), the relative connector 490 may be assembled from the assembly surface 471a of the door connector 470. An assembly hook 497 of the relative connector 490 may catch the door connector 470, two connectors may be assembled with each other.

FIGS. 71 and 72 illustrate the connector module 400 mounted to the connector storage part CM in the lower door 70. As illustrated in the drawing, the connector inlet 73a is open in the lower portion of the lower door 70, and the connector inlet 73a may include the operation space F, i.e., an empty space. The operation space F may be a clearance into which the fabricator can put a finger. Although the door connector 470 is disposed at the storage position, the fabricator can access the door connector 470 through the operation space F.

As illustrated in FIG. 71, the door connector 470 and the movement supporter 450 may be disposed at the storage position, so that outward exposure thereof cannot be exposed. Specifically, since the connector module 400 is disposed at a position deviating from the window V or only at least a part of the connector module 400 crosses the window V, the outward portion of the connector module 400 may be less. The connector module 400 is disposed adjacent to the connector inlet 73a, so that the fabricator can easily operate.

FIG. 72 illustrates the movement supporter 450 and the door connector 470 are turned after the movement supporter 450 and the door connector 470 are moved to the operation position. When the door connector 470 is turned, the door connector 470 faces in a direction in which the door connector 470 is assembled with the relative connector 490. In this state, the fabricator can assemble the relative connector 490 to the door connector 470 in front of the lower end of the lower door 70, or separate the relative connector 490. Therefore, the fabricator does not need to align the two connectors to assemble the two connectors. Furthermore, since the door connector 470 is supported in a direction toward the relative connector 490, the two connectors may be efficiently performed.

FIG. 73 illustrates the fourth embodiment of a connector module 500 constituting the doors for a home appliance according to the present disclosure. The structure overlapped with the above-described embodiment is assigned with the same reference numeral in the 500's, and a detailed description will be omitted.

In FIG. 73, the connector module 500 may include the mounting base 510, the movement supporter 550, and the door connector 570. The mounting base 510 may be fixed to the door body. The movement supporter 550 and the door connector 570 may be relatively moved with respect to the door body. The movement supporter 550 and the door connector 570 may be moved between the storage position and the operation position along the mounting base 510. FIG. 73 illustrates the movement supporter 550 and the door connector 570 disposed at a middle position between the storage position and the operation position.

The elastic member 560 may be provided between the movement supporter 550 and the mounting base 510. Both ends of the elastic member 560 may be connected to the movement supporter 550 and the mounting base 510 respectively. The elastic member 560 may provide an elastic force to the movement supporter 550 to pull the movement supporter 550 to the storage position. Therefore, when the movement supporter 550 is free without being caught by the mounting base 510, the movement supporter 550 and the door connector 570 disposed in the movement supporter 550 may be moved together to the storage position.

When the movement supporter 550 is moved to the operation position while overcoming the elastic force of the elastic member 560, the movement supporter 550 may be fixed by being caught by the restraint maintaining part 530. More specifically, when the movement supporter 550 is fixed to the restraint maintaining part 530, the movement supporter 550 and the connector assembly C may remain locked at the operation position. Then, when the fabricator lifts the operation lever 565, the locked state is released, and the elastic member 560 may pull the movement supporter 550 and the door connector 570 so that the movement supporter 550 and the door connector 570 are moved to the storage position.

FIG. 74 illustrate the fifth embodiment of a connector module 600 constituting the doors for a home appliance according to the present disclosure. The structure overlapped with the above-described embodiment is assigned with the same reference numeral in the 600's, and a detailed description will be omitted.

As illustrated in the drawing, in the embodiment, the door connector 670 constituting the connector module 600 may be assembled with the relative connector 690 below the lower door 70. The door connector 670 and the relative connector 690 may be stored in the lower door 70 after being assembled. More specifically, the connector storage part CM may be provided in the lower door 70. The door connector 670 and the relative connector 690 in the assembled state may be stored in the connector storage part CM.

The connector storage part CM may be provided in an empty space in the lower door 70. The connector storage part CM may include a fixation structure to which the door connector 670 and the relative connector 690 are fixed. For example, a structure to catch a part of the door connector 670 may be provided in the connector storage part CM. As another example, a structure to catch the door wire W2 connected to the door connector 670 may be provided in the connector storage part CM. As another example, the door connector 670 and the relative connector 690 may be fixed in a method of press-fitting the door connector 670 and the relative connector 690 into the connector storage part CM.

In the embodiment, the mounting base and the movement supporter may be omitted in the connector module 600. The door connector 670 and the relative connector 690 may be directly mounted to the connector storage part CM without the help of the movement supporter. Then, the door connector 670 may interfere with the structure of the connector storage part CM in the connector storage part CM to be fixed at the storage position. During movement along the linear section, the door connector 670 is not stored in the connector storage part CM and may be moved freely in the connector storage part CM.

Otherwise, the connector module 600 may include only one of the mounting bases or the movement supporters. For example, when only the mounting base is provided, the door connector 670 may be moved along the mounting base. At this point, the second position fixation part and the operation lever may be directly provided in the door connector 670. On the other hand, when only the movement supporter is provided, the movement supporter may be moved in the connector storage part CM while fixing the door connector 670.

FIG. 75 illustrates the sixth embodiment of a connector module 700 constituting the doors for a home appliance according to the present disclosure. The structure overlapped with the above-described embodiment is assigned with the same reference numeral in the 700's, and a detailed description will be omitted.

The connector storage part CM may be provided in the lower door 70. The connector storage part CM may be provided in the door body in the lower door 70. The connector storage part CM may be provided in the front frame part 72 constituting a frame of the door body. The front side plates 72a, i.e., a part of the front frame part 72, may constitute both side surfaces of the door body. As described above, the connector storage part CM may be provided in a front side plate 72a constituting both side surfaces of the door body.

As illustrated in FIG. 75, the connector module 700 may stand in the connector storage part CM. The connector module 700 is not seated on the front panel Ga, and may be disposed in the connector storage part CM provided in the front side plate 72a. A transverse width of the connector module 700 may be formed equal to or smaller than the width of each front side plate 72a. Since the connector storage part CM is provided at the lower end of the front frame part 72, the fabricator can easily access the connector module 700 through the connector inlet 73a of the lower door 70.

Herein, each front side plate 72a has roughly a concavely "⊂" shape, and the connector storage part CM may be provided in the concave portion. The connector storage part CM may be integrally formed with the front side plate 72a. Accordingly, the door connector 770 may be linearly moved along the concave portion of the front side plate 72a.

Although not shown in the drawing, the movement supporter 750 may be moved transversely with respect to the mounting base 710. Based on FIG. 74, the movement supporter 750 may be moved in the transverse direction, i.e., the width direction of the lower door 70, not the vertical direction.

Next, FIGS. 76 to 80 illustrate the seventh embodiment of a connector module 800 constituting the doors for a home appliance according to the present disclosure. The structure overlapped with the above-described embodiment is assigned with the same reference numeral in the 800's, and a detailed description will be omitted.

As shown in FIG. 76, the connector module 800 may be disposed in the lower door 70. The connector module 800 may be disposed in the connector storage part CM provided at the lower portion of the lower door 70. The connector inlet 73a may be open in a lower portion of the lower door 70. A lower portion of the connector module 800 may be disposed toward the connector inlet 73a.

The connector assembly C may be stored in the connector module 800. The connector assembly C may be a part of the connector module 800. When the connector assembly C is disposed in the connector module 800, two wires may be fixed while extending in different directions. More specifically, the door wire W2 of the door connector 870 constituting the connector assembly C may extend to the inside space of the lower door 70. The main wire W1 of the relative connector 890 constituting the connector assembly C may extend to the outside space of the lower door 70 through the connector inlet 73a.

FIG. 77 illustrates the enlarged structure of the connector module 800. The connector module 800 may include the mounting base 810. The mounting base 810 may be fixed to the connector storage part CM. The mounting base 810 may guide the movement of the connector assembly C. Since the mounting base 810 is fixed, the mounting base 810 may be relatively moved for the connector assembly C. FIG. 77 illustrates the connector assembly C fixed at the storage position.

The mounting base 810 may guide the movement of the connector assembly C. The mounting base 810 is fixed in the connector storage part CM, thereby preventing the connector assembly C from being also separated from the connector storage part CM. The mounting base 810 may guide an extension direction of the door wire W2 as described below.

Describing the mounting direction of the mounting base 810, as shown in FIG. 76, the rear surface of the mounting base 810 may face the front space of the lower door 70. When viewed from the front space of the lower door 70, the connector assembly C disposed on a front surface of the mounting base 810 may be covered by the mounting base 810. Since the connector module 800 including the mounting base 810 is disposed outside the window V, the connector module 800 may be covered by an edge portion of the lower door 70. As another example, even when the connector module 800 crosses a part of the window V, the connector assembly C is covered by the mounting base 810 and is prevented from exposing outward.

The door wire W2 may extend upward of the mounting base 810. The main wire W1 may extend downward of the mounting base 810. The mounting base 810 is disposed closer to the wire tube 83 provided in the side frame 80 (referring to FIG. 10), so an exposure area of the main wire W1 may be reduced.

The structure of the mounting base 810 will be described in detail with reference to FIG. 77. A frame of the mounting base 810 may be formed of a base body 811 of a flat plate structure. The mounting station 820 may be disposed on a first surface of the base body 811. The second surface of the base body 811 may be brought into close contact with the surface of the front panel Ga as a fixation surface. For example, the second surface of the base body 811 may adhere to the surface of the front panel Ga as a fixation surface. As another example, the base body 811 may be fixed to the door frame 72, 77, 80, 90, not a surface of the front panel Ga.

A guide fence 812 may be provided at either side of the base body 811. The guide fence 812 may be stood outside the mounting station820. The guide fence 812 may be provided in a movement direction of the door connector 870 outside the mounting station 820. In the embodiment, the guide fence 812 is provided at either side of the mounting station 820. As another example, the guide fence 812 may be provided on either side of the mounting station 820 or may be omitted.

The base body 811 may include a wire guide 813. The wire guide 813 may guide a direction in which the door wire W2 extends. The wire guide 813 may protrude from the base body 811. The wire guide 813 covers the door wire W2 so that the door wire W2 extends in a preset direction. In the embodiment, the wire guides 813 may include a first guide 814 and a second guide 815.

The seating surface 821 may be formed on a surface of the mounting station 820. The door connector 870 may be brought into close contact with the seating surface 821. The seating surface 321 may have a flat surface structure for sliding the door connector 870.

The mounting base 810 may include the connector holder 862. The connector holder 862 may fix the door connector 870 to the mounting base 810. In other words, the connector holder 862 may enable the mounting base 810 to fix the door connector 870 in the connector storage part CM. The connector holder 862 may have roughly a kind of rectangular frame structure surrounding the surface of the door connector 870. The mounting hole 864 is provided in a central portion of the connector holder 862, and the door connector 870 may be disposed in the mounting hole 864.

Referring to FIG. 79, the connector holder 862 may include the connector support end 863. The connector support end 863 may form the mounting hole 864 with the connector holder 862. When the connector holder 862 surrounds the first surface and both side surfaces of the door connector 870, the connector support end 863 may support the second surface of the door connector 870.

Referring to FIG. 78, when the door connector 870 is mounted to the mounting hole 864, the connector lance part 875 of the door connector 870 may pass through the mounting hole 864 and be fixed by being caught by the opposite side portion of the mounting hole 864. Then, the door connector 870 is prevented from being separated in the opposite direction, i.e., an upward direction based on FIG. 78.

The connector protrusion 876 of the door connector 870 may be caught by the opposite side portion of the mounting hole 864. When the connector protrusion 876 is caught by the opposite side portion of the mounting hole 864, the door connector 870 is no longer moved in the mounting direction, i.e., downward based on FIG. 78. Eventually, the door connector 870 may be fixed in the opposite directions.

Herein, a distance between the connector inlet 73c and the connector holder 862 may be longer than or equal to the sum of an outward protruding length (outside of the connector inlet 73c) of the door connector 870 disposed in the operation position and the length of the relative connector 890. Then, not only the door connector 870 but also the relative connector 890 may be prevented from being exposed outward of the connector inlet 73c.

As another example, the mounting hole 864 is omitted in the connector holder 862, and the connector holder 862 may protrude from the surface of the base body 811. In this case, the connector assembly C may be seated on the protruding upper portion of the connector holder 862. As another example, the connector holder 862 may be omitted. Herein, the connector assembly C may be fixed by being press-fitted into the mounting base 810. When the width between both side surfaces of the mounting base 810 is formed corresponding to the transverse width of the connector assembly C, the connector assembly C may be press-fitted into the mounting base 810.

The mounting base 810 may include a restraint maintaining part 830 provided at the opposite side of the wire guide 813. The restraint maintaining part 830 may fix the door connector 870 to prevent the door connector 870 from deviating from the operation position when the door connector 870 is moved to the operation position. The detailed structure of the restraint maintaining part 830 has been described in the previous embodiment, so a detailed description will be omitted.

In the embodiment, the mounting base 810 is fixed to the connector storage part CM, but as another example, the mounting base 810 may be integrally formed with the door body. For example, the mounting base 810 may be a part of the front frame part 72 constituting the door frame 72, 77, 80, 90.

FIG. 81 illustrates another example of a home appliance according to the present disclosure. As illustrated in the drawing, the home appliance may be a built-in type of home appliance. For example, the home appliance may be a cooking appliance installed in a built-in manner. As illustrated in the drawing, the cooking appliance of the embodiment may be installed in kitchen furniture 1, etc., and the front surface of the cooking appliance may only be exposed forward. Herein, the lower door 70 and the operating part 16 may be included on the front surface of the cooking appliance. Reference numeral 16 indicates a display part exposed from a front surface of the operating part 16. The image acquisition module 100 and the connector module 200 which are described above may be disposed in the lower door 70.

## Claims

1. Door (50, 70) for a home appliance, wherein the door (50, 70) comprises:
a door body configured to be disposed in front of a storage space of the home appliance, and accommodating an electronic compartment; and
a connector module (200) disposed in the door body, and comprising a door connector (270) electrically connected to the electronic compartment through a door wire (W2),
wherein the door body comprises a connector storage part (CM) therein,
wherein the connector storage part comprises a connector inlet (73a) open outward of the door body, and
wherein the door connector (270) is configured to be moved between a storage position disposed in the connector storage part (CM) and an operation position disposed at the connector inlet (73a).

2. The door (50, 70) of claim 1, wherein the door connector (270) is configured to be moved along the connector storage part (CM) between the storage position and the operation position in a linear path, and/or
wherein, when the door connector (270) is moved between the storage position and the operation position, a relative distance of the door connector (270) to the electronic compartment changes.

3. The door (50, 70) of claim 1 or 2, wherein the connector inlet (73a) is disposed at a lower portion of the door (50, 70), and/or
wherein the connector inlet (73a) is formed at an air inlet (I) into which air is introduced into the door (50, 70).

4. The door (50, 70) according to any one of claims 1 to 3, wherein the connector storage part (CM) extends in a height direction of the door body, and wherein the storage position is closer to the electronic compartment than the operation position, and/or
wherein an area of the connector inlet (73a) is wider than a thickness of the door connector (270), so an empty operation space is provided between an edge of the connector inlet (73a) and a surface of the door connector (270).

5. The door (50, 70) according to any one of claims 1 to 4, wherein the door connector (270) comprises an assembly surface (271a) assembled to a relative connector (290) disposed in a main body of the home appliance or a connection connector outside the home appliance, and when the door connector (270) is moved to the operation position, the assembly surface (271a) of the door connector (270) is exposed outside the connector inlet.

6. The door (50, 70) of claim 5, wherein the door connector (270) is moved between the storage position and the operation position with the assembly surface (271a) facing the connector inlet (73a), and/or
wherein the door wire (W2) connected to the door connector (270) and a main wire (W1) connected to the relative connector (290) extend in different directions from the connector module (200), and/or
wherein a movement range of the door connector (270) is equal to or longer than the sum of a protruding length from the door connector (270) disposed at the operation position outward of the connector inlet (73a) and a length of the relative connector (290).

7. The door (50, 70) according to any one of claims 1 to 6, wherein the connector storage part (CM) comprises a storage fixation part (227), the storage fixation part (227) interfering with the door connector (270) and fixing the door connector (270) to the storage position.

8. The door (50, 70) of claim 7, wherein the storage fixation part (227) is continuously or discontinuously disposed in a movement direction of the door connector (270), and the storage fixation part (227) fixes the door connector (270) at a plurality of positions in the connector storage part (CM), and/or
wherein the storage fixation part (227) comprises:
a first position fixation part (227) provided at a mounting base (210) of the connector module (200); and
a second position fixation part (257) provided at the door connector (270) and engaged with the first position fixation part (227).

9. The door (50, 70) of claim 8, wherein the first position fixation part (227) has an uneven structure continuously disposed in a movement direction of the door connector (270), and the second position fixation part (257) is fixed by being caught by the first position fixation part (227) by elastic deformation.

10. The door (50, 70) according to any one of claims 1 to 9, wherein the connector module (200) comprises:
a mounting base (210) fixed to the connector storage part (CM);
a movement supporter (250) configured to be moved along the mounting base (210); and
the door connector (270) disposed at the movement supporter (250) and configured to be moved with the movement supporter (250) along the mounting base (210).

11. The door (50, 70) of claim 10, wherein the mounting base (210) comprises a mounting station (220) in a movement direction of the movement supporter (250), and the movement supporter (250) is configured to be moved along the mounting station (220), and/or
wherein a plurality of surfaces of the movement supporter (250) is brought into close contact with a plurality of different surfaces of the mounting base (210) respectively.

12. The door (50, 70) according to any one of claims 8 to 10, wherein the mounting base (210) comprises:
a mounting station (220) in which the movement supporter (250) is configured to be moved; and
a guide fence (212) disposed at either side of the mounting station (220).

13. The door (50, 70) of claim 12, wherein one surface of the movement supporter (250) is seated on the mounting station (220), and the guide fence (212) covers one of both surfaces of the movement supporter (250), and/or
wherein the mounting station (220) comprises a mounting stopper (229) fixing the movement supporter (250) and the door connector (270) to the storage position, and the movement supporter (250) comprises a stopping holder (259) fixed by being caught by the mounting stopper (250).

14. The door (50, 70) of claim 11, wherein the mounting base (210) comprises a restraint maintaining part (230) catching and fixing the movement supporter (250) disposed at the operation position, and/or
wherein the movement supporter (250) comprises a connector holder (262) covering the door connector (270), and the connector holder (262) aligns the door connector (270) so that the door connector (270) is directed in a specific direction, and/or
wherein the mounting base (210) and the movement supporter (250) comprise a supporter guide groove (223) and a guide block (253a) corresponding to each other, and while the guide block (253a) is inserted into the supporter guide groove (223), the movement supporter (250) is moved along the mounting base (210), and/or
wherein either surface of the mounting base (210) comprises a first position fixation part (227) at a position facing either surface of the movement supporter (250), the movement supporter (250) comprises a second position fixation part (257) interfering with the first position fixation part (227), and the first position fixation part (227) or the second position fixation part (257) is caught by the second position fixation part (257) or the first position fixation part (227) by elastic deformation, and/or
wherein the connector module (500) comprises an elastic member (560) connecting the mounting base (510) and the movement supporter (550) to each other, and the elastic member (560) configured to supply an elastic force to the movement supporter (550) in a direction toward the storage position, and/or
wherein the mounting base (510) is disposed at a lower portion of the door.

15. The door (50, 70) according to any one of claims 1 to 14, wherein a central portion of the door body comprises a door panel (G) disposed therein, and the door panel (G) comprises a window (V) through which the storage space is visible, an indoor space defined by the door body and the door panel (G) has an installation region (T1, T2, T3, T4) around an outer portion of the window (V), and the connector storage part (CM) is disposed in the installation region (T1, T2, T3, T4).
